(19) Europäisches Patentamt
European Patent Office
Office européen des brevets

(11) EP 4 462 164 A1

(12) EUROPEAN PATENT APPLICATION
published in accordance with Art. 153(4) EPC

(43) Date of publication:
**13.11.2024 Bulletin 2024/46**

(21) Application number: **22918901.4**

(22) Date of filing: **28.12.2022**

(51) International Patent Classification (IPC):
***G02B 5/22*** *(2006.01)* ***B32B 7/023*** *(2019.01)*
***B32B 27/18*** *(2006.01)* ***B32B 27/20*** *(2006.01)*
***C07F 15/06*** *(2006.01)* ***C08F 290/00*** *(2006.01)*
***C08L 33/04*** *(2006.01)* ***C08L 101/00*** *(2006.01)*
***C09B 23/04*** *(2006.01)* ***C09B 23/16*** *(2006.01)*
***C09B 26/02*** *(2006.01)* ***C09B 67/20*** *(2006.01)*
***G02B 5/20*** *(2006.01)*

(52) Cooperative Patent Classification (CPC):
**B32B 7/023; B32B 27/18; B32B 27/20; C07F 15/06; C08F 290/00; C08L 33/04; C08L 101/00; C09B 23/04; C09B 23/16; C09B 26/02; C09B 67/006; G02B 5/20; G02B 5/22**

(86) International application number:
**PCT/JP2022/048523**

(87) International publication number:
**WO 2023/132318 (13.07.2023 Gazette 2023/28)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **07.01.2022 JP 2022001431**
**30.05.2022 JP 2022087750**
**30.05.2022 JP 2022087756**
**30.05.2022 JP 2022087760**

(71) Applicant: **Toppan Holdings Inc.**
**Tokyo 110-0016 (JP)**

(72) Inventors:
- **TAGAMI, Hanae**
**Tokyo 110-0016 (JP)**
- **FURUKAWA, Shigeki**
**Tokyo 110-0016 (JP)**
- **SHIMADA, Erika**
**Tokyo 110-0016 (JP)**
- **ISHIMARU, Yoshiko**
**Tokyo 110-0016 (JP)**
- **FUTAMATA, Kai**
**Tokyo 110-0016 (JP)**
- **ISHIKAWA, Shinya**
**Tokyo 110-0016 (JP)**

(74) Representative: **TBK**
**Bavariaring 4-6**
**80336 München (DE)**

# (54) OPTICAL FILM, COMPOSITION FOR COLORED LAYER FORMATION, DIPYRROMETHENE COBALT COMPLEX, AND DISPLAY DEVICE

(57) An optical film includes: a transparent substrate; and a colored layer laminated on at least one side of the transparent substrate, the colored layer containing a dye (A), the dye (A) containing a colorant having a wavelength of maximum absorption in the range of 470 nm to 530 nm, the colorant containing a dipyrromethene cobalt complex having a structure represented by formula (I), in which $R^1$ to $R^7$ are combined such that a free energy change between before and after the reaction, calculated by applying $R^1$ to $R^7$ in the formula (I) to a predetermined reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is 0.92 kcal/mol or greater.

EP 4 462 164 A1

## Description

[Technical Field]

The present invention relates to an optical film, a composition for forming a colored layer, a dipyrromethene cobalt complex and a display device.

The present application claims the benefit of priorities from Japanese Patent Application No. 2022-001431 filed January 7, 2022, Japanese Patent Application No. 2022-087750 filed May 30, 2022, Japanese Patent Application No. 2022-087756 filed May 30, 2022, and Japanese Patent Application No. 2022-087760 filed May 30, 2022, the contents of all of which are incorporated herein by reference.

[Background Art]

Display devices are often used in environments with incident external light, both indoors or outdoors. The external light incident on a display device is reflected at the surface of the display device, causing a reduction in display quality, such as a decrease in visibility. In particular, self-emissive display devices such as organic light-emitting display devices have the problem that the electrodes and many other metal wirings strongly reflect external light, which tends to degrade display quality.

In order to reduce the reflectance of the display device and suppress external light reflection, a circularly polarizing plate may be disposed on a display surface of the display device.

Furthermore, display devices are generally required to have high color purity. Color purity indicates the range of colors a display device can display, and is also called color reproduction range. Therefore, high color purity means a wide color reproduction range and good color reproducibility. Known means of improving color reproducibility include, for example, applying a color filter to a white light source of a display device to separate colors, and using a color filter for correcting a monochromatic light source to narrow the full width at half maximum.

For example, the following color filters have been proposed.

- A color correction filter containing a first colorant having a specific structure, and a second colorant having a maximum absorption in the wavelength range of 420 nm to 480 nm (PTL 1).
- A display filter having a resin layer containing a dipyrromethene dye, the resin being a polyester resin having a specific glass transition temperature (PTL 2).

In PTL 1, specific colorants are combined in order to improve the color purity of a white light source. In PTL 2, the wavelength of maximum absorption of the dye is set to an appropriate value depending on the type of the light source so that secondary emission from the light source is selectively absorbed, improving color purity.

[Citation List]

[Patent Literature]

PTL 1: JP 6142398 B

PTL 2: JP 2006-251076 A

[Summary of Invention]

[Technical Problems]

However, when a circularly polarizing plate is used, light emitted from the display device is also absorbed by the circularly polarizing plate, resulting in a significant decrease in luminance. Increasing the light emission intensity to compensate for the decrease in luminance may shorten the life of the light emitting element. In addition, the thickness of the circularly polarizing plate itself may make it difficult to make the display device thinner.

When a conventional color filter is used to improve the color reproducibility of a display device, it is necessary to make the color filters thicker and increase the concentration of colorants. This may cause deterioration of pixel shape and viewing angle characteristics, resulting in poor display quality.

The inventors of the present invention have diligently studied and found that dipyrromethene complexes (also

called dipyrromethene cobalt complexes) with cobalt as the central element can selectively and efficiently absorb light having a wavelength of around 500 nm (specifically, external light or secondary emission from a light source of the display device), which is effective in achieving low reflectance, high luminance, reduced film thickness and improved color reproducibility of the display device, but on the other hand, the light fastness may be insufficient depending on differences in substituents, and the like.

Therefore, the present invention has been made to provide an optical film capable of selectively and efficiently absorbing light having a wavelength of around 500 nm and excellent in light fastness, a composition for forming a colored layer capable of selectively and efficiently absorbing light having a wavelength of around 500 nm and excellent in light fastness, a dipyrromethene cobalt complex capable of selectively and efficiently absorbing light having a wavelength of around 500 nm and excellent in light fastness, and a display device using the optical film.

[Solution to Problems]

The present invention has an aspect as follows.

[1] An optical film including: a transparent substrate; and a colored layer laminated on at least one side of the transparent substrate, the colored layer containing a dye (A), the dye (A) containing a colorant having a wavelength of maximum absorption in the range of 470 nm to 530 nm, the colorant containing a dipyrromethene cobalt complex having a structure represented by the following formula (I), in which $R^1$ to $R^7$ in the following formulas (I) and (II) are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group, wherein the colorant satisfies at least one of the following conditions (1) to (4):

(1) The colorant has a wavelength of maximum absorption in the range of 470 nm to 530 nm, and, when thermogravimetric measurement is performed for the dipyrromethene cobalt complex under conditions of a gas flow rate of 500 mL/min and a temperature increase rate of 10°C/min, a 5% weight loss temperature when the gas is air and a 5% weight loss temperature when the gas is nitrogen are both 300°C or higher, and when thermogravimetric measurement is performed under conditions of a nitrogen flow rate of 500 mL/min and a temperature increase rate of 10°C/min, a 50% weight loss temperature is 360°C or higher and 470°C or lower;
(2) The colorant has a wavelength of maximum absorption of 489 nm to 500 nm and a full width at half maximum of an absorption peak of 22 nm or less in acetone solution with a concentration of $5.0 \times 10^{-6}$ M, and has a full width at half maximum of an absorption peak of 30 nm or less;
(3) The colorant has a wavelength of maximum absorption in the range of 470 nm to 530 nm, and contains a dipyrromethene cobalt complex in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is 0.92 kcal/mol or greater; and
(4) The colorant has a wavelength of maximum absorption in the range of 470 nm to 530 nm, and contains a dipyrromethene cobalt complex in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is -1.0 kcal/mol or greater, and at least one of $R^1$ to $R^4$ is a hydrogen atom or a halogen atom.

[Chem. 1]

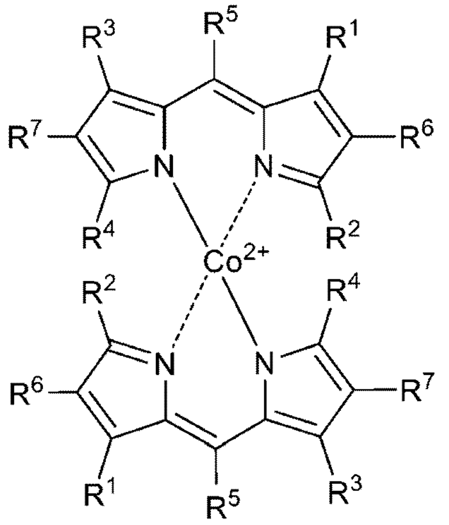

(I)

[Chem. 2]

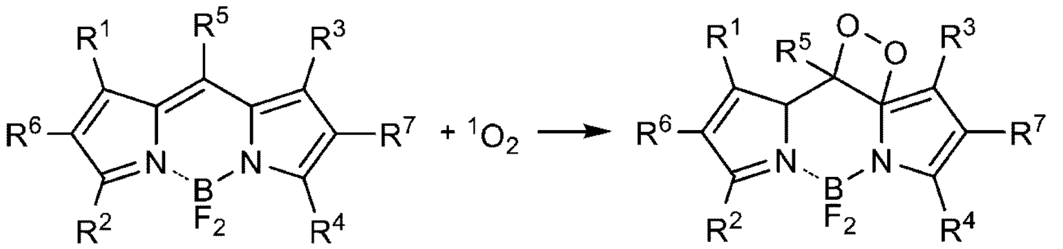

(II)

[2] The optical film according to [1], wherein the colorant satisfies the condition (2).

[3] The optical film according to [1], wherein, when thermogravimetric measurement is performed for the dipyrromethene cobalt complex of the condition (1) under conditions of a gas flow rate of 500 mL/min and a temperature increase rate of 10°C/min, a difference between a 50% weight loss temperature when the gas is air and a 50% weight loss temperature when the gas is nitrogen is 10°C or less.

[4] The optical film according to [1] or [2], wherein, in the reaction formula (II) in which boron dipyrromethene having a structure represented by the following formula (III) reacts with singlet oxygen, the dipyrromethene cobalt complex of the condition (2) has a free energy change ΔG between before and after reaction, calculated using a quantum chemical calculation program Gaussian 16 with a calculation method B3LYP and a basis function 6-31G (d,p) (however, a basis function LanL2DZ is assigned to elements in which $R^5$ in the formula (I) has an atomic number greater than that of Kr), of -1.0 kcal/mol or greater.

[Chem. 3]

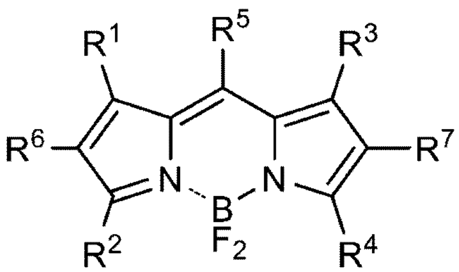

(III)

$R^1$ to $R^7$ in formula (III) each represent the same monovalent groups as $R^1$ to $R^7$ in formula (I).

[5] The optical film according to [1], wherein, in the dipyrromethene cobalt complex of the condition (3), at least one of $R^1$ to $R^4$ is a hydrogen atom or a halogen atom.

The optical film according to [1] or [5], wherein, in the dipyrromethene cobalt complex of the condition (3) or (4), $R^1$ and $R^3$ are each independently a hydrogen atom or a halogen atom and $R^2$ and $R^4$ are each independently an alkyl group having 1 to 4 carbon atoms, or $R^1$ and $R^3$ are each independently an alkyl group having 1 to 4 carbon atoms and $R^2$ and $R^4$ are each independently a halogen atom.

The optical film according to any one of [1] to [6], wherein, in the dipyrromethene cobalt complex, $R^5$ is a hydrogen atom.

The optical film according to any one of [1] to [4] and [7], wherein, in the dipyrromethene cobalt complex of the conditions (1) to (3), $R^1$ to $R^4$ are alkyl groups, and a sum of carbon numbers of $R^1$ and $R^2$ is 3 or greater and a sum of carbon numbers of $R^3$ and $R^4$ is 3 or greater.

The optical film according to [1], wherein the dipyrromethene cobalt complex has a structure represented by the following formula (I-1).

[Chem. 4]

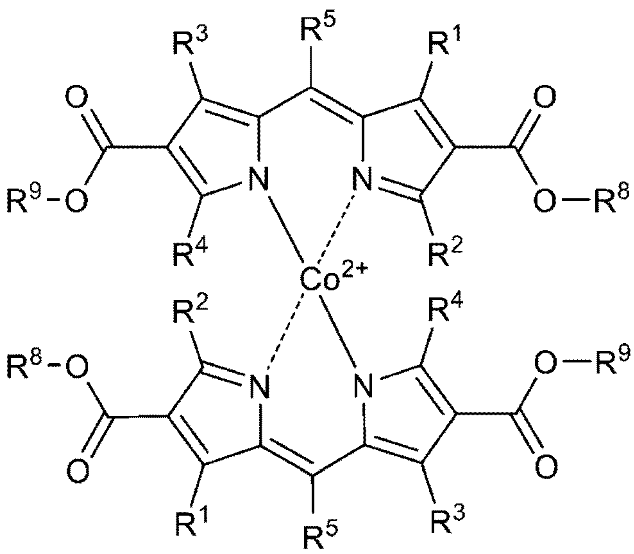

(I-1)

$R^1$ to $R^5$ in formula (I-1) each represent the same monovalent groups as $R^1$ to $R^5$ in the formula (I), and $R^8$ and $R^9$ each independently represent an alkyl group having 1 to 6 carbon atoms.

The optical film according to [9], wherein an acetone solution of the dipyrromethene cobalt complex has a molar absorption coefficient of 190,000 L/(mol·cm) or greater.

The optical film according to [9] or [10], wherein, in the dipyrromethene cobalt complex, $R^8$ and $R^9$ are each independently a methyl group or an ethyl group.

A composition for forming a colored layer, the composition including: a dye (A); a photopolymerizable compound (B); and a photopolymerization initiator (C), the dye (A) containing a colorant, the colorant containing a dipyrromethene cobalt complex having a structure represented by the following formula (I), in which $R^1$ to $R^7$ in the following formulas (I) and (II) are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group, wherein the colorant satisfies at least one of the following conditions (1) to (4):

(1) The colorant has a wavelength of maximum absorption in the range of 470 nm to 530 nm, and, when thermogravimetric measurement is performed for the dipyrromethene cobalt complex under conditions of a gas flow rate of 500 mL/min and a temperature increase rate of 10°C/min, a 5% weight loss temperature when the gas is air and a 5% weight loss temperature when the gas is nitrogen are both 300°C or higher, and when thermogravimetric measurement is performed under conditions of a nitrogen flow rate of 500 mL/min and a temperature increase rate of 10°C/min, a 50% weight loss temperature is 360°C or higher and 470°C or lower;

(2) The colorant has a wavelength of maximum absorption of 489 nm to 500 nm and a full width at half maximum of an absorption peak of 22 nm or less in acetone solution with a concentration of $5.0\times10^{-6}$ M, and has a full width at half maximum of an absorption peak of 30 nm or less;

(3) The colorant has a wavelength of maximum absorption in the range of 470 nm to 530 nm, and contains a

dipyrromethene cobalt complex in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is 0.92 kcal/mol or greater; and

(4) The colorant has a wavelength of maximum absorption in the range of 470 nm to 530 nm, and contains a dipyrromethene cobalt complex in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is -1.0 kcal/mol or greater, and at least one of $R^1$ to $R^4$ is a hydrogen atom or a halogen atom.

[Chem. 5]

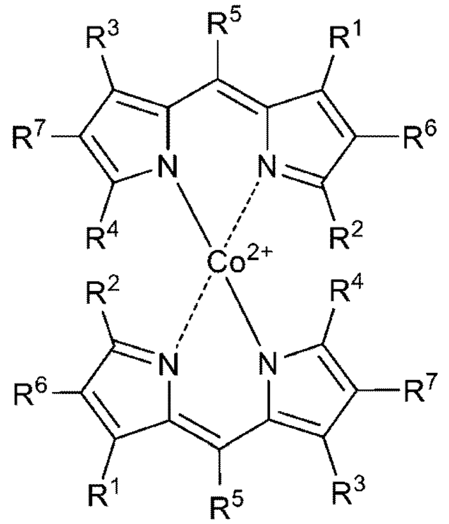

(I)

[Chem. 6]

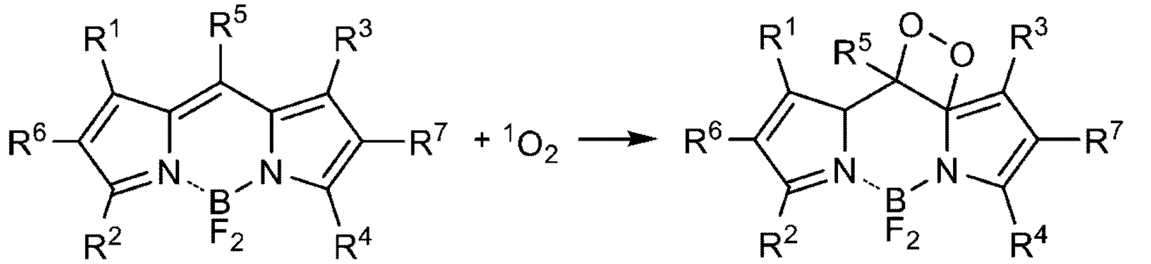

(II)

The composition for forming a colored layer according to [12] wherein the colorant satisfies the condition (2).

The composition for forming a colored layer according to [12], wherein, when thermogravimetric measurement is performed for the dipyrromethene cobalt complex of the condition (1) under conditions of a gas flow rate of 500 mL/min and a temperature increase rate of 10°C/min, a difference between a 50% weight loss temperature when the gas is air and a 50% weight loss temperature when the gas is nitrogen is 10°C or less.

The composition for forming a colored layer according to [12] or [13], wherein, in the reaction formula (II) in which boron dipyrromethene having a structure represented by the following formula (III) reacts with singlet oxygen, the dipyrromethene cobalt complex of the condition (2) has a free energy change $\Delta G$ between before and after reaction, calculated using a quantum chemical calculation program Gaussian 16 with a calculation method B3LYP and a basis function 6-31G (d,p) (however, a basis function LanL2DZ is assigned to elements in which $R^5$ in the formula (I) has an atomic number greater than that of Kr), of -1.0 kcal/mol or greater.

[Chem. 7]

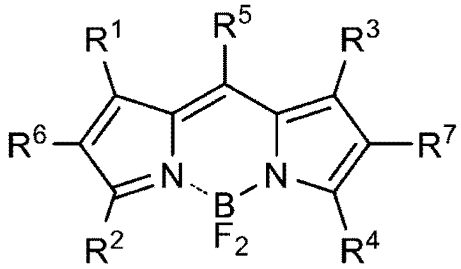

(III)

$R^1$ to $R^7$ in formula (III) each represent the same monovalent groups as $R^1$ to $R^7$ in formula (I).

The composition for forming a colored layer according to [12], wherein, in the dipyrromethene cobalt complex of the condition (3), at least one of $R^1$ to $R^4$ is a hydrogen atom or a halogen atom.

The composition for forming a colored layer according to [12] or 16], wherein, in the dipyrromethene cobalt complex of the condition (3) or (4), $R^1$ and $R^3$ are each independently a hydrogen atom or a halogen atom and $R^2$ and $R^4$ are each independently an alkyl group having 1 to 4 carbon atoms, or $R^1$ and $R^3$ are each independently an alkyl group having 1 to 4 carbon atoms and $R^2$ and $R^4$ are each independently a halogen atom.

The composition for forming a colored layer according to any one of [12] to [17], wherein, in the dipyrromethene cobalt complex, $R^5$ is a hydrogen atom.

The composition for forming a colored layer according to any one of [12] to [15] and [18], wherein, in the dipyrromethene cobalt complex of the conditions (1) to (3), $R^1$ to $R^4$ are alkyl groups, and a sum of carbon numbers of $R^1$ and $R^2$ is 3 or greater and a sum of carbon numbers of $R^3$ and $R^4$ is 3 or greater.

The composition for forming a colored layer according to [12], wherein the dipyrromethene cobalt complex has a structure represented by the following formula (I-1).

[Chem. 8]

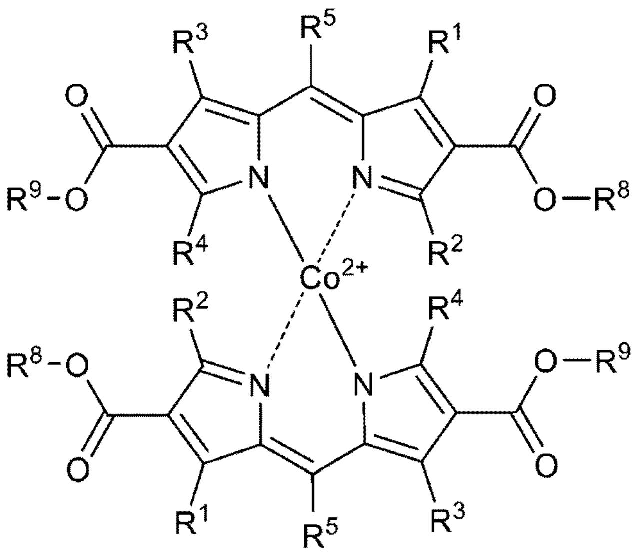

(I-1)

$R^1$ to $R^5$ in formula (I-1) each represent the same monovalent groups as $R^1$ to $R^5$ in the formula (I), and $R^8$ and $R^9$ each independently represent an alkyl group having 1 to 6 carbon atoms.

The composition for forming a colored layer according to [20], wherein an acetone solution of the dipyrromethene cobalt complex has a molar absorption coefficient of 190,000 L/(mol cm) or greater.

The composition for forming a colored layer according to [20] or [21], wherein, in the dipyrromethene cobalt complex, $R^8$ and $R^9$ are each independently a methyl group or an ethyl group.

The composition for forming a colored layer according to any one of [12] to [22], further containing a non-polymerizable additive (D).

An optical film including: a transparent substrate; and a colored layer laminated on at least one side of the transparent substrate, the colored layer being a cured product of the composition for forming a colored layer according to any one of [12] to [23].

A dipyrromethene cobalt complex having a structure represented by the following formula (I-1), in which $R^1$ to $R^5$ in the following formula (I-1) are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group, wherein the dipyrromethene cobalt complex satisfies at least one of the following conditions (1) to (3):

(1) When thermogravimetric measurement is performed for the dipyrromethene cobalt complex under conditions of a gas flow rate of 500 mL/min and a temperature increase rate of 10°C/min, a 5% weight loss temperature when the gas is air and a 5% weight loss temperature when the gas is nitrogen are both 300°C or higher, and when thermogravimetric measurement is performed under conditions of a nitrogen flow rate of 500 mL/min and a temperature increase rate of 10°C/min, a 50% weight loss temperature is 360°C or higher and 470°C or lower, and $R^8$ and $R^9$ are each independently an alkyl group having 1 to 6 carbon atoms;

(2) An acetone solution of the dipyrromethene cobalt complex has a molar absorption coefficient of 190,000 L/(mol·cm) or greater, $R^1$ to $R^5$, $R^8$ and $R^9$ are combined such that a free energy change between before and after the reaction, calculated by applying $R^1$ to $R^5$, $R^8$ and $R^9$ in the formula (I-1) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is 0.92 kcal/mol or greater, $R^8$ and $R^9$ are each independently an alkyl group having 1 to 6 carbon atoms, $R^6$ is -C(=O)-O-$R^8$, and $R^7$ is -C(=O)-O-$R^9$; and

(3) An acetone solution of the dipyrromethene cobalt complex has a molar absorption coefficient of 190,000 L/(mol·cm) or greater, $R^8$ and $R^9$ are each independently an alkyl group having 1 to 6 carbon atoms, and at least one of $R^1$ to $R^4$ is a hydrogen atom or a halogen atom.

[Chem. 9]

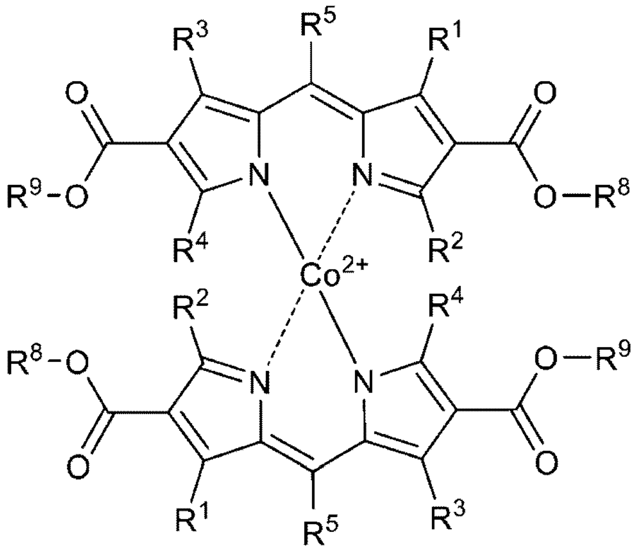

(I-1)

[Chem. 10]

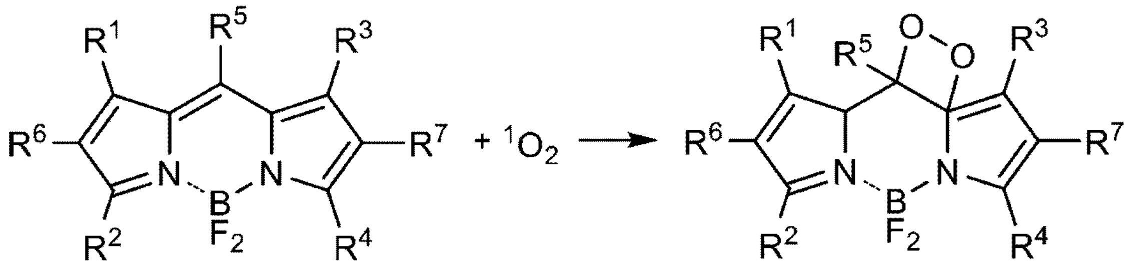

(II)

[26] The dipyrromethene cobalt complex according to [25], wherein, when thermogravimetric measurement is

performed for the dipyrromethene cobalt complex of the condition (1) under conditions of a gas flow rate of 500 mL/min and a temperature increase rate of 10°C/min, a difference between a 50% weight loss temperature when the gas is air and a 50% weight loss temperature when the gas is nitrogen is 10°C or less.

[27] The dipyrromethene cobalt complex according to [25] or [26], wherein $R^5$ is a hydrogen atom.

[28] The dipyrromethene cobalt complex according to any one of [25] to [27], wherein $R^8$ and $R^9$ are each independently a methyl group or an ethyl group.

[29] The dipyrromethene cobalt complex according to any one of [25] to [28], wherein $R^1$ to $R^4$ are alkyl groups, and a sum of carbon numbers of $R^1$ and $R^2$ is 3 or greater and a sum of carbon numbers of $R^3$ and $R^4$ is 3 or greater.

[30] The dipyrromethene cobalt complex according to any one of [25] to [29], wherein, in the dipyrromethene cobalt complex of the condition (2), $R^1$ and $R^3$ are each independently a hydrogen atom or a halogen atom and $R^2$ and $R^4$ are each independently an alkyl group having 1 to 4 carbon atoms, or $R^1$ and $R^3$ are each independently an alkyl group having 1 to 4 carbon atoms and $R^2$ and $R^4$ are each independently a halogen atom.

[31] The dipyrromethene cobalt complex according to any one of [25] to [30], wherein a wavelength of maximum absorption of an acetone solution thereof is 470 nm to 530 nm.

[32] A display device including the optical film according to any one of [1] to [11] and [24].

The present invention has another aspect as follows.

[1] An optical film including: a transparent substrate; and a colored layer laminated on at least one side of the transparent substrate, the colored layer containing a dye (A), the dye (A) containing a colorant having a wavelength of maximum absorption in the range of 470 nm to 530 nm, the colorant containing a dipyrromethene cobalt complex having a structure represented by the following formula (I), in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is -1.0 kcal/mol or greater.

[Chem. 11]

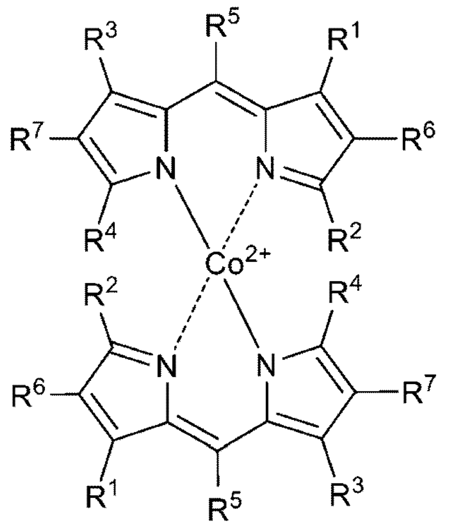

(I)

In the formula, $R^1$ to $R^7$ are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group.

[Chem. 12]

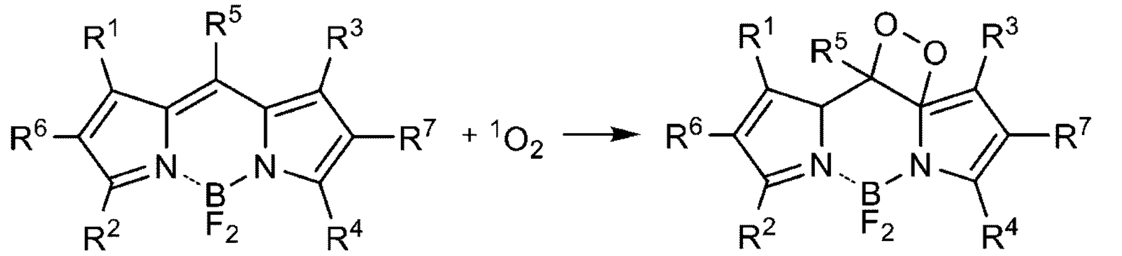

(II)

[2] The optical film according to [1], wherein, in the dipyrromethene cobalt complex, $R^5$ is a hydrogen atom.

[3] The optical film according to [1] or [2], wherein, in the dipyrromethene cobalt complex, $R^1$ to $R^4$ are alkyl groups, and a sum of carbon numbers of $R^1$ and $R^2$ is 3 or greater and a sum of carbon numbers of $R^3$ and $R^4$ is 3 or greater.

[4] The optical film according to [1] or [2], wherein, in the dipyrromethene cobalt complex, at least one of $R^1$ to $R^4$ is a hydrogen atom or a halogen atom.

[5] The optical film according to [4], wherein, in the dipyrromethene cobalt complex, $R^1$ and $R^3$ are each independently a hydrogen atom or a halogen atom and $R^2$ and $R^4$ are each independently an alkyl group having 1 to 4 carbon atoms, or $R^1$ and $R^3$ are each independently an alkyl group having 1 to 4 carbon atoms and $R^2$ and $R^4$ are each independently a halogen atom.

[6] The optical film according to any one of [1] to [5], wherein the dipyrromethene cobalt complex has a structure represented by the following formula (I-1), and an acetone solution thereof has a molar absorption coefficient of 190,000 L/(mol·cm) or greater.

[Chem. 13]

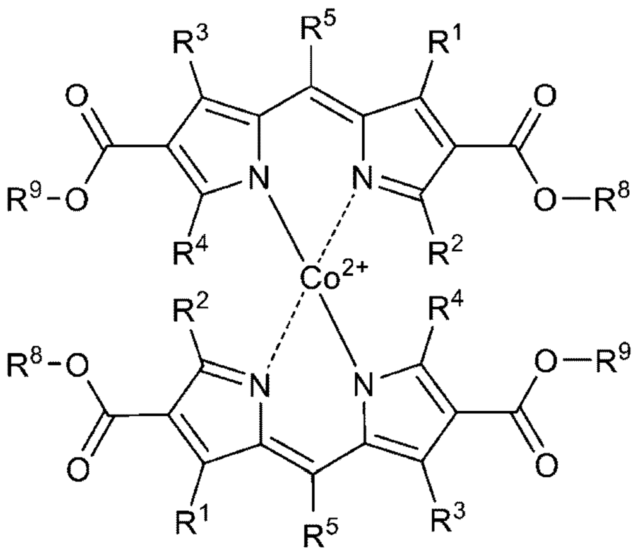

(I-1)

In the formula, $R^1$ to $R^5$ are as described above, and $R^8$ and $R^9$ each independently represent an alkyl group having 1 to 6 carbon atoms.

[7] The optical film according to [6], wherein, in the dipyrromethene cobalt complex, $R^8$ and $R^9$ are each independently a methyl group or an ethyl group.

[7'] The optical film according to any one of [1] to [7], containing a dipyrromethene cobalt complex in which $R^1$ to $R^7$ are combined such that the free energy change is 0.92 kcal/mol or greater.

[7"] The optical film according to any one of [1] to [7], wherein, in the dipyrromethene cobalt complex, at least one of $R^1$ to $R^4$ is a hydrogen atom or a halogen atom.

[8] A composition for forming a colored layer, the composition including: a dye (A); a photopolymerizable compound (B); and a photopolymerization initiator (C), the dye (A) containing a colorant having a wavelength of maximum absorption in the range of 470 nm to 530 nm, the colorant containing a dipyrromethene cobalt complex having a structure represented by the following formula (I), in which $R^1$ to $R^7$ are combined such that a free energy change between before and after the reaction, calculated by applying $R^1$ to $R^7$ in the formula (I) to the following reaction formula (II) using a quantum

chemical calculation program Gaussian 16 with a calculation method B3LYP and a basis function 6-31G (d,p) (however, a basis function LanL2DZ is assigned to elements having an atomic number greater than that of Kr in the periodic table), is -1.0 kcal/mol or greater.

[Chem. 14]

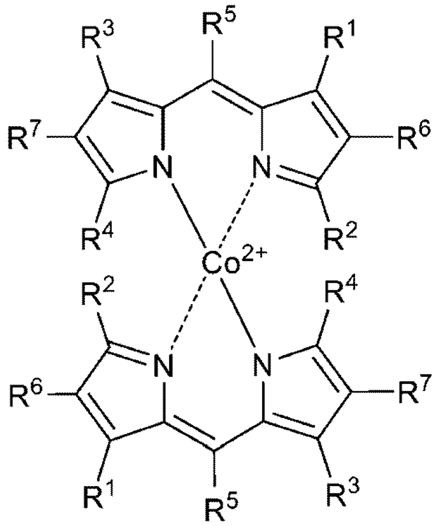

(I)

In the formula, $R^1$ to $R^7$ are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group.

[Chem. 15]

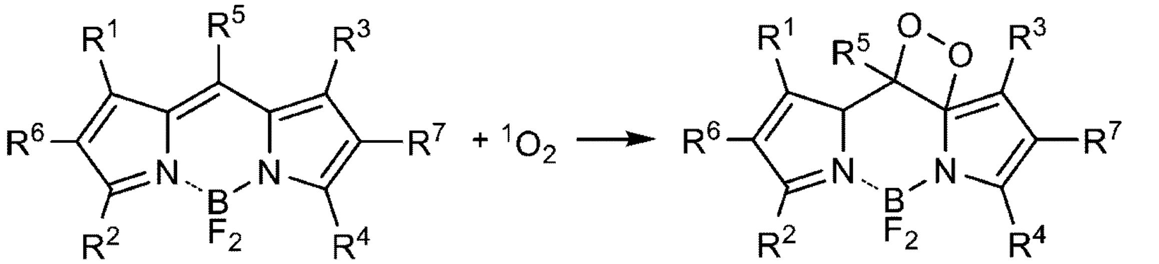

(II)

[9] The composition for forming a colored layer according to [8], wherein, in the dipyrromethene cobalt complex, $R^5$ is a hydrogen atom.

[10] The composition for forming a colored layer according to [8] or [9], wherein, in the dipyrromethene cobalt complex, $R^1$ to $R^4$ are alkyl groups, and a sum of carbon numbers of $R^1$ and $R^2$ is 3 or greater and a sum of carbon numbers of $R^3$ and $R^4$ is 3 or greater.

[11] The composition for forming a colored layer according to claim [8] or [9], wherein, in the dipyrromethene cobalt complex, at least one of $R^1$ to $R^4$ is a hydrogen atom or a halogen atom.

[12] The composition for forming a colored layer according to [11], wherein, in the dipyrromethene cobalt complex, $R^1$ and $R^3$ are each independently a hydrogen atom or a halogen atom and $R^2$ and $R^4$ are each independently an alkyl group having 1 to 4 carbon atoms, or $R^1$ and $R^3$ are each independently an alkyl group having 1 to 4 carbon atoms and $R^2$ and $R^4$ are each independently a halogen atom.

[13] The composition for forming a colored layer according to any one of [8] to [12], wherein the dipyrromethene cobalt complex has a structure represented by the following formula (I-1), and an acetone solution thereof has a molar absorption coefficient of 190,000 L/(mol cm) or greater.

[Chem. 16]

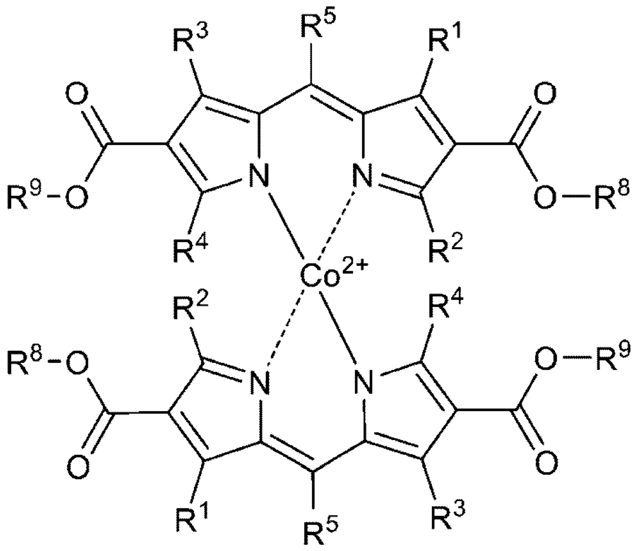

(I-1)

In the formula, $R^1$ to $R^5$ are as described above, and $R^8$ and $R^9$ each independently represent an alkyl group having 1 to 6 carbon atoms.

[14] The composition for forming a colored layer according to [13], wherein, in the dipyrromethene cobalt complex, $R^8$ and $R^9$ are each independently a methyl group or an ethyl group.

[15] The composition for forming a colored layer according to any one of [8] to [14], further containing a non-polymerizable additive (D).

[15'] The composition for forming a colored layer according to any one of [8] to [15], containing a dipyrromethene cobalt complex in which $R^1$ to $R^7$ are combined such that the free energy change is 0.92 kcal/mol or greater.

[15"] The composition for forming a colored layer according to any one of [8] to [15], wherein, in the dipyrromethene cobalt complex, at least one of $R^1$ to $R^4$ is a hydrogen atom or a halogen atom.

[16] An optical film including: a transparent substrate; and a colored layer laminated on at least one side of the transparent substrate, the colored layer being a cured product of the composition for forming a colored layer according to any one of [8] to [15], [15'] and [15"].

[17] A dipyrromethene cobalt complex having a structure represented by the following formula (I-1), and an acetone solution thereof has a molar absorption coefficient of 190,000 L/(mol·cm) or greater.

[Chem. 17]

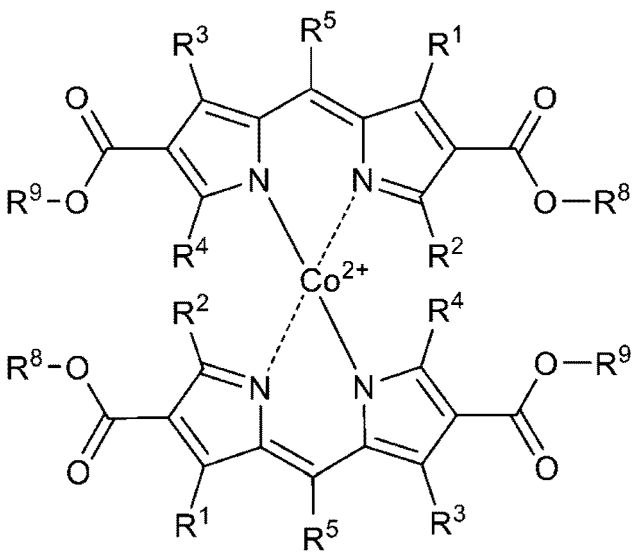

(I-1)

In the formula, $R^1$ to $R^5$ each independently represent a monovalent group selected from the group consisting of a

hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group, and $R^8$ and $R^9$ each independently represent an alkyl group having 1 to 6 carbon atoms.

[18] The dipyrromethene cobalt complex according to [17], wherein $R^8$ and $R^9$ are each independently a methyl group or an ethyl group.

[19] The dipyrromethene cobalt complex according to [17] or [18], wherein $R^5$ is a hydrogen atom.

[20] The dipyrromethene cobalt complex according to any one of [17] to [19], wherein $R^1$ to $R^4$ are alkyl groups, and a sum of carbon numbers of $R^1$ and $R^2$ is 3 or greater and a sum of carbon numbers of $R^3$ and $R^4$ is 3 or greater.

[21] The dipyrromethene cobalt complex according to any one of [17] to [19], wherein at least one of $R^1$ to $R^4$ is a hydrogen atom or a halogen atom.

[22] The dipyrromethene cobalt complex according to [21], wherein $R^1$ and $R^3$ are each independently a hydrogen atom or a halogen atom and $R^2$ and $R^4$ are each independently an alkyl group having 1 to 4 carbon atoms, or $R^1$ and $R^3$ are each independently an alkyl group having 1 to 4 carbon atoms and $R^2$ and $R^4$ are each independently a halogen atom.

[22'] The dipyrromethene cobalt complex according to any one of [17] to [22], wherein $R^1$ to $R^5$, $R^8$ and $R^9$ are combined such that a free energy change between before and after the reaction, calculated by applying $R^1$ to $R^5$, $R^8$ and $R^9$ in the formula (I-1) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is 0.92 kcal/mol or greater.

[Chem. 18]

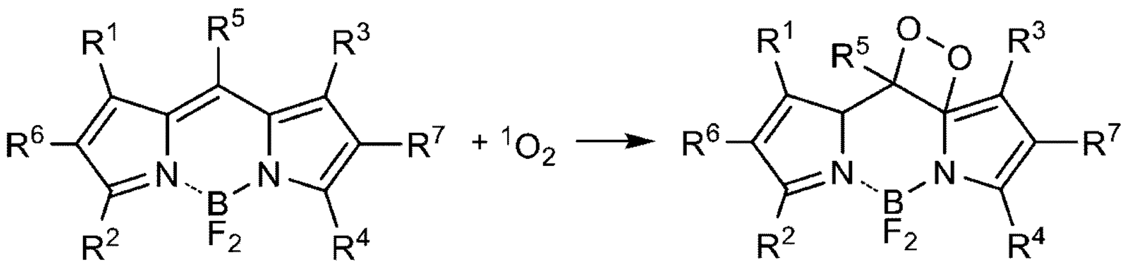

(II)

In the formula, $R^1$ to $R^5$ are each independently represent a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group, $R^8$ and $R^9$ each independently represent an alkyl group having 1 to 6 carbon atoms, $R^6$ represents -C(=O)-O-$R^8$, and $R^7$ represents -C(=O)-O-$R^9$.

[23] The dipyrromethene cobalt complex according to any one of [17] to [22], wherein a wavelength of maximum absorption of an acetone solution thereof is 470 nm to 530 nm.

[24] A display device including the optical film according to any one of [1] to [7], [7'] and [7"].

[25] A display device including the optical film according to [16].

The present invention has still another aspect as follows.

[1] An optical film including: a transparent substrate; and a colored layer laminated on at least one side of the transparent substrate, the colored layer containing a dye (A), the dye (A) containing a colorant having a wavelength of maximum absorption in the range of 470 nm to 530 nm, the colorant containing a dipyrromethene cobalt complex having a structure represented by the following formula (I), wherein, when thermogravimetric measurement is performed for the dipyrromethene cobalt complex under conditions of a gas flow rate of 500 mL/min and a temperature increase rate of 10°C/min, a 5% weight loss temperature when the gas is air and a 5% weight loss temperature when the gas is nitrogen are both 300°C or higher, and when thermogravimetric measurement is performed under conditions of a nitrogen flow rate of 500 mL/min and a temperature increase rate of 10°C/min, a 50% weight loss temperature is 360°C or higher and 470°C or lower.

[Chem. 19]

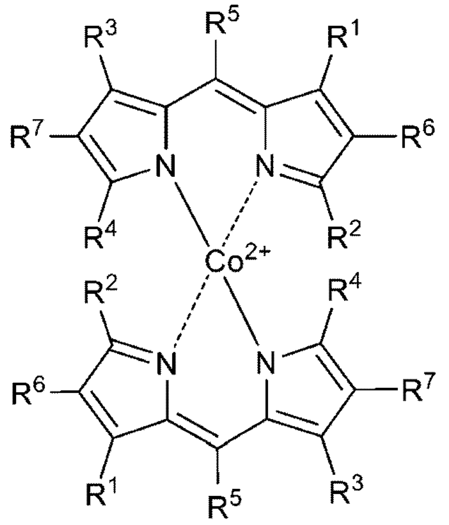

(I)

In the formula, $R^1$ to $R^7$ are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group.

[2] The optical film according to [1], wherein, when thermogravimetric measurement is performed for the dipyrromethene cobalt complex under conditions of a gas flow rate of 500 mL/min and a temperature increase rate of 10°C/min, a difference between a 50% weight loss temperature when the gas is air and a 50% weight loss temperature when the gas is nitrogen is 10°C or less.

[3] The optical film according to [1] or [2], wherein the dipyrromethene cobalt complex has a structure represented by the following formula (1-1).

[Chem. 20]

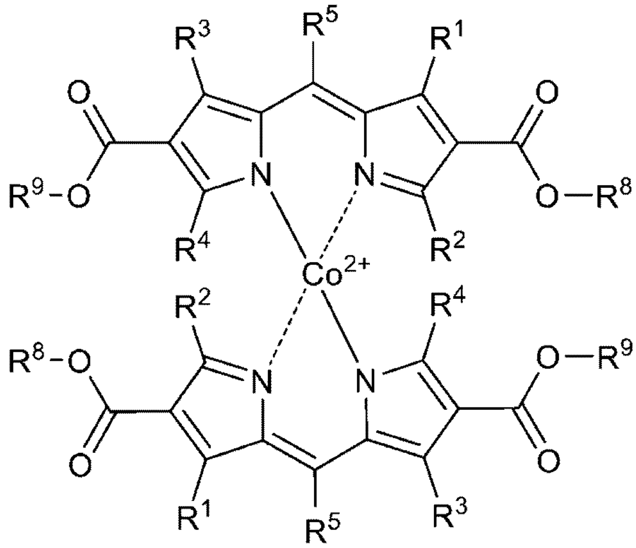

(I-1)

In the formula, $R^1$ to $R^5$ are as described above, and $R^8$ and $R^9$ each independently represent an alkyl group having 1 to 6 carbon atoms.

[4] The optical film according to [3], wherein, in the dipyrromethene cobalt complex, $R^5$ is a hydrogen atom.

[5] The optical film according to [3] or [4], wherein, in the dipyrromethene cobalt complex, $R^1$ to $R^4$ are alkyl groups, and a sum of carbon numbers of $R^1$ and $R^2$ is 3 or greater and a sum of carbon numbers of $R^3$ and $R^4$ is 3 or greater.

[6] A composition for forming a colored layer, the composition including: a dye (A); a photopolymerizable compound (B); and a photopolymerization initiator (C), the dye (A) containing a colorant having a wavelength of maximum absorption in the range of 470 nm to 530 nm, the colorant containing a dipyrromethene cobalt complex having a structure represented by the following formula (I), wherein, when thermogravimetric measurement is performed for the dipyrromethene cobalt complex under conditions of a gas flow rate of 500 mL/min and a temperature increase rate of 10°C/min, a 5% weight loss temperature when the gas is air and a 5% weight loss temperature when the gas is nitrogen are both 300°C or higher, and when thermogravimetric measurement is performed under conditions of a nitrogen flow rate of 500 mL/min and a temperature increase rate of 10°C/min, a 50% weight loss temperature is 360°C or higher and 470°C or lower.

[Chem. 21]

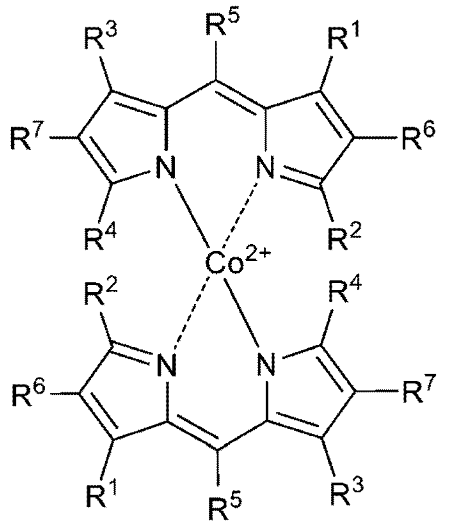

(I)

In the formula, $R^1$ to $R^7$ are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group.

[7] The composition for forming a colored layer according to [6], wherein, when thermogravimetric measurement is performed for the dipyrromethene cobalt complex under conditions of a gas flow rate of 500 mL/min and a temperature increase rate of 10°C/min, a difference between a 50% weight loss temperature when the gas is air and a 50% weight loss temperature when the gas is nitrogen is 10°C or less.

[8] The composition for forming a colored layer according to [6] or [7], wherein the dipyrromethene cobalt complex has a structure represented by the following formula (I-1).

[Chem. 22]

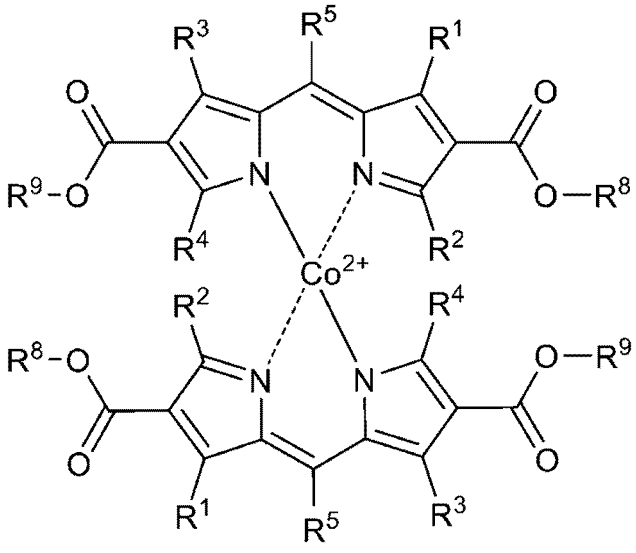

(I-1)

In the formula, $R^1$ to $R^5$ are as described above, and $R^8$ and $R^9$ each independently represent an alkyl group having 1 to 6 carbon atoms.

[9] The composition for forming a colored layer according to [8], wherein, in the dipyrromethene cobalt complex, $R^5$ is a hydrogen atom.

[10] The composition for forming a colored layer according to [8] or [9], wherein, in the dipyrromethene cobalt complex, $R^1$ to $R^4$ are alkyl groups, and a sum of carbon numbers of $R^1$ and $R^2$ is 3 or greater and a sum of carbon numbers of $R^3$ and $R^4$ is 3 or greater.

[11] An optical film including: a transparent substrate; and a colored layer laminated on at least one side of the transparent substrate, the colored layer being a cured product of the composition for forming a colored layer according to any one of [6] to [10].

[12] A dipyrromethene cobalt complex having a structure represented by the following formula (I-1), wherein, when thermogravimetric measurement is performed under conditions of a gas flow rate of 500 mL/min and a temperature increase rate of 10°C/min, a 5% weight loss temperature when the gas is air and a 5% weight loss temperature when the gas is nitrogen are both 300°C or higher, and when thermogravimetric measurement is performed under conditions of a nitrogen flow rate of 500 mL/min and a temperature increase rate of 10°C/min, a 50% weight loss temperature is 360°C or higher and 470°C or lower.

[Chem. 23]

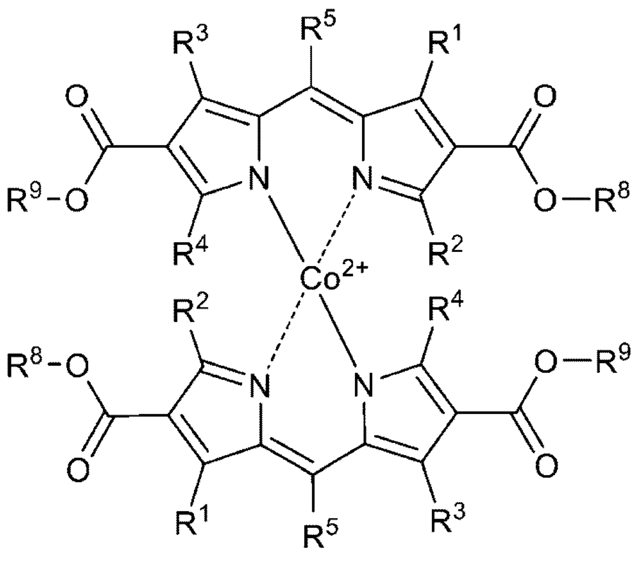

(I-1)

In the formula, $R^1$ to $R^5$ each independently represent a monovalent group selected from the group consisting of a hydrogen atom, a halogen atom, an aliphatic hydrocarbon group, an alkoxy group, an alkylthio group, an aromatic

hydrocarbon group, a heterocyclic group, a hydroxyl group, a mercapto group, a nitro group, a substituted amino group, an unsubstituted amino group, a cyano group, a sulfo group, an ester group and an acyl group, and $R^8$ and $R^9$ each independently represent an alkyl group having 1 to 6 carbon atoms.

[13] The dipyrromethene cobalt complex according to [12], wherein, when thermogravimetric measurement is performed under conditions of a gas flow rate of 500 mL/min and a temperature increase rate of 10°C/min, a difference between a 50% weight loss temperature when the gas is air and a 50% weight loss temperature when the gas is nitrogen is 10°C or less.

[14] The dipyrromethene cobalt complex according to [12] or [13], wherein $R^5$ is a hydrogen atom.

[15] The dipyrromethene cobalt complex according to any one of [12] to [14], wherein $R^1$ to $R^4$ are alkyl groups, and a sum of carbon numbers of $R^1$ and $R^2$ is 3 or greater and a sum of carbon numbers of $R^3$ and $R^4$ is 3 or greater.

[16] The dipyrromethene cobalt complex according to any one of [12] to [15], wherein a wavelength of maximum absorption of an acetone solution thereof is 470 nm to 530 nm.

[17] A display device including the optical film according to any one of [1] to [5].

[18] A display device including the optical film according to [11].

The present invention has yet still another aspect as follows.

[1] An optical film including: a transparent substrate; and a colored layer laminated on at least one side of the transparent substrate, the colored layer containing a dye (A), the dye (A) containing a colorant having a wavelength of maximum absorption of 489 nm to 500 nm and a full width at half maximum of an absorption peak of 22 nm or less in acetone solution with a concentration of $5.0\times10^{-6}$ M, the colorant containing a dipyrromethene cobalt complex having a structure represented by the following formula (I), and having a full width at half maximum of an absorption peak of 30 nm or less.

[Chem. 24]

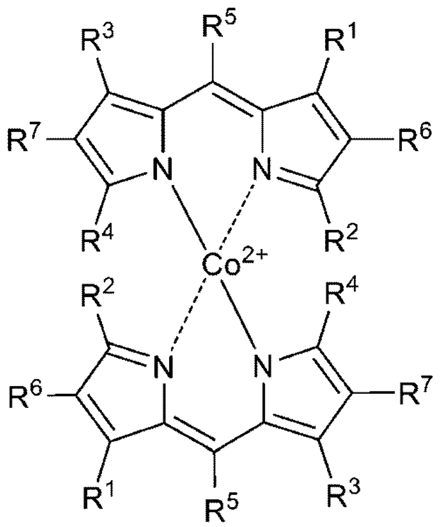

(I)

In the formula, $R^1$ to $R^7$ are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group.

[2] The optical film according to [1], wherein, in the following reaction formula (II) in which boron dipyrromethene having a structure represented by the following formula (III) reacts with singlet oxygen, the dipyrromethene cobalt complex has a free energy change $\Delta G$ between before and after reaction, calculated using a quantum chemical calculation program Gaussian 16 with a calculation method B3LYP and a basis function 6-31G (d,p) (however, a basis function LanL2DZ is assigned to elements in which $R^5$ in the formula (I) has an atomic number greater than that of Kr), of -1.0 kcal/mol or greater.

[Chem. 25]

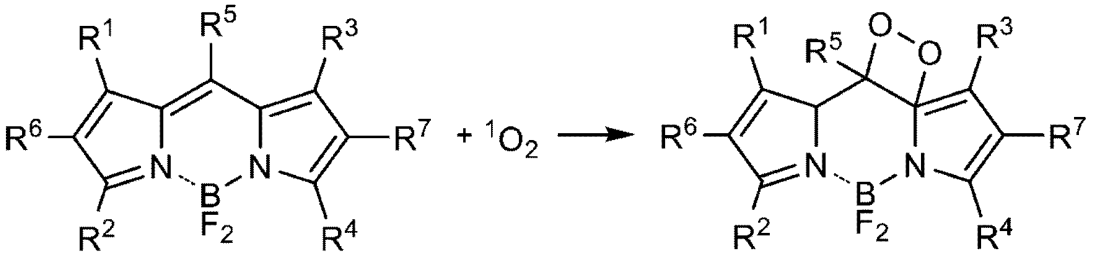

(II)

[Chem. 26]

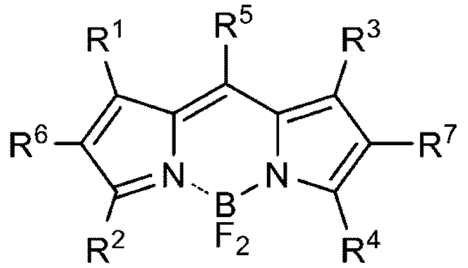

(III)

$R^1$ to $R^7$ in formula (II) and formula (III) each represent the same monovalent groups as $R^1$ to $R^7$ in the formula (I).

[3] The optical film according to [1] or [2], wherein, in the dipyrromethene cobalt complex, $R^5$ is a hydrogen atom.

[4] The optical film according to any one of [1] to [3], wherein, in the dipyrromethene cobalt complex, $R^1$ to $R^4$ are alkyl groups, and a sum of carbon numbers of $R^1$ and $R^2$ is 3 or greater and a sum of carbon numbers of $R^3$ and $R^4$ is 3 or greater.

[5] The optical film according to any one of [1] to [4], wherein the dipyrromethene cobalt complex has a structure represented by the following formula (I-1), and an acetone solution thereof with a concentration of $5.0 \times 10^{-6}$ M has a molar absorption coefficient of 190,000 L/(mol·cm) or greater.

[Chem. 27]

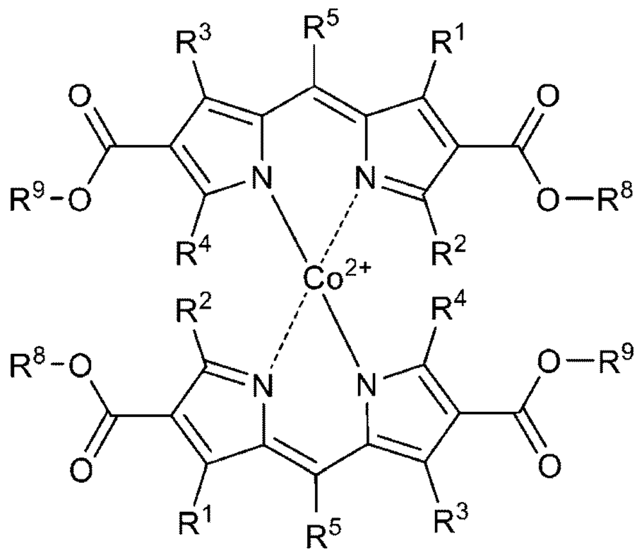

(I-1)

In the formula, $R^1$ to $R^5$ are as described above, and $R^8$ and $R^9$ each independently represent an alkyl group having 1 to 6 carbon atoms.

[6] The optical film according to [5], wherein, in the dipyrromethene cobalt complex, $R^8$ and $R^9$ are each independently a methyl group or an ethyl group.

[7] A composition for forming a colored layer, the composition including: a dye (A); a photopolymerizable compound

(B); and a photopolymerization initiator (C), the dye (A) containing a colorant having a wavelength of maximum absorption of 489 nm to 500 nm and a full width at half maximum of an absorption peak of 22 nm or less in acetone solution with a concentration of $5.0\times10^{-6}$ M, the colorant containing a dipyrromethene cobalt complex having a structure represented by the following formula (I), and having a full width at half maximum of an absorption peak of 30 nm or less in a cured product.

[Chem. 28]

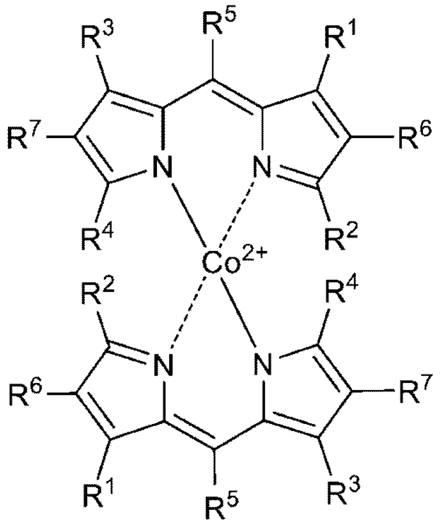

(I)

In the formula, $R^1$ to $R^7$ are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group.

[8] The composition for forming a colored layer according to [7], wherein, in the following reaction formula (II) in which boron dipyrromethene having a structure represented by the following formula (III) reacts with singlet oxygen, the dipyrromethene cobalt complex has a free energy change $\Delta G$ between before and after reaction, calculated using a quantum chemical calculation program Gaussian 16 with a calculation method B3LYP and a basis function 6-31G (d,p) (however, a basis function LanL2DZ is assigned to elements in which $R^5$ in the formula (I) has an atomic number greater than that of Kr), of -1.0 kcal/mol or greater.

[Chem. 29]

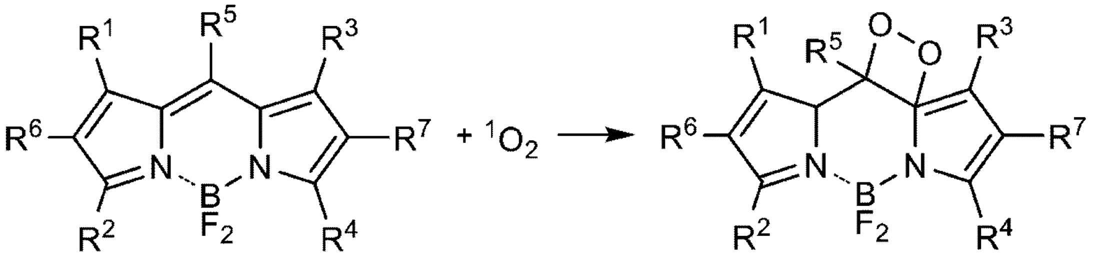

(II)

[Chem. 30]

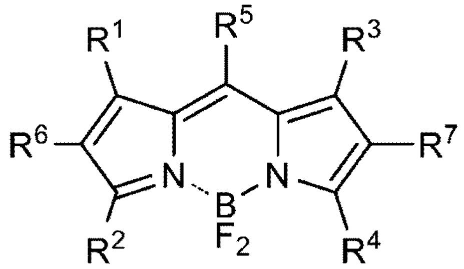

(III)

$R^1$ to $R^7$ in formula (II) and formula (III) each represent the same monovalent groups as $R^1$ to $R^7$ in the formula (I).

[9] The composition for forming a colored layer according to [7] or [8], wherein, in the dipyrromethene cobalt complex, $R^5$ is a hydrogen atom.

[10] The composition for forming a colored layer according to any one of [7] to [9], wherein, in the dipyrromethene cobalt complex, $R^1$ to $R^4$ are alkyl groups, and a sum of carbon numbers of $R^1$ and $R^2$ is 3 or greater and a sum of carbon numbers of $R^3$ and $R^4$ is 3 or greater.

[11] The composition for forming a colored layer according to any one of [7] to [10], wherein the dipyrromethene cobalt complex has a structure represented by the following formula (I-1), and an acetone solution thereof with a concentration of $5.0\times10^{-6}$ M has a molar absorption coefficient of 190,000 L/(mol·cm) or greater.

[Chem. 31]

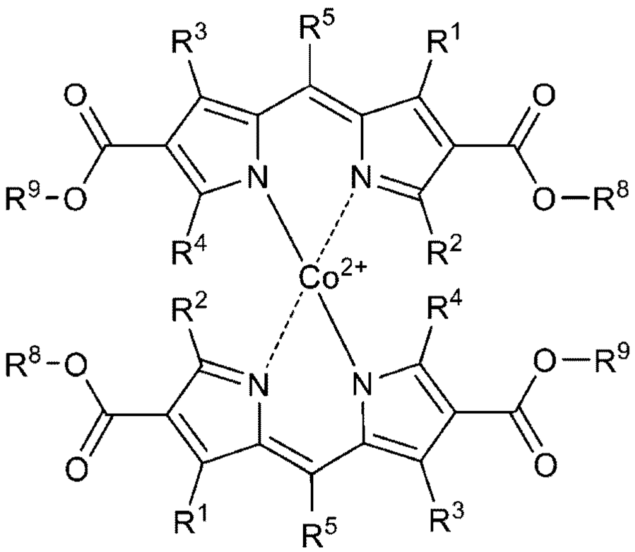

(I-1)

In the formula, $R^1$ to $R^5$ are as described above, and $R^8$ and $R^9$ each independently represent an alkyl group having 1 to 6 carbon atoms.

[12] The composition for forming a colored layer according to [11], wherein, in the dipyrromethene cobalt complex, $R^8$ and $R^9$ are each independently a methyl group or an ethyl group.

[13] The composition for forming a colored layer according to any one of [7] to [12], further containing a non-polymerizable additive (D).

[14] An optical film including: a transparent substrate; and a colored layer laminated on at least one side of the transparent substrate, the colored layer being a cured product of the composition for forming a colored layer according to any one of [7] to [13].

[15] A display device including the optical film according to any one of [1] to [6] and [14].

[Advantageous Effects of Invention]

According to the present invention, it is possible to provide an optical film capable of selectively and efficiently absorbing light having a wavelength of around 500 nm and excellent in light fastness, a composition for forming a colored layer capable of selectively and efficiently absorbing light having a wavelength of around 500 nm and excellent in light

fastness, a dipyrromethene cobalt complex capable of selectively and efficiently absorbing light having a wavelength of around 500 nm and excellent in light fastness, and a display device using the optical film.

[Brief Description of Drawings]

Fig. 1 is a cross-sectional view of an optical film according to a first embodiment of the present invention.
Fig. 2 is a cross-sectional view of an optical film according to another embodiment of the present invention.
Fig. 3 is a cross-sectional view of an optical film according to another embodiment of the present invention.
Fig. 4 is a cross-sectional view of an optical film according to another embodiment of the invention.
Fig. 5 is a cross-sectional view of an optical film according to another embodiment of the invention.
Fig. 6 is a cross-sectional view of an optical film according to another embodiment of the invention.
Fig. 7 is a cross-sectional view of an optical film according to another embodiment of the invention.
Fig. 8 is a cross-sectional view of an optical film according to another embodiment of the invention.
Fig. 9 is a spectrum of a light source used to evaluate white luminous efficiency.
Fig. 10 is a spectrum of a light source used to evaluate color purity.

[Description of Embodiments]

[Optical Film]

An optical film according to one aspect of the present invention includes: a transparent substrate; and a colored layer laminated on at least one side of the transparent substrate, the colored layer containing a dye (A), the dye (A) containing a colorant having a wavelength of maximum absorption in the range of 470 nm to 530 nm, the colorant containing a dipyrromethene cobalt complex having a structure represented by the following formula (I), in which $R^1$ to $R^7$ in the following formulas (I) and (II) are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group, wherein the colorant satisfies at least one of the following conditions (1) to (4):

(1) The colorant has a wavelength of maximum absorption in the range of 470 nm to 530 nm, and, when thermogravimetric measurement is performed for the dipyrromethene cobalt complex under conditions of a gas flow rate of 500 mL/min and a temperature increase rate of 10°C/min, a 5% weight loss temperature when the gas is air and a 5% weight loss temperature when the gas is nitrogen are both 300°C or higher, and when thermogravimetric measurement is performed under conditions of a nitrogen flow rate of 500 mL/min and a temperature increase rate of 10°C/min, a 50% weight loss temperature is 360°C or higher and 470°C or lower;
(2) The colorant has a wavelength of maximum absorption of 489 nm to 500 nm and a full width at half maximum of an absorption peak of 22 nm or less in acetone solution with a concentration of $5.0\times10^{-6}$ M, and has a full width at half maximum of an absorption peak of 30 nm or less;
(3) The colorant has a wavelength of maximum absorption in the range of 470 nm to 530 nm, and contains a dipyrromethene cobalt complex in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is 0.92 kcal/mol or greater; and
(4) The colorant has a wavelength of maximum absorption in the range of 470 nm to 530 nm, and contains a dipyrromethene cobalt complex in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is -1.0 kcal/mol or greater, and at least one of $R^1$ to $R^4$ is a hydrogen atom or a halogen atom.

[Chem. 32]

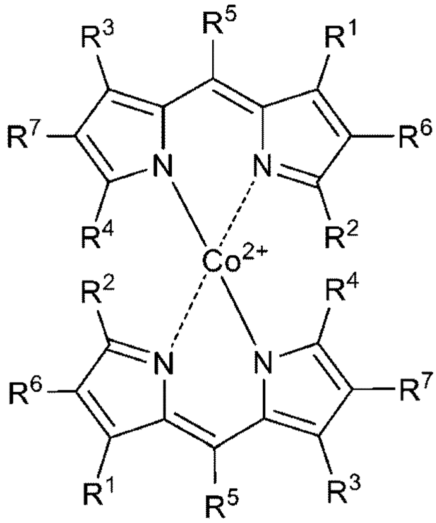

(I)

[Chem. 33]

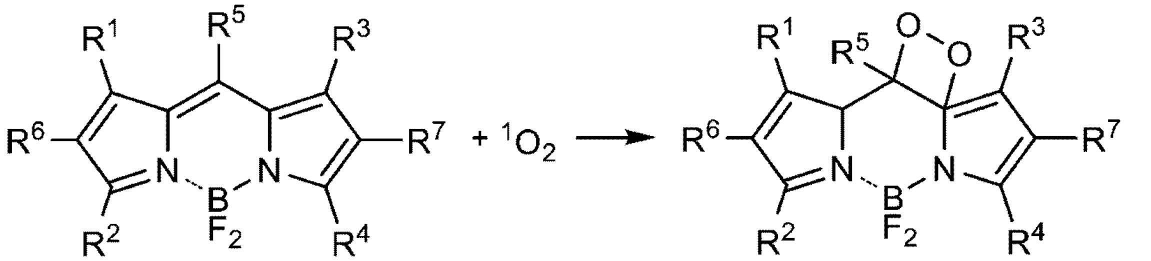

(II)

An optical film according to an embodiment of the present invention will be described below.

<First Embodiment>

With reference to Fig. 1, an optical film according to a first embodiment of the present invention will be described in detail. As shown in Fig. 1, an optical film 1 includes a colored layer 10, a transparent substrate 20 and a functional layer 30. The functional layer 30 includes a low refractive index layer 31 and a hard coat layer 32. That is, the optical film 1 has the transparent substrate 20 located on one surface of the colored layer 10, and is a laminate in which the colored layer 10, the transparent substrate 20, the hard coat layer 32 and the low refractive index layer 31 are laminated in this order.

The thickness of the optical film 1 may be, for example, preferably in a range of 10 μm to 140 μm, more preferably 15 μm to 120 μm, and still more preferably 20 μm to 100 μm. When the thickness of the optical film 1 is greater than or equal to the lower limit, the strength of the optical film 1 can be further increased. When the thickness of the optical film 1 is less than or equal to the upper limit, the optical film 1 can be more lightweight, which is advantageous in making the display device thinner.

Each of the layers constituting the optical film 1 will be described below.

<<Colored Layer>>

The colored layer 10 contains a dye (A).

In a preferred embodiment, the colored layer 10 is a cured product of the composition for forming a colored layer of the present invention. The composition for forming a colored layer of the present invention contains a dye (A), a photopolymerizable compound (B) and a photopolymerization initiator (C). When the colored layer 10 is a cured product of the composition for forming a colored layer of the present invention, the colored layer 10 contains the dye (A) and a polymer of the photopolymerizable compound (B).

The colored layer 10 and the composition for forming a colored layer of the present invention may further contain a

non-polymerizable additive (D). The composition for forming a colored layer of the present invention may further contain a solvent (E).

The thickness of the colored layer 10 may be, for example, preferably 0.5 μm to 10 μm. When the thickness of the colored layer 10 is greater than or equal to the lower limit, color purity can be improved, whereby both color purity and luminous efficiency can be achieved. When the thickness of the colored layer 10 is less than or equal to the upper limit, it is advantageous in making the display device thinner.

The thickness of the colored layer 10 is determined by observing the cross-section in the thickness direction of the optical film 1 using a microscope or the like.

<Dye (A)>

The dye (A) contains a colorant (hereinafter, also referred to as a "first colorant") having a wavelength of maximum absorption in the range of 470 nm to 530 nm.

When the wavelength of maximum absorption of the first colorant is greater than or equal to the lower limit, the luminance of blue light emission is less likely to decrease. When the wavelength of maximum absorption of the first colorant is less than or equal to the upper limit, the luminance of green light emission is less likely to decrease. Therefore, by controlling the absorption wavelength and absorption intensity, both color purity and luminous efficiency can be easily achieved.

The full width at half maximum of the absorption spectrum of the first colorant is preferably 15 nm to 30 nm, and more preferably 15 nm to 25 nm. When the full width at half maximum of the absorption spectrum of the first colorant is within the above numerical range, both color purity and luminous efficiency can be easily achieved.

The first colorant contains a specific dipyrromethene cobalt complex (hereinafter, also referred to as "complex (I)").

Complex (I) has a structure represented by the following formula (I), and $R^1$ to $R^7$ are combined such that a free energy change between before and after the reaction (hereinafter, also referred to as "ΔG"), calculated by applying $R^1$ to $R^7$ in formula (I) to the following reaction formula (II), is -1.0 kcal/mol or greater. Even if a compound has a structure represented by formula (I), it does not fall within the definition of complex (I) when ΔG is less than -1.0 kcal/mol.

[Chem. 34]

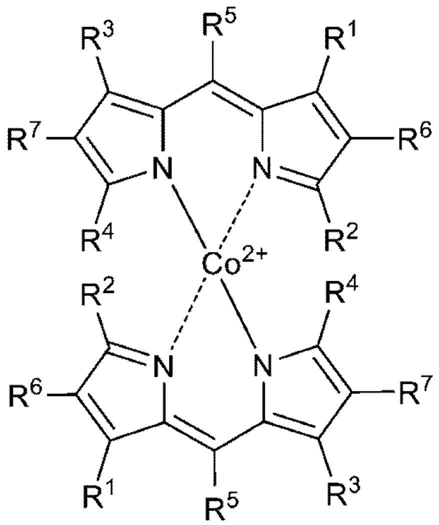

(I)

In the formula, $R^1$ to $R^7$ are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group.

When the monovalent group has a carbon atom (that is, an aliphatic hydrocarbon group, an alkoxy group, an alkylthio group, an aromatic hydrocarbon group, a heterocyclic group, a substituted amino group, an ester group, an acyl group, or the like), the monovalent group may have a substituent.

[Chem. 35]

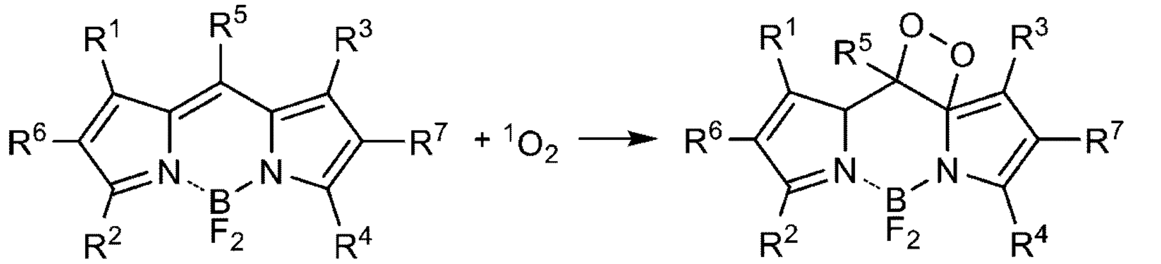

(II)

Reaction formula (II) is a reaction formula of boron dipyrromethene represented by the following formula (III) with singlet oxygen. The ΔG between before and after the reaction of boron dipyrromethene with singlet oxygen correlates with the ΔG between before and after the reaction of complex (I) with singlet oxygen. By calculating ΔG using boron dipyrromethene having the same substituents as $R^1$ to $R^7$ in complex (I) as an alternative structure, ΔG can be calculated in a shorter time than when calculating using the structure of the dipyrromethene cobalt complex itself, which has a large number of electrons and requires a greater calculation load.

[Chem. 36]

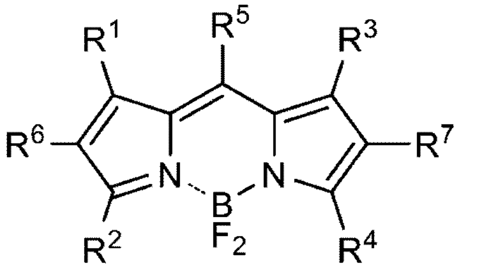

(III)

ΔG is a value calculated using the quantum chemical calculation program Gaussian 16 with the calculation method B3LYP and the basis function 6-31G (d,p) (however, the basis function LanL2DZ is assigned to elements having an atomic number greater than that of Kr in the periodic table). More specifically, ΔG is calculated, using the quantum chemical calculation program Gaussian 16 with the calculation method B3LYP and the basis function 6-31G (d,p) (however, the basis function LanL2DZ is assigned to elements having an atomic number greater than that of Kr in the periodic table), by subtracting a sum of the free energy value obtained as a result of structural optimization calculation and vibration calculation of boron dipyrromethene represented by the following formula (III) and the free energy value obtained as a result of structural optimization calculation and vibration calculation of singlet oxygen from the free energy value obtained as a result of structural optimization calculation and vibration calculation of the right side of reaction formula (II).

ΔG differs depending on the groups or atoms $R^1$ to $R^7$ in formula (II). Therefore, $R^1$ to $R^7$ in formula (II) are selected such that ΔG is -1.0 kcal/mol or greater.

When ΔG is -1.0 kcal/mol or greater, the dipyrromethene cobalt complex has excellent light fastness, and a colored layer and an optical film containing the dipyrromethene cobalt complex also have excellent light fastness.

ΔG is preferably 0.0 kcal/mol or greater, more preferably 0.3 kcal/mol or greater, and still more preferably 0.92 kcal/mol or greater. Larger ΔG is preferred, and the upper limit is not particularly limited, but may be, for example, 5 kcal/mol.

In formula (I), examples of the halogen atom in $R^1$ to $R^7$ include a fluorine atom, chlorine atom, bromine atom and iodine atom.

Examples of the aliphatic hydrocarbon group in $R^1$ to $R^7$ include an alkyl group and alkenyl group.

Examples of the alkyl group include a methyl group, ethyl group, n-propyl group, iso-propyl group, n-butyl group, iso-butyl group, sec-butyl group, t-butyl group, n-pentyl group, iso-pentyl group, 2-methylbutyl group, 1-methylbutyl group, neo-pentyl group, 1,2-dimethylpropyl group, 1,1-dimethylpropyl group, cyclo-pentyl group, n-hexyl group, 4-methylpentyl group, 3-methylpentyl group, 2-methylpentyl group, 1-methylpentyl group, 3,3-dimethylbutyl group, 2,3-dimethylbutyl group, 1,3-dimethylbutyl group, 2,2-dimethylbutyl group, 1,2-dimethylbutyl group, 1,1-dimethylbutyl group, 3-ethylbutyl group, 2-ethylbutyl group, 1-ethylbutyl group, 1,2,2-trimethylbutyl group, 1,1,2-trimethylbutyl group, 1-ethyl-2-methylpropyl group, cyclo-hexyl group, n-heptyl group, 2-methylhexyl group, 3-methylhexyl group, 4-methylhexyl group, 5-methylhexyl group, 2,4-dimethylpentyl group, n-octyl group, 2-ethylhexyl group, 2,5-dimethylhexyl group, 2,5,5-trimethylpentyl group, 2,4-dimethylhexyl group, 2,2,4-trimethylpentyl group, n-octyl group, 3,5,5-trimethylhexyl group, n-nonyl

group, n-decyl group, 4-ethyloctyl group, 4-ethyl-4,5-methylhexyl group, n-undecyl group, n-dodecyl group, 1,3,5,7-tetraethyloctyl group, 4-butyl octyl group, 6,6-diethyloctyl group, n-tridecyl group, 6-methyl-4-butyl octyl group, n-tetradecyl group, n-pentadecyl group, 3,5-dimethylheptyl group, 2,6-dimethylheptyl group, 2,4-dimethylheptyl group, 2,2,5,5-tetramethylhexyl group, 1-cyclo-pentyl-2,2-dimethylpropyl group and 1-cyclo-hexyl-2,2-dimethylpropyl group.

One or more hydrogen atoms of these alkyl groups may be substituted with a substituent such as a halogen atom or an alkoxy group.

The alkyl group may be linear, branched or cyclic. The alkyl group may have, for example, 1 to 20 carbon atoms.

Examples of the alkenyl group include a vinyl group, propenyl group, 1-butenyl group, iso-butenyl group, 1-pentenyl group, 2-pentenyl group, 2-methyl-1-butenyl group, 3-methyl-1-butenyl group, 2-methyl-2-butenyl group, 2,2-dicyanovinyl group, 2-cyano-2-methylcarboxyvinyl group and 2-cyano-2-methylsulfonevinyl group.

The alkenyl group may be linear or branched. The alkenyl group may have, for example, 2 to 20 carbon atoms.

Examples of the alkoxy group in $R^1$ to $R^7$ include a methoxy group, ethoxy group, n-propoxy group, iso-propoxy group, n-butoxy group, iso-butoxy group, sec-butoxy group, t-butoxy group, n-pentoxy group, iso-pentoxy group, neo-pentoxy group, n-hexyloxy group and n-dodecyloxy group.

The alkoxy group may be linear or branched. The alkoxy group may have, for example, 1 to 20 carbon atoms.

Examples of the alkylthio group in $R^1$ to $R^7$ include a methylthio group, ethylthio group, n-propylthio group, iso-propylthio group, n-butylthio group, iso-butylthio group, sec-butylthio group, t-butylthio group, n-pentylthio group, iso-pentylthio group, 2-methylbutylthio group, 1-methylbutylthio group, neo-pentylthio group, 1,2-dimethylpropylthio group and 1,1-dimethylpropylthio group.

The alkylthio group may be linear or branched. The alkylthio group may have, for example, 1 to 20 carbon atoms.

Examples of the aromatic hydrocarbon group in $R^1$ to $R^7$ include an aralkyl group and aryl group. One or more hydrogen atoms of the aromatic hydrocarbon group may be substituted with a substituent such as a halogen atom, aliphatic hydrocarbon group, alkoxy group, alkylthio group, aromatic hydrocarbon group, heterocyclic group, hydroxyl group, mercapto group, nitro group, substituted amino group, unsubstituted amino group, cyano group, sulfo group, ester group or acyl group.

Examples of the aralkyl group include a benzyl group, nitrobenzyl group, cyanobenzyl group, hydroxybenzyl group, methylbenzyl group, dimethylbenzyl group, trimethylbenzyl group, dichlorobenzyl group, methoxybenzyl group, ethoxybenzyl group, trifluoromethylbenzyl group, naphthylmethyl group, nitronaphthylmethyl group, cyanonaphthylmethyl group, hydroxynaphthylmethyl group, methylnaphthylmethyl group and trifluoromethylnaphthyl methyl group.

The aralkyl group may have, for example, 7 to 20 carbon atoms.

Examples of the aryl group include a phenyl group, nitrophenyl group, cyanophenyl group, hydroxyphenyl group, methylphenyl group, dimethylphenyl group, trimethylphenyl group, dichlorophenyl group, methoxyphenyl group, ethoxyphenyl group, trifluoromethylphenyl group, N,N-dimethylaminophenyl group, naphthyl group, nitronaphthyl group, cyanonaphthyl group, hydroxynaphthyl group, methylnaphthyl group and trifluoromethylnaphthyl group.

The aryl group may have, for example, 6 to 20 carbon atoms.

Examples of the heterocyclic group in $R^1$ to $R^7$ include a heteroaryl group.

Examples of the heteroaryl group include a pyrrolyl group, thienyl group, furanyl group, oxazolyl group, isoxazolyl group, oxadiazolyl group, imidazolyl group, benzoxyazolyl group, benzothiazolyl group, benzimidazolyl group, benzofuranyl group and indolyl group.

The heteroaryl group may have, for example, 4 to 20 carbon atoms.

The examples of the substituted amino group in $R^1$ to $R^7$ include an alkylcarbonylamino group and arylcarbonylamino group.

Examples of the alkylcarbonylamino group include an acetylamino group, ethylcarbonylamino group and butylcarbonylamino group.

The alkylcarbonylamino group may have, for example, 2 to 20 carbon atoms.

Examples of the arylcarbonylamino group include a phenylaminocarbonyl group, 4-methylphenylaminocarbonyl group, 2-methoxy phenylaminocarbonyl group and 4-n-propyl phenylaminocarbonyl group.

The arylcarbonylamino group may have, for example, 7 to 20 carbon atoms.

Examples of the ester group in $R^1$ to $R^7$ include an alkoxycarbonyl group, alkenyloxycarbonyl group and aralkyloxycarbonyl group.

Examples of the alkoxycarbonyl group include a methoxycarbonyl group, ethoxycarbonyl group, isopropyl oxycarbonyl group, n-butoxycarbonyl group, t-butoxycarbonyl group, 2,2-dimethylpropyl oxycarbonyl group and 2,4-dimethylbutyl oxycarbonyl group.

The alkoxycarbonyl group may have, for example, 2 to 20 carbon atoms.

Examples of the alkenyloxycarbonyl group include an allyloxycarbonyl group and 2-butenoxycarbonyl group.

The alkenyloxycarbonyl group may have, for example, 3 to 20 carbon atoms.

Examples of the aralkyloxycarbonyl group include benzyl oxycarbonyl group and phenethyloxycarbonyl group.

The aralkyloxycarbonyl group may have, for example, 8 to 20 carbon atoms.

Examples of the acyl group in $R^1$ to $R^7$ include a formyl group, acetyl group, ethylcarbonyl group, n-propyl carbonyl group, iso-propyl carbonyl group, n-butyl carbonyl group, iso-butyl carbonyl group, sec-butyl carbonyl group, t-butyl carbonyl group, n-pentyl carbonyl group, iso-pentyl carbonyl group, neo-pentyl carbonyl group, 2-methylbutyl carbonyl group and nitrobenzyl carbonyl group.

The acyl group may have, for example, 1 to 20 carbon atoms.

When the monovalent group in $R^1$ to $R^7$ has a carbon atom, the carbon number of the monovalent group is preferably 10 or less, more preferably 6 or less, and still more preferably 4 or less. When the carbon number is less than or equal to the upper limit, the molecular weight of the complex (I) is relatively low, and light having a wavelength of around 500 nm can be sufficiently absorbed even at a low colorant concentration.

When the monovalent group has a carbon atom, the lower limit of the carbon number is the same as the lower limit of the range of the carbon number described in the above description of each monovalent group.

In formula (I), it is preferred that $R^1$ to $R^4$ are alkyl groups, and a sum of carbon numbers of $R^1$ and $R^2$ is 3 or greater and a sum of carbon numbers of $R^3$ and $R^4$ is 3 or greater. In this case, $\Delta G$ tends to be large, improving the light fastness. The reason for this seems to be that the attack of singlet oxygen on the meso position of the dipyrromethene structure is inhibited by the steric hindrance by $R^1$ or $R^2$ and the steric hindrance by $R^3$ or $R^4$. Further, due to improvement in miscibility with the resin constituting the coating film, the compound can stably exist in the coating film, improving the light fastness. The sum of carbon numbers of $R^1$ and $R^2$ and the sum of carbon numbers of $R^3$ and $R^4$ are each preferably 4 or greater. The upper limit of the sum of carbon numbers of $R^1$ and $R^2$ and the upper limit of the sum of carbon numbers of $R^3$ and $R^4$ may be 12, for example, and preferably 8.

In formula (I), it is also preferred that at least one of $R^1$ to $R^4$ is a hydrogen atom or a halogen atom. In this case, $\Delta G$ tends to be large, improving the light fastness. In this case, it is more preferred that $R^1$ and $R^3$ are each independently a hydrogen atom or a halogen atom and $R^2$ and $R^4$ are each independently an alkyl group having 1 to 4 carbon atoms, or $R^1$ and $R^3$ are each independently an alkyl group having 1 to 4 carbon atoms and $R^2$ and $R^4$ are each independently a halogen atom.

In formula (I), $R^5$ is preferably a hydrogen atom. In this case, $\Delta G$ tends to be large, improving the light fastness.

In formula (I), it is preferred that $R^6$ and $R^7$ are each independently an ester group. In this case, $\Delta G$ tends to be large, improving the light fastness. The reason for this seems to be that the attack of singlet oxygen on the meso position of the dipyrromethene structure is inhibited due to $R^6$ and $R^7$ having a bulky structure.

Among the ester groups, an alkoxycarbonyl group having 2 to 7 carbon atoms is preferred, and an alkoxycarbonyl group having 2 to 3 carbon atoms is more preferred. In this case, due to the molecular weight of complex (I) being relatively low, the concentration of the colorant can be reduced.

A preferred example of complex (I) is a dipyrromethene cobalt complex having a structure represented by the following formula (I-1), and the acetone solution (solution obtained by dissolving the dipyrromethene cobalt complex in acetone) has a molar absorption coefficient of 190,000 L/(mol·cm) or greater. Such a dipyrromethene cobalt complex has excellent light fastness. Further, it has a relatively low molecular weight, and the concentration of the colorant can be reduced.

[Chem. 37]

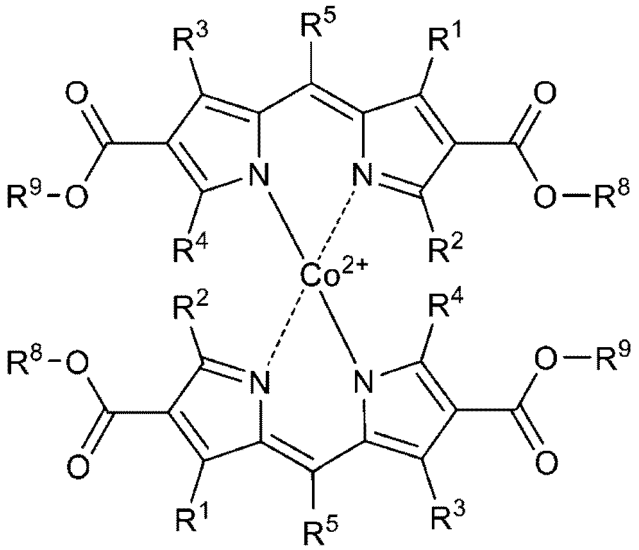

(I-1)

In the formula, $R^1$ to $R^5$ are as described above, and $R^8$ and $R^9$ each independently represent an alkyl group having 1 to 6 carbon atoms. It is preferred that $R^8$ and $R^9$ are each independently a methyl group or an ethyl group.
When the molar absorption coefficient is 190,000 L/(mol·cm) or greater, the light fastness tends to be improved.
The molar absorption coefficient is preferably 200,000 L/(mol·cm) or greater, and more preferably 210,000 L/(mol cm) or greater. The upper limit of the molar absorption coefficient is not particularly limited, but may be, for example, 300,000 L/(mol·cm).
The molar absorption coefficient is measured by the method described later in Examples.
The molar absorption coefficient differs depending on the groups or atoms $R^1$ to $R^5$, $R^8$ and $R^9$ in formula (I-1). Therefore, $R^1$ to $R^5$, $R^8$ and $R^9$ in formula (I-1) are selected such that the molar absorption coefficient is 190,000 L/(mol·cm) or greater.
The method of producing complex (I) is not particularly limited, and can be produced according to the method described in, for example, JP 2002-212456 A.
$R^1$ to $R^7$ in formula (I) can be appropriately selected to control the wavelength of maximum absorption of complex (I).
The dye (A) may further contain a second colorant having a wavelength of maximum absorption in the range of 560 nm to 620 nm. Containing the second colorant can further improve the color purity.
The full width at half maximum of the absorption spectrum of the second colorant is preferably in the range of 15 nm to 55 nm.
The dye (A) may further contain another colorant other than the first and second colorants.
Examples of another colorant include a third colorant whose lowest transmittance in the wavelength range of 380 nm to 780 nm is in the range of 650 nm to 780 nm. Containing the third colorant further can minimize a decrease in luminous efficiency and further improve the color purity.
The dye (A) preferably contains a compound having a porphyrin structure, merocyanine structure, phthalocyanine structure, azo structure, cyanine structure, squarylium structure, coumarin structure, polyene structure, quinone structure, tetrad porphyrin structure, pyrromethene structure or indigo structure; or a metal complex thereof. The containing of the above compounds or metal complexes thereof in the dye (A) can achieve both color purity and luminous efficiency, and further improve the display quality.
The dye (A) may contain only one of these compounds or metal complexes thereof, or two or more of them. These compounds or metal complexes thereof may be contained in the first, second, or third colorant, or in two or more of these colorants.
The content of the dye (A) is preferably 0.01 to 5.0 mass%, more preferably 0.01 to 2.0 mass% relative to the solid content of the composition for forming a colored layer. When the content of the dye (A) is greater than or equal to the lower limit, and the content of the dye (A) is less than or equal to the upper limit, external light or secondary emission from a light source of the display device can be effectively absorbed. When the content of the dye (A) is less than or equal to the upper limit, dye aggregation or association can be suppressed.
The solid content of the composition for forming a colored layer is the total of all the components other than the solvent (E). The content of the dye (A) relative to the solid content of the composition for forming a colored layer can be regarded as the content of the dye (A) relative to the total mass of the colored layer.

<Photopolymerizable Compound (B)>

The photopolymerizable compound (B) is a compound that polymerizes and cures when irradiated with ionizing radiation such as ultraviolet light.
Examples of the photopolymerizable compound (B) include monofunctional (meth)acrylates, bifunctional (meth) acrylates and tri- or higher functional (meth)acrylates. The photopolymerizable compound (B) preferably contains bi- or higher functional (meth)acrylates.
In the specification, "(meth)acrylate" is a general term for both acrylate and methacrylate, and "(meth)acryloyl" is a general term for both acryloyl and methacryloyl.
The monofunctional (meth)acrylates are compounds having one (meth)acryloyl group, and examples thereof include 2-hydroxyethyl (meth)acrylate, 2-hydroxypropyl (meth)acrylate, 2-hydroxybutyl (meth)acrylate, n-butyl (meth) acrylate, isobutyl (meth)acrylate, t-butyl (meth)acrylate, glycidyl (meth)acrylate, acryloylmorpholine, N-vinylpyrrolidone, tetrahydrofurfuryl acrylate, cyclohexyl (meth)acrylate, 2-ethylhexyl (meth)acrylate, isobornyl (meth)acrylate, isodecyl (meth)acrylate, lauryl (meth)acrylate, tridecyl (meth)acrylate, cetyl (meth)acrylate, stearyl (meth)acrylate, benzyl (meth) acrylate, 2-ethoxyethyl (meth)acrylate, 3-methoxybutyl (meth)acrylate, ethyl carbitol (meth)acrylate, phosphate (meth) acrylate, ethylene-oxide-modified phosphate (meth)acrylate, phenoxy (meth)acrylate, ethylene-oxide-modified phenoxy (meth)acrylate, propylene-oxide-modified phenoxy (meth)acrylate, nonyl phenol (meth)acrylate, ethylene-oxide-modified nonyl phenol (meth)acrylate, propylene-oxide-modified nonyl phenol (meth)acrylate, methoxy diethylene glycol (meth)acrylate, methoxy polyethylene glycol (meth)acrylate, methoxy propylene glycol (meth)acrylate, 2-(meth)acryloyl

oxyethyl-2-hydroxy propyl phthalate, 2-hydroxy-3-phenoxy propyl (meth)acrylate, 2-(meth)acryloyl oxyethyl hydrogen phthalate, 2-(meth)acryloyl oxypropyl hydrogen phthalate, 2-(meth)acryloyl oxypropyl hexahydro hydrogen phthalate, 2-(meth)acryloyl oxypropyl tetrahydro hydrogen phthalate, dimethylaminoethyl (meth)acrylate, trifluoroethyl (meth) acrylate, tetrafluoropropyl (meth)acrylate, hexafluoropropyl (meth)acrylate, octafluoropropyl (meth)acrylate, 2-adamantane, and adamantane derivative mono(meth)acrylates, such as adamantyl acrylate having a monovalent mono(meth) acrylate which is derived from adamantane diol.

The bifunctional (meth)acrylates are compounds having two (meth)acryloyl groups, and examples thereof include di(meth)acrylates, such as ethylene glycol di(meth)acrylate, diethylene glycol di(meth)acrylate, butanediol di(meth)acrylate, hexanediol di(meth)acrylate, nonanediol di(meth)acrylate, ethoxylated hexanediol di(meth)acrylate, propoxylated hexanediol di(meth)acrylate, triethylene glycol di(meth)acrylate, polyethylene glycol di(meth)acrylate, tripropylene glycol di(meth)acrylate, polypropylene glycol di(meth)acrylate, neopentyl glycol di(meth)acrylate, ethoxylated neopentyl glycol di(meth)acrylate and hydroxy pivalate neopentyl glycol di(meth)acrylate.

The tri- or higher functional (meth)acrylates are compounds having three or more (meth)acryloyl groups, and examples thereof include tri(meth)acrylates such as trimethylolpropane tri(meth)acrylate, ethoxylated trimethylolpropane tri(meth)acrylate, propoxylated trimethylolpropane tri(meth)acrylate, tris-2-hydroxyethyl isocyanurate tri(meth)acrylate and glycerin tri(meth)acrylate; trifunctional (meth)acrylate compounds such as pentaerythritol tri(meth)acrylate, dipentaerythritol tri(meth)acrylate and ditrimethylolpropane tri(meth)acrylate; trifunctional or higher polyfunctional (meth) acrylate compounds such as pentaerythritol tetra(meth)acrylate, ditrimethylolpropane tetra(meth)acrylate, dipentaerythritol tetra(meth)acrylate, ditrimethylol ditrimethylol ditrimethylol penta(meth)acrylate, ditrimethylolpropane penta(meth) acrylate, dipentaerythritol hexa(meth)acrylate and ditrimethylolpropane hexa(meth)acrylate; and polyfunctional (meth) acrylate compounds in which a part of each of these (meth)acrylates is substituted with an alkyl group or ε-caprolactone.

The photopolymerizable compound (B) may be urethane (meth)acrylate. Examples of the urethane (meth) acrylate include those obtained by reacting a (meth)acrylate monomer having a hydroxyl group with a product of the reaction between a polyester polyol with an isocyanate monomer or a prepolymer.

Examples of the urethane (meth)acrylate include a pentaerythritol triacrylate hexamethylene diisocyanate urethane prepolymer, dipentaerythritol pentaacrylate hexamethylene diisocyanate urethane prepolymer, pentaerythritol triacrylate toluene diisocyanate urethane prepolymer, dipentaerythritol pentaacrylate toluene diisocyanate urethane prepolymer, pentaerythritol triacrylate isophorone diisocyanate urethane prepolymer and dipentaerythritol pentaacrylate isophorone diisocyanate urethane prepolymer.

The above (meth)acrylates may be used singly or in combination of two or more. Further, the above (meth) acrylates may be monomers or partially polymerized oligomers in the composition for forming a colored layer.

The content of the photopolymerizable compound (B) is preferably 50 to 99 mass%, and more preferably 70 to 99 mass% relative to the solid content of the composition for forming a colored layer. When the content of the photopolymerizable compound (B) is greater than or equal to the lower limit, the effect of suppressing fading can be further enhanced. When the content of the photopolymerizable compound (B) is less than or equal to the upper limit, the composition for forming a colored layer can be handled more easily.

<Photopolymerization Initiator (C)>

Examples of the photopolymerization initiator (C) include those generate radicals when irradiated with ionizing radiation such as ultraviolet light.

Examples of the photopolymerization initiator (C) include benzoins (e.g., benzoin and benzoin alkyl ethers such as benzoin methyl ether, benzoin ethyl ether and benzoin isopropyl ether), phenyl ketones [for example, acetophenones (e.g., acetophenone, 2-hydroxy-2-methyl-1-phenylpropane-1-one, 2,2-dimethoxy-2-phenylacetophenone, 2,2-diethoxy-2-phenylacetophenone and 1,1-dichloroacetophenone), alkylphenyl ketones such as 2-hydroxy-2-methylpropiophenone; and cycloalkylphenyl ketones such as 1-hydroxycyclohexylphenyl ketone], aminoacetophenones {e.g., 2-methyl-1-[4-(methylthio)phenyl]-2-morpholinoaminopropanone-1,2-benzyl-2-dimethylamino-1-(4-morpholinophenyl)-butanone-1}, anthraquinones (e.g., anthraquinone, 2-methylanthraquinone, 2-ethylanthraquinone, 2-t-butylanthraquinone and 1-chloroanthraquinone), thioxanthones (e.g., 2,4-dimethylthioxanthone, 2,4-diethylthioxanthone, 2-chlorothioxanthone and 2,4-diisopropylthioxanthone), ketals (e.g., acetophenone dimethyl ketal and benzyl dimethyl ketal), benzophenones (e.g., benzophenone), xanthones and phosphine oxides (e.g., 2,4,6-trimethylbenzoyldiphenylphosphine oxide). These photopolymerization initiators may be used singly or in combination of two or more.

The content of the photopolymerization initiator (C) is preferably 0.1 to 20 mass%, and more preferably 0.1 to 10 mass% relative to the solid content of the composition for forming a colored layer. When the content of the photopolymerization initiator (C) is greater than or equal to the lower limit, the composition for forming a colored layer can be sufficiently cured. When the content of the photopolymerization initiator (C) is less than or equal to the upper limit, unreacted photopolymerization initiator (D) is less likely to remain, reducing deterioration in reliability.

<Non-Polymerizable Additive (D)>

When the composition for forming a colored layer contains the non-polymerizable additive (D), various functions can be imparted to the colored layer 10.

Examples of the non-polymerizable additive (D) include radical scavengers, peroxide decomposers, singlet oxygen quenchers, leveling agents, defoaming agents, antioxidants, photosensitizers, antifouling agents and conductive materials. The non-polymerizable additive (D) may be used singly or in combination of two or more.

The non-polymerizable additive (D), having a function of preventing deterioration of the dye (A) due to light, heat, or the like, is preferably one or more selected from a radical scavenger, a peroxide decomposer and a singlet oxygen quencher.

The radical scavenger has a function of capturing radicals when the dye (A) undergoes oxidative deterioration and suppressing autoxidation to thereby suppress dye deterioration (also called fading). Examples of the radical scavenger include hindered amine photostabilizers, aromatic amine antioxidants and phenolic antioxidants, and in particular, hindered amine photostabilizers having a molecular weight of 2,000 or greater are preferably used. With the molecular weight of the hindered amine photostabilizer of 2,000 or greater, the effect of suppressing fading can be improved. The reason for this seems to be that the hindered amine photostabilizer is less likely to volatize, causing more molecules to remain in the colored layer 10, thereby providing a sufficient effect of suppressing fading.

Examples of the hindered amine photostabilizer having a molecular weight of 2,000 or greater include Chimassorb 2020 FDL, Chimassorb 944 FDL and Tinuvin 622 manufactured by BASF, and ADK STAB LA-63P manufactured by ADEKA.

The peroxide decomposer is a type of antioxidant that ionically decomposes hydroperoxides (ROOH, where R represents an alkyl group, O represents an oxygen atom, and H represents a hydrogen atom) into inactive compounds to suppress generation of radicals. The non-polymerizable additive (D) containing the peroxide decomposer can suppress oxidative deterioration of the dye (A) and extend the life of the light emitting element having the colored layer 10. Further, when a peroxide decomposer falls within the definition of singlet oxygen quencher, which will be described later, the singlet oxygen quencher is excluded from being the peroxide decomposer within the meaning of this specification.

Examples of the peroxide decomposer include sulfur-based antioxidants and phosphorus-based antioxidants. Examples of the sulfur-based antioxidants include didodecyl 3,3'-thiodipropionate and 2-mercaptobenzimidazole. Examples of the phosphorus-based antioxidants include trihexyl phosphite, trioleyl phosphite, trioctyl phosphite, tris(2-ethylhexyl) phosphite, tris(2,4-di-tert-butyl phenyl) phosphite, tris(1,1,1,3,3,3-hexafluoro-2-propyl) phosphite, triphenyl phosphite, tris(2-methylphenyl) phosphite, tris(4-methylphenyl) phosphite and 3,9-bis(2,4-di-tert-butylphenoxy)-2,4,8,10-tetraoxa-3,9-diphosphaspiro[5,5]undecane.

The singlet oxygen quencher is a compound that suppresses oxidative deterioration of the dye (A) due to singlet oxygen. The non-polymerizable additive (D) containing the singlet oxygen quencher can suppress oxidative deterioration of the dye (A) and extend the life of the light emitting element having the colored layer 10.

Examples of the singlet oxygen quencher include transition metal complexes, dyes (excluding the dye (A)), amines, phenols and sulfides. Particularly preferred materials for use as the singlet oxygen quencher include dialkyl phosphates, dialkyl dithiocarbamates, benzenedithiols, and transition metal complexes of similar dithiols, with nickel, copper or cobalt being preferably used as the center metal. Examples of the singlet oxygen quencher include NKX1199 (bis[2'-chloro-3-methoxy-4-(2-methoxyethoxy) dithiobenzyl]nickel), NKX113 (bis(dithiobenzyl)nickel) and NKX114 (bis[4-(dimethylamino)dithiobenzyl]nickel) manufactured by Hayashibara Co., Ltd., and D1781 (nickel(II) dibutyldithiocarbamate), B1350 (bis(dithiobenzyl)nickel(II)), B4360 (bis[4,4'-dimethoxy (dithiobenzyl)]nickel(II)) and T3204 (tetrabutylammonium bis (3,6-dichloro-1,2-benzenedithiolato)nickelate) manufactured by Tokyo Chemical Industry Co., Ltd.

The content of the non-polymerizable additive (D) is preferably 0.1 to 50 mass%, and more preferably 5 to 30 mass% relative to the solid content of the composition for forming a colored layer. When the content of the non-polymerizable additive (D) is greater than or equal to the lower limit, various functions can be imparted to the colored layer 10. When the content of the non-polymerizable additive (D) is less than or equal to the upper limit, curability can be easily maintained.

<Solvent (E)>

Examples of the solvent (E) include ethers, ketones, esters and cellosolves. Examples of the ethers include dibutyl ether, dimethoxymethane, dimethoxyethane, diethoxyethane, propylene oxide, 1,4-dioxane, 1,3-dioxolane, 1,3,5-trioxane, tetrahydrofuran, anisole and phenetole. Examples of the ketones include acetone, methyl ethyl ketone, diethyl ketone, dipropyl ketone, diisobutyl ketone, methyl isobutyl ketone, cyclopentanone, cyclohexanone, methylcyclohexanone and ethyl cyclohexanone. Examples of the esters include ethyl formate, propyl formate, n-pentyl formate, methyl acetate, ethyl acetate, methyl propionate, ethyl propionate, n-pentyl acetate and $\gamma$-butyrolactone. Examples of the cellosolves include methyl cellosolve, cellosolve (ethyl cellosolve), butyl cellosolve and cellosolve acetate. The solvents

(E) may be used singly or in combination of two or more.

The content of the solvent (E) is preferably 40 to 70 mass%, and more preferably 40 to 60 mass% relative to the total mass of the composition for forming a colored layer. When the content of the solvent (E) is within the above range, the solubility of the dye (A) and the non-polymerizable additive (D) is improved, whereby the coating liquid stability (liquid stability) is maintained, resulting in good coatability.

By using the composition for forming a colored layer of the present invention, the colored layer 10 can improve color purity and luminous efficiency, whereby both color purity and luminous efficiency can be achieved, improving display quality. This is effective in achieving low reflectance, high luminance, reduced film thickness, improved color reproducibility and excellent light fastness.

<<Transparent Substrate>>

The transparent substrate 20 is a sheet-like member located on one surface of the colored layer 10 and forming the optical film 1.

The transparent substrate 20 can be formed of a translucent resin film. For example, transparent resin, such as polyolefin, polyester, polyacrylate, polyamide, polyimide, polyarylate, polycarbonate, triacetyl cellulose, polyvinyl alcohol, polyvinyl chloride, cycloolefin copolymer, norbomene-containing resin, polyether sulfone and polysulfone, and inorganic glass can be used. Examples of the polyolefin include polyethylene and polypropylene. Examples of the polyester include polyethylene terephthalate, polybutylene terephthalate and polyethylene naphthalate. Examples of the polyacrylate include polymethyl methacrylate. Examples of the polyamides include nylon 6 and nylon 66. Among these, suitable examples are films made of polyethylene terephthalate (also called PET), films made of triacetyl cellulose (also called TAC), films of polymethyl methacrylate (also called PMMA) and films made of polyester other than PET.

The transparent substrate 20 may preferably have transmittance of, for example, 90% or higher. The transmittance of the transparent substrate 20 can be measured using a spectrophotometer (U-4100 manufactured by Hitachi, Ltd.).

The transparent substrate 20 may be provided with ultraviolet light absorption capability. The ultraviolet light absorption capability can be imparted to the transparent substrate 20 by adding an ultraviolet absorber to the resin material of the transparent substrate 20.

Examples of the ultraviolet absorber include salicylic acid ester ultraviolet absorbers, benzophenone ultraviolet absorbers, benzotriazole ultraviolet absorbers and cyanoacrylate ultraviolet absorbers.

These ultraviolet absorbers may be used singly or in combination of two or more.

When the transparent substrate 20 is provided with ultraviolet light absorption capability, it preferably has an ultraviolet shielding rate of 85% or higher. The ultraviolet shielding rate is a value measured in accordance with JIS L 1925, and is calculated by the following formula (I).

Ultraviolet shielding rate (%) = 100 - (average transmittance of ultraviolet light with wavelengths of 290 nm to 400 nm (%))

An ultraviolet shielding rate below 85% reduces the effect of suppressing fading with regard to the lightfastness of the dye (A).

The thickness of the transparent substrate 20 may be, for example, preferably 10 μm to 100 μm. When the thickness of the transparent substrate 20 is greater than or equal to the lower limit, the strength of the optical film 1 can be further increased. When the thickness of the transparent substrate 20 is less than or equal to the upper limit, the thickness of the optical film 1 can be further reduced.

The thickness of the transparent substrate 20 is determined by measurement with a digital caliper or the like.

«Functional layer»

The functional layer 30 is located on one or the other surface of the colored layer 10. By having the functional layer 30, the optical film 1 can exhibit various functions.

Examples of the functions of the functional layer 30 include antireflection function, antiglare function, oxygen barrier function, antistatic function, antifouling function, reinforcement function and ultraviolet absorption function (also called ultraviolet light absorption capability).

The functional layer 30 may be a monolayer or a multilayer. The functional layer 30 may have a single function or two or more functions.

When the optical film 1 has an antireflection function, the functional layer 30 serves as an antireflection layer. Examples of the antireflection layer include a low refractive index layer 31 having a lower refractive index than a hard coat

layer 32, an antiglare layer 34 and the transparent substrate 20, which will be described later. The low refractive index layer 31 can be formed by using, for the functional layer, a material having a lower refractive index than the materials of the hard coat layer 32, the antiglare layer 34 and the transparent substrate 20.

To adjust the refractive index of the low refractive index layer 31, fine particles of lithium fluoride (LiF), magnesium fluoride ($MgF_2$), sodium hexafluoroaluminum (cryolite, 3NaF AlFs, $Na_3AlF_6$) or aluminum fluoride ($AlF_3$), or fine silica particles may be added. It is effective to use particles having internal voids, such as fine, porous silica particles or hollow silica particles, as the fine silica particles to reduce the refractive index of the low refractive index layer 31. In addition, the photopolymerization initiator (D), additive (B) or solvent (E) described in relation to the colored layer 10 may be added as appropriate to the composition for forming the low refractive index layer 31 (also referred to as a composition for forming a low refractive index layer).

The refractive index of the low refractive index layer 31 is preferably in the range of 1.20 to 1.55.

Although the thickness of the low refractive index layer 31 is not specifically limited, it is preferably in the range of 40 nm to 1 μm, for example.

When the optical film 1 has an antiglare function, the functional layer 30 serves as an antiglare layer 34. The antiglare layer 34 has fine asperities on its surface causing scattering of external light to suppress reflection and in turn improve display quality. When combined with the low refractive index layer 31, the low refractive index layer 31 and the antiglare layer 34 constitute an antireflection layer.

The antiglare layer 34 contains at least one selected from fine organic particles and fine inorganic particles as necessary.

The fine organic particles are materials that form fine asperities on the surface and provide the function of scattering external light. Examples of the fine organic particles include resin particles of translucent resin materials such as acrylic resin, polystyrene resin, styrene-(meth)acrylate copolymers, polyethylene resin, epoxy resin, silicone resin, polyvinylidene fluoride and polyethylene fluoride resin. In order to adjust the refractive index and the dispersibility of resin particles, two or more types of resin particles having different characteristics (for example, refractive indexes) may be mixed.

The fine inorganic particles are a material for controlling sedimentation and aggregation of the fine organic particles. Examples of the fine inorganic particles include fine silica particles, fine metal oxide particles and fine particles of various minerals. Examples of the fine silica particles include colloidal silica and fine silica particles surface-modified with a reactive functional group such as an (meth)acryloyl group. Examples of the fine metal oxide particles include fine particles of alumina (aluminum oxide), zinc oxide, tin oxide, antimony oxide, indium oxide, titania (titanium dioxide) and zirconia (zirconium dioxide). Examples of the fine mineral particles include fine particles of mica, synthetic mica, vermiculite, montmorillonite, iron-montmorillonite, bentonite, beidellite, saponite, hectorite, stevensite, nontronite, magadiite, ilerite, kanemite, layered titanate, smectite and synthetic smectite. The fine mineral particles may either be natural or synthetic (including substituted products and derivatives), and also a mixture of both may be used. Among these fine mineral particles, organic layered clay is more preferred. Organic layered clay refers to a swelling clay in which organic onium ions are introduced between layers. The organic onium ion is not particularly limited as long as it can make a swelling clay organic by using the cation exchange properties of the swelling clay. When an organic layered clay mineral is used as the fine mineral particles, the synthetic smectite described above can be suitably used. Synthetic smectite has a function of increasing the viscosity of the coating liquid for forming an antiglare layer and suppressing sedimentation of resin particles and fine inorganic particles to adjust the shape of asperities on the surface of the antiglare layer 34 (functional layer 30).

When the optical film 1 has an oxygen barrier function, the functional layer 30 serves as an oxygen barrier layer 33. The oxygen barrier layer 33 has an oxygen permeability of 10 $cm^3/(m^2 \cdot day \cdot atm)$ or lower, preferably 5 $cm^3/(m^2 \cdot day \cdot atm)$ or lower, and more preferably 1 $cm^3/(m^2 \cdot day \cdot atm)$ or lower. When the oxygen permeability of the oxygen barrier layer 33 is lower than or equal to the upper limit, the functional layer 30 can be provided with a sufficient oxygen barrier function. The lower limit of the oxygen permeability of the oxygen barrier layer 33 is not particularly limited, and may be 0 $cm^3/(m^2 \cdot day \cdot atm)$.

The oxygen permeability of the oxygen barrier layer 33 is a value measured using an oxygen permeability measuring device at 30°C and a relative humidity of 60%.

When the optical film 1 has an antistatic function, the functional layer 30 serves as an antistatic layer. Examples of the antistatic layer include layers containing antistatic agents such as fine metal oxide particles such as antimony-doped tin oxide (also called ATO) and tin-doped indium oxide (also called ITO), polymeric conductive compositions and quaternary ammonium salts.

The antistatic layer may be provided on the outermost surface of the functional layer 30 or between the functional layer 30 and the transparent substrate 20. Alternatively, the antistatic layer may be formed by adding an antistatic agent to one of the above-described layers constituting the functional layer 30. When providing an antistatic layer, the optical film preferably has a surface resistance of $1.0 \times 10^6$ to $1.0 \times 10^{12}$ (Ω/ cm).

When the optical film 1 has an antifouling function, the functional layer 30 serves as an antifouling layer. The antifouling layer improves the antifouling performance by imparting both or one of water repellency and oil repellency.

Examples of the antifouling layer include layers containing antifouling agents such as silicon oxide, fluorine-containing silane compounds, fluoroalkylsilazanes, fluoroalkylsilanes, fluorine-containing silicon compounds and perfluoropolyether group-containing silane coupling agents.

The antifouling layer may be provided on the outermost surface of the functional layer 30, or formed by adding an antifouling agent to the outermost layer of the functional layer(s) 30.

When the optical film 1 has a reinforcement function, the functional layer 30 serves as a reinforcement layer. The reinforcement layer is a layer that reinforces the optical film. Examples of the reinforcement layer include the hard coat layer 32. Examples of the hard coat layer 32 include layers formed with a hard coat agent containing monofunctional, bifunctional or trifunctional (meth)acrylate or urethane (meth)acrylate, or (meth)acrylate or urethane (meth)acrylate with more functional groups.

When the optical film 1 has the ultraviolet light absorption capability, the functional layer 30 functions as an ultraviolet absorbing layer. Examples of the ultraviolet absorbing layer include layers containing triazine ultraviolet absorbers such as 2-(4,6-diphenyl-1,3,5-triazin-2-yl)-5-hexyloxyphenol and benzotriazole ultraviolet absorbers such as 2-(2H-benzotriazole-2-yl)-4-methylphenol.

The content of the ultraviolet absorber is preferably 0.1 to 5 mass% relative to the total mass of the materials forming the ultraviolet absorbing layer. When the content of the ultraviolet absorber is greater than or equal to the lower limit, the functional layer 30 can be provided with sufficient ultraviolet light absorption capability. When the content of the ultraviolet absorber is lower than or equal to the upper limit, it is possible to avoid insufficient hardness due to a decrease in the amount of the curing component.

In the optical film 1, one or both of the transparent substrate 20 and the functional layer 30 preferably have an ultraviolet shielding rate of 85% or higher, more preferably 90% or higher, and still more preferably 95% or higher, and may even be 100%. When the ultraviolet shielding rate is greater than or equal to the lower limit, lightfastness can be further improved.

The ultraviolet shielding rate can be measured according to the method described in JIS L 1925.

The ultraviolet shielding rate can be adjusted by imparting ultraviolet light absorption capability to one or both of the transparent substrate 20 and the functional layer 30.

The thickness of the functional layer 30 may be, for example, preferably in the range of 0.04 μm to 25 μm, more preferably 0.1 μm to 20 μm, and still more preferably 0.2 μm to 15 μm. When the thickness of the functional layer 30 is greater than or equal to the lower limit, it becomes easier to impart various functions to the optical film 1. When the thickness of the functional layer 30 is less than or equal to the upper limit, it is advantageous in making the display device thinner.

The thickness of the functional layer 30 is determined by observing the cross section in the thickness direction of the optical film 1 using a microscope or the like.

The optical film of the present embodiment can selectively and efficiently absorb light having a wavelength of around 500 nm and have excellent light fastness.

<Second Embodiment>

An optical film of the present embodiment is the same as that of the first embodiment except that the first colorant is different from that of the first embodiment. Therefore, description of the same parts as those in the first embodiment will be omitted. The description of the first embodiment can be applied to configurations, elements, forms, and the like which are not described in the present embodiment, and the description of the first embodiment can be combined with the present embodiment.

An optical film in the present embodiment may have an example structure shown in Fig. 1. A first colorant in the present embodiment contains a specific dipyrromethene cobalt complex (hereinafter, also referred to as a "complex (I)"). The complex (I) has a structure represented by formula (I) described in the first embodiment, and satisfies the following thermal properties (1) and (2).

Thermal properties (1): When thermogravimetric measurement is performed under conditions of a gas flow rate of 500 mL/min and a temperature increase rate of 10°C/min, the 5% weight loss temperature when the gas is air (hereinafter, also referred to as "5% weight loss temperature in air") and the 5% weight loss temperature when the gas is nitrogen (hereinafter, also referred to as "5% weight loss temperature in nitrogen") are both 300°C or higher.

Thermal properties (2): When thermogravimetric measurement is performed under conditions of a nitrogen flow rate of 500 mL/min and a temperature increase rate of 10°C/min, the 50% weight loss temperature (hereinafter, also referred to as "50% weight loss temperature in nitrogen") is 360°C or higher and 470°C or lower.

Even if a compound has a structure represented by formula (I), it does not fall within the definition of complex (I) of the present embodiment when it does not satisfy one or both of the thermal properties (1) and (2).

The 5% weight loss temperature in air, the 5% weight loss temperature in nitrogen and the 50% weight loss temperature in nitrogen differs depending on the groups or atoms $R^1$ to $R^7$ in formula (I). Therefore, $R^1$ to $R^7$ in formula (I) are selected and combined such that the dipyrromethene cobalt complex satisfies the thermal properties (1) and (2).

When the 5% weight loss temperature in air and the 5% weight loss temperature in nitrogen are both 300°C or higher, the dipyrromethene cobalt complex has high stability and excellent durability such as light fastness, and a colored layer and an optical film containing the dipyrromethene cobalt complex also have excellent durability.

The 5% weight loss temperature in air is preferably 300°C or higher, and more preferably 320°C or higher. The upper limit of the 5% weight loss temperature in air is not particularly limited, and may be, for example, 400°C.

The 5% weight loss temperature in nitrogen is preferably 300°C or higher, and more preferably 330°C or higher. The upper limit of the 5% weight loss temperature in nitrogen is not particularly limited, and may be, for example, 400°C.

When the 50% weight loss temperature in nitrogen is 360°C or higher, the dipyrromethene cobalt complex is less likely to deteriorate, and when it is 470°C or lower, the performance degradation of the optical film due to carbonized decomposition products can be reduced.

The 50% weight loss temperature in nitrogen is preferably 360°C or higher and 470°C or lower, and more preferably 380°C or higher and 410°C or lower.

It is preferred that the complex (I) further satisfies the following thermal properties (3).

Thermal properties (3): When thermogravimetric measurement is performed under conditions of a gas flow rate of 500 mL/min and a temperature increase rate of 10°C/min, a difference between the 50% weight loss temperature when the gas is air (hereinafter, also referred to as "50% weight loss temperature in air") and the 50% weight loss temperature when the gas is nitrogen, that is, the above-mentioned 50% weight loss temperature in nitrogen, is 10°C or less.

When the difference between the 50% weight loss temperature in air and the 50% weight loss temperature in nitrogen is 10°C or less, the light fastness tends to be improved. The smaller the difference between the 50% weight loss temperature in air and the 50% weight loss temperature in nitrogen, the less susceptible the dipyrromethene cobalt complex is to the effects of oxygen, which is one of the causes of degradation of the dipyrromethene cobalt complex.

The difference between the 50% weight loss temperature in air and the 50% weight loss temperature in nitrogen is preferably 5°C or less. The difference between the 50% weight loss temperature in air and the 50% weight loss temperature in nitrogen is an absolute value, and is calculated by "50% weight loss temperature in air - 50% weight loss temperature in nitrogen".

As with the 50% weight loss temperature in nitrogen, the 50% weight loss temperature in air differs depending on the groups or atoms $R^1$ to $R^7$.

$R^1$ to $R^7$ in formula (I) are the same as $R^1$ to $R^7$ described in the first embodiment.

In formula (I), $R^5$ is preferably a hydrogen atom. In this case, the light fastness tends to be improved. The reason for this seems to be that the electron density of the dipyrromethene cobalt complex decreases, stabilizing the dipyrromethene cobalt complex.

In formula (I), it is preferred that $R^6$ and $R^7$ are each independently an ester group. In this case, the light fastness tends to be improved. The reason for this seems to be that the electron density of the dipyrromethene cobalt complex decreases, stabilizing the dipyrromethene cobalt complex, and that $R^6$ and $R^7$ have a bulky structure, resulting in a decrease in reactivity with oxygen.

Among the ester groups, an alkoxycarbonyl group having 2 to 7 carbon atoms is preferred, and an alkoxycarbonyl group having 2 to 3 carbon atoms is more preferred. In this case, due to the molecular weight of complex (I) being relatively low, the concentration of the colorant can be reduced.

Preferred examples of the complex (I) include a dipyrromethene cobalt complex having a structure represented by the following formula (I-1) and satisfying the above-mentioned thermal properties (1) and (2) (hereinafter, also referred to as a "complex (I-1)"). The complex (I-1) tends to have further improved light fastness. Further, it has a relatively low molecular weight, and the concentration of the colorant can be reduced.

[Chem. 38]

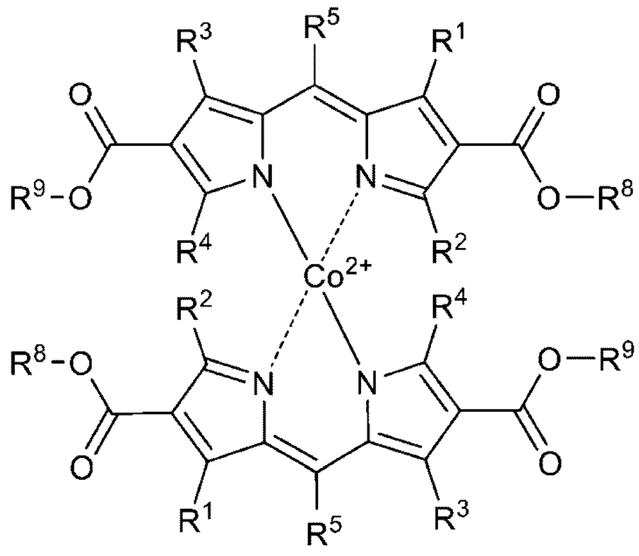

(I-1)

In the formula, $R^1$ to $R^5$ are as described in the first embodiment and the present embodiment, and preferred embodiments are also the same.

In formula (I-1), it is preferred that $R^1$ to $R^4$ are alkyl groups, and a sum of carbon numbers of $R^1$ and $R^2$ is 3 or greater and a sum of carbon numbers of $R^3$ and $R^4$ is 3 or greater.

$R^5$ is preferably a hydrogen atom.

$R^8$ and $R^9$ are each independently an alkyl group having 1 to 6 carbon atoms. $R^8$ and $R^9$ are each independently a methyl group or an ethyl group.

It is preferred that the complex (I-1) further satisfies the aforementioned thermal properties (3).

According to the present embodiment, an optical film that can selectively and efficiently absorb light having a wavelength of around 500 nm and have excellent light fastness can be provided.

<Third Embodiment>

An optical film of the present embodiment is the same as that of the first embodiment except that the first colorant is different from that of the first embodiment. Therefore, description of the same parts as those in the first embodiment will be omitted. The description of the first embodiment can be applied to configurations, elements, forms, and the like which are not described in the present embodiment, and the description of the first embodiment can be combined with the present embodiment.

An optical film in the present embodiment may have an example structure shown in Fig. 1. The optical film 1 in the present embodiment has the full width at half maximum of the absorption peak of 30 nm or less, preferably 28 nm or less, and more preferably 25 nm or less. When the full width at half maximum of the absorption peak of the optical film 1 is less than or equal to the upper limit, the luminous efficiency can be further improved. The lower limit of the full width at half maximum of the absorption peak of the optical film 1 is not particularly limited, but may be, for example, 10 nm.

The following description will be given of the configuration of the optical film 1 different from that of the first embodiment.

<Dye (A)>

The dye (A) contains a colorant (hereinafter, also referred to as a "first colorant") having a wavelength of maximum absorption of 489 nm to 500 nm and a full width at half maximum of the absorption peak of 22 nm or less in acetone solution with a concentration of $5.0\times10^{-6}$ M.

When the wavelength of maximum absorption of the first colorant in acetone solution with a concentration of $5.0\times10^{-6}$ M is greater than or equal to the lower limit, the luminance of blue light emission is less likely to decrease. When the wavelength of maximum absorption of the first colorant in acetone solution with a concentration of $5.0\times10^{-6}$ M is less than or equal to the upper limit, the luminance of green light emission is less likely to decrease. Therefore, by controlling the absorption wavelength and absorption intensity, both color purity and luminous efficiency can be easily achieved.

The concentration of the acetone solution refers to the concentration of the dipyrromethene cobalt complex,

which will be described later.

The full width at half maximum of the absorption peak of the first colorant in acetone solution with a concentration of $5.0\times10^{-6}$ M is 22 nm or less, preferably 20 nm or less, and more preferably 18 nm or less. When the full width at half maximum of the absorption peak in acetone solution with a concentration of $5.0\times10^{-6}$ M is less than or equal to the upper limit, the color purity can be further improved. The lower limit of the full width at half maximum of the absorption peak in acetone solution with a concentration of $5.0\times10^{-6}$ M is not particularly limited, but may be, for example, 5 nm.

The concentration of the acetone solution refers to the concentration of the dipyrromethene cobalt complex, which will be described later.

The first colorant contains a specific dipyrromethene cobalt complex (hereinafter, also referred to as "complex (I)").

The complex (I) has a structure represented by the following formula (I).

[Chem. 39]

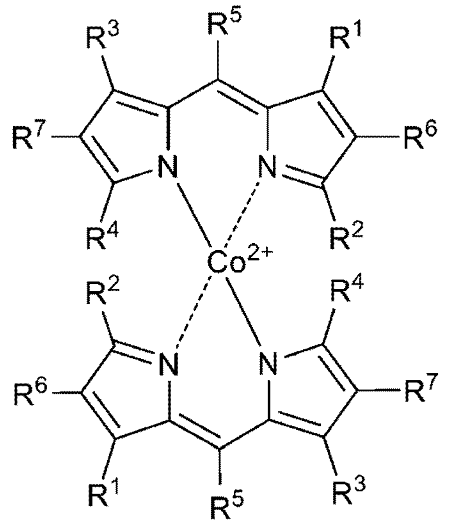

(I)

$R^1$ to $R^7$ in formula (I) are the same as $R^1$ to $R^7$ described in the first embodiment.

In the complex (I), $R^1$ to $R^7$ are preferably combined such that a free energy change between before and after the reaction (hereinafter, also referred to as "$\Delta G$"), calculated by applying $R^1$ to $R^7$ in formula (I) to the following reaction formula (II), is -1.0 kcal/mol or greater.

[Chem. 40]

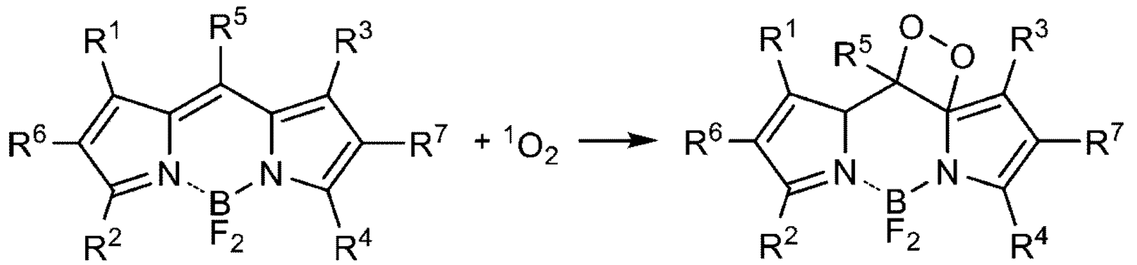

(II)

$R^1$ to $R^7$ in reaction formula (II) each represent the same monovalent groups as $R^1$ to $R^7$ in formula (I).

Reaction formula (II) is a reaction formula of boron dipyrromethene represented by the following formula (III) with singlet oxygen. The $\Delta G$ between before and after the reaction of boron dipyrromethene with singlet oxygen correlates with the $\Delta G$ between before and after the reaction of complex (I) with singlet oxygen. By calculating $\Delta G$ using boron dipyrromethene having the same substituents as $R^1$ to $R^7$ in complex (I) as an alternative structure, $\Delta G$ can be calculated in a shorter time than when calculating using the structure of the dipyrromethene cobalt complex itself, which has a large number of electrons and requires a greater calculation load.

[Chem. 41]

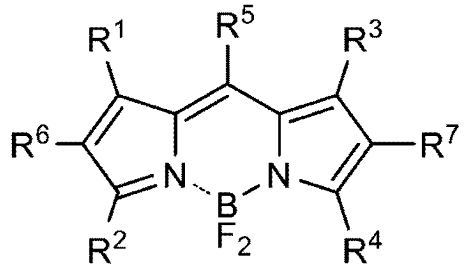

(III)

ΔG is a value calculated using the quantum chemical calculation program Gaussian 16 with the calculation method B3LYP and the basis function 6-31G (d,p) (however, the basis function LanL2DZ is assigned to elements having an atomic number greater than that of Kr in the periodic table). More specifically, ΔG is calculated, using the quantum chemical calculation program Gaussian 16 with the calculation method B3LYP and the basis function 6-31G (d,p) (however, the basis function LanL2DZ is assigned to elements in which $R^5$ in formula (I) has an atomic number greater than that of Kr), by subtracting a sum of the free energy value obtained as a result of structural optimization calculation and vibration calculation of boron dipyrromethene represented by the following formula (III) and the free energy value obtained as a result of structural optimization calculation and vibration calculation of singlet oxygen from the free energy value obtained as a result of structural optimization calculation and vibration calculation of the right side of reaction formula (II).

ΔG differs depending on the groups or atoms $R^1$ to $R^7$ in formula (II). Therefore, $R^1$ to $R^7$ in formula (II) are selected such that ΔG is -1.0 kcal/mol or greater.

When ΔG is -1.0 kcal/mol or greater, the dipyrromethene cobalt complex has excellent light fastness, and a colored layer and an optical film containing the dipyrromethene cobalt complex also have excellent light fastness.

ΔG is preferably 0.0 kcal/mol or greater, and more preferably 0.3 kcal/mol or greater. Larger ΔG is preferred, and the upper limit is not particularly limited.

A preferred example of complex (I) is a dipyrromethene cobalt complex having a structure represented by the following formula (I-1), and the acetone solution (solution obtained by dissolving the complex (I) in acetone) with a concentration of $5.0 \times 10^{-6}$ M has a molar absorption coefficient of 190,000 L/(mol·cm) or greater. Such a dipyrromethene cobalt complex has excellent light fastness. Further, it has a relatively low molecular weight, and the concentration of the dye (A) can be reduced.

[Chem. 42]

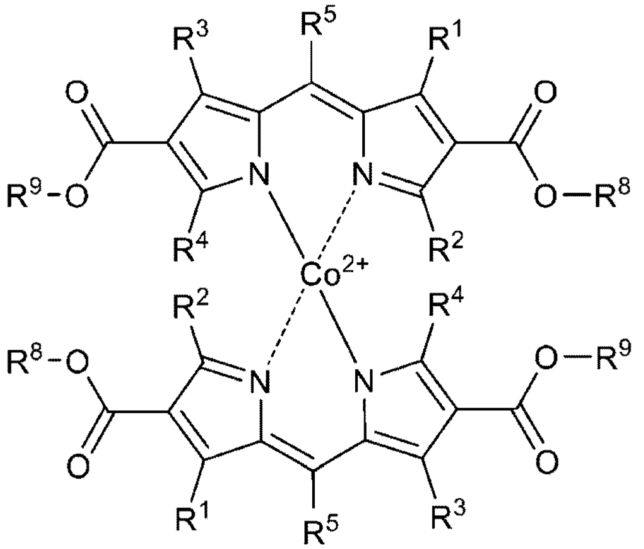

(I-1)

The content of the first colorant in the dye (A) may be, for example, preferably 10 to 100 mass% relative to the total mass of the dye (A). When the content of the first colorant in the dye (A) is within the above numerical range, the light fastness of the optical film 1 can be further improved.

The dye (A) may further contain a second colorant having a wavelength of maximum absorption in the range of 560 nm to 620 nm in acetone solution with a concentration of $5.0 \times 10^{-6}$ M. Containing the second colorant in the dye (A) can

further improve the color purity.

The full width at half maximum of the absorption peak of the second colorant in acetone solution with a concentration of $5.0\times10^{-6}$ M is preferably 15 nm to 55 nm.

Examples of the second colorant include phthalocyanine dyes and porphyrin dyes.

In the dye (A) containing the second colorant, the content of the second colorant in the dye (A) may be, for example, preferably 10 to 60 mass% relative to the total mass of the dye (A). When the content of the second colorant in the dye (A) is within the above numerical range, the color purity can be further improved.

The dye (A) may further contain another colorant other than the first and second colorants.

Examples of another colorant include a third colorant whose lowest transmittance in the wavelength range of 380 nm to 780 nm is in the range of 650 nm to 780 nm. Containing the third colorant further in the dye (A) can minimize a decrease in luminous efficiency and further improve the color purity.

Examples of the third colorant include squarylium dyes and phthalocyanine dyes.

In the dye (A) containing the third colorant, the content of the third colorant in the dye (A) may be, for example, preferably 10 to 60 mass% relative to the total mass of the dye (A). When the content of the third colorant in the dye (A) is within the above numerical range, the color purity can be further improved.

The optical film of the present embodiment includes the colored layer containing a colorant having a wavelength of maximum absorption of 489 nm to 500 nm and a full width at half maximum of the absorption peak of 22 nm or less in acetone solution with a concentration of $5.0\times10^{-6}$ M. Therefore, it can selectively and efficiently absorb light having a wavelength of around 500 nm. As a result, even when the optical film has a small thickness or low colorant concentration, it can sufficiently absorb light having a wavelength of around 500 nm.

Therefore, according to the optical film of the present embodiment, it is possible for the display device to achieve low reflectance, high luminance, reduced film thickness and improved color reproducibility. Further, the optical film of the present invention also has excellent light fastness.

[Method of Producing Optical Film]

The optical film 1 of the first to third embodiments can be produced by a conventionally known method.

For example, a colored layer 10 is obtained by applying a composition for forming a colored layer to one surface of the transparent substrate 20, drying it (removing a solvent (E)) as necessary, and curing the composition for forming a colored layer by irradiating it with ionizing radiation.

Any light source that generates ionizing radiation can be used as a light source for curing the composition for forming a colored layer by irradiating it with ionizing radiation to form the colored layer 10. As the ionizing radiation, optical energy radiation such as radiation (e.g., gamma rays and X-rays), ultraviolet light, visible light or electron beams (EB) can be used. Usually, ultraviolet light or electron beams are used. Examples of lamps emitting ultraviolet light include low-pressure mercury vapor lamps, medium-pressure mercury vapor lamps, high-pressure mercury vapor lamps, carbon arc lamps, metal halide lamps, xenon lamps and electrodeless lamps. Regarding the irradiation conditions, the UV irradiation dose is typically 100 to 1,000 $mJ/cm^2$.

Next, a hard coat agent is applied to the other surface of the transparent substrate 20. As with the colored layer 10, the applied hard coat agent is cured by irradiating it with ionizing radiation, thereby obtaining a hard coat layer 32.

A low refractive index layer 31 is formed on the hard coat layer 32, whereby an optical film 1 having a functional layer 30 on the other surface of the transparent substrate 20 can be obtained.

The method of forming the low refractive index layer 31 is not particularly limited, and examples thereof include applying a composition for forming a low refractive index layer to the hard coat layer 32 and irradiating it with ionizing radiation for curing, vacuum evaporation, sputtering, ion plating, an ion beam method, or plasma-enhanced chemical vapor deposition.

[Other Embodiments]

As shown in Fig. 2, the optical film may be an optical film 2 in which the transparent substrate 20 is located on one surface of the colored layer 10, and the colored layer 10, the transparent substrate 20, the oxygen barrier layer 33, the hard coat layer 32 and the low refractive index layer 31 are laminated in this order. In the optical film 2, the oxygen barrier layer 33, the hard coat layer 32 and the low refractive index layer 31 constitute the functional layer 30. The oxygen barrier layer 33 may be a layer similar to the oxygen barrier layer described above. In this case, it is preferred that the functional layer 30 and the transparent substrate 20 have ultraviolet shielding properties with an ultraviolet shielding rate of 85% or higher.

Since the optical film 2 of the present embodiment has the oxygen barrier layer 33, it exhibits better oxygen barrier performance than the optical film 1.

As shown in Fig. 3, the optical film may be an optical film 3 in which the transparent substrate 20 is located on one surface of the colored layer 10, and the colored layer 10, the transparent substrate 20 and the antiglare layer 34 are

laminated in this order. In the optical film 3, the antiglare layer 34 constitutes the functional layer 30. The antiglare layer 34 may be a layer similar to the antiglare layer described above. In this case, it is preferred that the functional layer 30 and the transparent substrate 20 have ultraviolet shielding properties with an ultraviolet shielding rate of 85% or higher.

Since the optical film 3 of the present embodiment has the antiglare layer 34, it has improved display quality.

As shown in Fig. 4, the optical film may be an optical film 4 in which the transparent substrate 20 is located on one surface of the colored layer 10, and the colored layer 10, the transparent substrate 20, the antiglare layer 34 and the low refractive index layer 31 are laminated in this order. In the optical film 4, the antiglare layer 34 and the low refractive index layer 31 constitute the functional layer 30. In this case, it is preferred that the functional layer 30 and the transparent substrate 20 have ultraviolet shielding properties with an ultraviolet shielding rate of 85% or higher.

Since the optical film 4 of the present embodiment has the low refractive index layer 31 and the antiglare layer 34, it has improved display quality.

As shown in Fig. 5, the optical film may be an optical film 5 in which the transparent substrate 20 is located on one surface of the colored layer 10, and the functional layer 30 is located on the other surface of the colored layer 10. In the optical film 5, the transparent substrate 20, the colored layer 10, the hard coat layer 32 and the low refractive index layer 31 are laminated in this order. In the optical film 5, the hard coat layer 32 and the low refractive index layer 31 constitute the functional layer 30. In this case, it is preferred that the functional layer 30 has ultraviolet shielding properties with an ultraviolet shielding rate of 85% or higher.

Since the optical film 5 of the present embodiment has the colored layer 10 and the functional layer 30 on one surface of the transparent substrate 20, it has improved display quality.

As shown in Fig. 6, the optical film may be an optical film 6 in which the transparent substrate 20 is located on one surface of the colored layer 10, and the functional layer 30 is located on the other surface of the colored layer 10. In the optical film 6, the transparent substrate 20, the colored layer 10, the oxygen barrier layer 33, the hard coat layer 32 and the low refractive index layer 31 are laminated in this order. In the optical film 6, the oxygen barrier layer 33, the hard coat layer 32 and the low refractive index layer 31 constitute the functional layer 30. In this case, it is preferred that the functional layer 30 has ultraviolet shielding properties with an ultraviolet shielding rate of 85% or higher.

Since the optical film 6 of the present embodiment has the oxygen barrier layer 33, it exhibits better oxygen barrier performance than the optical film 5.

As shown in Fig. 7, the optical film may be an optical film 7 in which the transparent substrate 20 is located on one surface of the colored layer 10, and the functional layer 30 is located on the other surface of the colored layer 10. In the optical film 7, the transparent substrate 20, the colored layer 10 and the antiglare layer 34 are laminated in this order. In the optical film 7, the antiglare layer 34 constitutes the functional layer 30. In this case, it is preferred that the functional layer 30 has ultraviolet shielding properties with an ultraviolet shielding rate of 85% or higher.

Since the optical film 7 of the present embodiment has the antiglare layer 34, it has improved display quality.

As shown in Fig. 8, the optical film may be an optical film 8 in which the transparent substrate 20 is located on one surface of the colored layer 10, and the functional layer 30 is located on the other surface of the colored layer 10. In the optical film 8, the transparent substrate 20, the colored layer 10, the antiglare layer 34 and the low refractive index layer 31 are laminated in this order. In the optical film 8, the antiglare layer 34 and the low refractive index layer 31 constitute the functional layer 30. In this case, it is preferred that the functional layer 30 has ultraviolet shielding properties with an ultraviolet shielding rate of 85% or higher.

Since the optical film 8 of the present embodiment has the low refractive index layer 31 and the antiglare layer 34, it has improved display quality.

Although some embodiments of the optical film of the present invention have been described in detail with reference to the drawings, specific configurations are not limited to these embodiments. Various modifications and combinations of the configurations can be made without departing from the spirit of the present invention.

For example, although the optical film of the above embodiments has one colored layer 10, there may be two or more colored layers.

In the optical film of the above embodiments, the ultraviolet light absorption capability may be imparted to the transparent substrate 20 or to the functional layer 30 such as the hard coat layer 32.

The optical film of the present invention can selectively and efficiently absorb light having a wavelength of around 500 nm. As a result, even when the optical film has a small thickness or low colorant concentration, it can sufficiently absorb light having a wavelength of around 500 nm. Therefore, according to the optical film of the present invention, it is possible for the display device to achieve low reflectance, high luminance, reduced film thickness and improved color reproducibility. Further, the optical film of the present invention also has excellent light fastness.

[Display Device]

The display device of the present invention has the optical film of the present invention.

Specific examples of the display device include television, monitors, mobile phones, portable game machines,

portable information terminals, personal computers, electronic books, video cameras, digital still cameras, head mounted displays, navigation systems, sound reproduction devices (car audio systems, digital audio players, and the like), copiers, facsimiles, printers, multifunction printers, vending machines, automated teller machines (ATMs), personal identification devices, optical communication devices and IC cards. In particular, display devices having self-emissive elements such as LEDs, organic ELs, inorganic phosphors and quantum dots are suitable since they are susceptible to the effects of external light reflection due to metal electrodes and wiring, and thus the present invention is highly useful.

Examples

The present invention will be described in more detail below with reference to examples. However, the present invention should not be construed as being limited to the following examples. The term "parts" indicates "parts by mass."

[Materials Used]

<Photopolymerizable Compound (B)>

UA-306H: Pentaerythritol triacrylate hexamethylene diisocyanate urethane prepolymer (UA-306H manufactured by Kyoeisha Chemical Co., Ltd.).
DPHA: Dipentaerythritol hexaacrylate.
PETA: Pentaerythritol triacrylate.

<Photopolymerization Initiator (C)>

Omnirad TPO: Acyl phosphine oxide photopolymerization initiator (manufactured by IGM Resins B.V.).

<Non-Polymerizable Additive (D)>

Tinuvin 249: Radical scavenger, hindered amine photostabilizer (HALS) (manufactured by BASF Japan Ltd., molecular weight 482).
D1781: Singlet oxygen quencher, nickel(II) bis(dibutyldithiocarbamate), product code D1781 (manufactured by Tokyo Chemical Industry Co., Ltd.).

<Solvent (E)>

MEK: Methyl ethyl ketone.
Methyl acetate: Methyl acetate.

[Examples 1A to 18A, Comparative Examples 1A to 12A]

(Synthesis of Dipyrromethene Cobalt Complex)

The dipyrromethene cobalt complexes (compounds 1 to 18 and 1' to 12') shown in Tables 1-1 and 1-2 were synthesized by the following procedure.

In Tables 1-1 and 1-2, Me represents a methyl group, Et represents an ethyl group, Pr represents a propyl group, $^{n}$Bu represents an n-butyl group, $^{t}$Bu represents a t-butyl group, and Ph represents a phenyl group.

<Synthesis of Compound 1>

[Synthesis of 3,3',5,5'-tetramethyl-4,4'-di-ethoxycarbonyl-2,2'-dipyrromethene hydrobromide]

After placing ethyl 5-formyl-2,4-dimethyl-1H-pyrrole-3-carboxylate (2.5 g) in a reaction vessel to dissolve it in methanol (50 mL), 47% hydrobromic acid (45 g) was added, and the mixture was refluxed for 1 hour. By filtering the

precipitated solid, 3,3',5,5'-tetramethyl-4,4'-di-ethoxycarbonyl-2,2'-dipyrromethene hydrobromide (2.6 g) was obtained.

[Synthesis of Compound 1]

After placing 3,3',5,5'-tetramethyl-4,4'-di-ethoxycarbonyl-2,2'-dipyrromethene hydrobromide (0.6 g) in a reaction vessel, methanol (5 mL), triethylamine (0.17 g) and cobalt acetate tetrahydrate (0.18 g) were added, and the mixture was refluxed for 2 hours. By filtering the precipitated solid, compound 1 (0.42 g) was obtained.

<Synthesis of Compound 2>

[Synthesis of 3,3'-dimethyl-5,5'-di-iodo-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 5-formyl-2-iodo-4-methyl-1H-pyrrole-3-carboxylate.

[Synthesis of Compound 2]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-dimethyl-5,5'-di-iodo-4,4'-di-ethoxycarbonyl-2,2'-dipyrromethene hydrobromide.

<Synthesis of Compound 3>

[Synthesis of 3,3'-dimethyl-5,5'-di-bromo-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 2-bromo-5-formyl-4-methyl-1H-pyrrole-3-carboxylate.

[Synthesis of Compound 3]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-dimethyl-5,5'-di-bromo-4,4'-di-ethoxycarbonyl-2,2'-dipyrromethene hydrobromide.

<Synthesis of Compound 4>

[Synthesis of 3,3'-dimethyl-5,5'-di-chloro-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 2-chloro-5-formyl-4-methyl-1H-pyrrole-3-carboxylate.

[Synthesis of Compound 4]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-dimethyl-5,5'-di-chloro-4,4'-di-ethoxycarbonyl-2,2'-dipyrromethene hydrobromide.

<Synthesis of Compound 5>

[Synthesis of 5,5'-di-methyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 5-formyl-2-methyl-1H-pyrrole-3-carboxylate.

[Synthesis of Compound 5]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 5,5'-di-methyl-4,4'-di-ethoxycarbonyl-2,2'-dipyrromethene hydrobromide.

<Synthesis of Compound 6>

[Synthesis of 3,3'-di-chloro-5,5'-di-methyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 4-chloro-5-formyl-2-methyl-1H-pyrrole-3-carboxylate.

[Synthesis of Compound 6]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-chloro-5,5'-di-methyl-4,4'-di-ethoxycarbonyl-2,2'-dipyrromethene hydrobromide.

<Synthesis of Compound 7>

[Synthesis of 3,3'-di-iodo-5,5'-di-methyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 5-formyl-4-iodo-2-methyl-1H-pyrrole-3-carboxylate.

[Synthesis of Compound 7]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-iodo-5,5'-di-methyl-4,4'-di-ethoxycarbonyl-2,2'-dipyrromethene hydrobromide.

<Synthesis of Compound 8>

[Synthesis of 3,3'-di-bromo-5,5'-di-methyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 4-bromo-5-formyl-2-methyl-1H-pyrrole-3-carboxylate.

[Synthesis of Compound 8]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-bromo-5,5'-di-methyl-4,4'-di-ethoxycarbonyl-2,2'-dipyrromethene hydrobromide.

<Synthesis of Compound 9>

[Synthesis of 3,3',5,5'-tetramethyl-4,4'-bis(2,2-dimethylpropoxycarbonyl)-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with 2,2-dimethylpropyl 5-formyl-2,4-dimethyl-1H-pyrrole-3-carboxylate.

[Synthesis of Compound 9]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3',5,5'-tetramethyl-4,4'-bis(2,2-dimethylpropoxycarbonyl)-2,2'-dipyrromethene hydrobromide.

<Synthesis of Compound 10>

[Synthesis of 3,3',5,5'-tetramethyl-4,4'-di-methoxy carbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with methyl 5-formyl-2,4-dimethyl-1H-pyrrole-3-carboxylate.

[Synthesis of Compound 10]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3',5,5'-tetramethyl-4,4'-di-methoxy carbonyl-2,2'-dipyrromethene hydrobromide.

<Synthesis of Compound 11>

[Synthesis of 4,4'-di-ethoxycarbonyl-2,2'-dipyrromethene hydrobromide] The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 5-formyl-1H-pyrrole-3-carboxylate.

[Synthesis of Compound 11]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 4,4'-di-ethoxycarbonyl-2,2'-dipyrromethene hydrobromide.

<Synthesis of Compound 12>

[Synthesis of 5,5'-di-methyl-4,4'-di-methoxy carbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with methyl 5-formyl-2-methyl-1H-pyrrole-3-carboxylate.

[Synthesis of Compound 12]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 5,5'-di-methyl-4,4'-di-methoxy carbonyl-2,2'-dipyrromethene hydrobromide.

<Synthesis of Compound 13>

[Synthesis of 3,3'-di-butyl-5,5'-di-ethyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 4-butyl-2-ethyl-5-formyl-1H-pyrrole-3-carboxylate.

[Synthesis of Compound 13]

The synthesis was performed in the same manner as in the above [Synthesis of Compound 1] except that

3,3',5,5'-tetramethyl-4,4'-di-ethoxycarbonyl-2,2'-dipyrromethene hydrobromide was replaced with 3,3'-di-butyl-5,5'-di-ethyl-4,4'-di-ethoxycarbonyl-2,2'-dipyrromethene hydrobromide.

<Synthesis of Compound 14>

[Synthesis of 3,3'-di-butyl-5,5'-di-ethyl-4,4'-di-methoxy carbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with methyl 4-butyl-2-ethyl-5-formyl-1H-pyrrole-3-carboxylate.

[Synthesis of Compound 14]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-butyl-5,5'-di-ethyl-4,4'-di-methoxy carbonyl-2,2'-dipyrromethene hydrobromide.

<Synthesis of Compound 15>

[Synthesis of 3,3'-di-butyl-5,5'-di-methyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 4-butyl-2-methyl-5-formyl-1H-pyrrole-3-carboxylate.

[Synthesis of Compound 15]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-butyl-5,5'-di-methyl-4,4'-di-ethoxycarbonyl-2,2'-dipyrromethene hydrobromide.

<Synthesis of Compound 16>

[Synthesis of 3,3'-di-propyl-5,5'-di-methyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 4-propyl-2-methyl-5-formyl-1H-pyrrole-3-carboxylate.

[Synthesis of Compound 16]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-propyl-5,5'-di-methyl-4,4'-di-ethoxycarbonyl-2,2'-dipyrromethene hydrobromide.

<Synthesis of Compound 17>

[Synthesis of 3,3'-di-butyl-5,5'-di-methyl-4,4'-di-methoxy carbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with methyl 4-butyl-2-methyl-5-formyl-1H-pyrrole-3-carboxylate.

[Synthesis of Compound 17]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-butyl-5,5'-di-methyl-4,4'-di-methoxy carbonyl-2,2'-dipyrromethene hydrobromide.

<Synthesis of Compound 18>

[Synthesis of 3,3'-di-ethyl-5,5'-di-methyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 4-ethyl-2-methyl-5-formyl-1H-pyrrole-3-carboxylate.

[Synthesis of Compound 18]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-ethyl-5,5'-di-methyl-4,4'-di-ethoxycarbonyl-2,2'-dipyrromethene hydrobromide.

<Synthesis of Compound 1'>

[Synthesis of 4,4'-di-ethyl-3,3',5,5'-tetramethyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with 3-ethyl-5-formyl-2,4-dimethyl-1H-pyrrole.

[Synthesis of Compound 1']

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 4,4'-di-ethyl-3,3',5,5'-tetramethyl-2,2'-dipyrromethene hydrobromide.

<Synthesis of Compound 2'>

After placing p-bromobenzaldehyde (0.27 g), ethyl 2,4-dimethylpyrrole-3-carboxylate (0.50 g), dichloromethane (93 mL) and trifluoroacetic acid (0.1 mL) in a reaction vessel, the mixture was refluxed for 3 hours. 2,3-dichloro-5,6-dicyano-p-benzoquinone (0.33 g) was added to the resultant solution, and the mixture was stirred at room temperature for 2 hours. Then, after placing triethylamine (3.0 mL) and cobalt(II) acetate tetrahydrate (0.18 g), the mixture was refluxed for 2 hours. After diluting with dichloromethane, the mixture was washed with pure water, and the remaining organic layer was dried with anhydrous magnesium sulfate. After filtration and concentration, methanol was poured to precipitate a powder, which was then collected by suction filtration to thereby obtain a compound 2' (0.42 g).

<Synthesis of Compound 3'>

The synthesis was performed in the same manner as in the above <Synthesis of Compound 2'> except that p-bromobenzaldehyde was replaced with m-cyanobenzaldehyde.

<Synthesis of Compound 4'>

The synthesis was performed in the same manner as in the above <Synthesis of Compound 2'> except that p-bromobenzaldehyde was replaced with p-nitrobenzaldehyde.

<Synthesis of Compound 5'>

The synthesis was performed in the same manner as in the above <Synthesis of Compound 2'> except that p-bromobenzaldehyde was replaced with p-iodobenzaldehyde, and that ethyl 2,4-dimethylpyrrole-3-carboxylate was replaced with 3-ethyl-2,4-dimethylpyrrole.

<Synthesis of Compound 6'>

The synthesis was performed in the same manner as in the above <Synthesis of Compound 2'> except that p-bromobenzaldehyde was replaced with p-iodobenzaldehyde.

<Synthesis of Compound 7'>

The synthesis was performed in the same manner as in the above <Synthesis of Compound 2'> except that p-bromobenzaldehyde was replaced with benzaldehyde.

<Synthesis of Compound 8'>

The synthesis was performed in the same manner as in the above <Synthesis of Compound 2'> except that p-bromobenzaldehyde was replaced with p-cyanobenzaldehyde.

<Synthesis of Compound 9'>

The synthesis was performed in the same manner as in the above <Synthesis of Compound 2'> except that p-bromobenzaldehyde was replaced with m-iodobenzaldehyde.

<Synthesis of Compound 10'>

The synthesis was performed in the same manner as in the above <Synthesis of Compound 2'> except that p-bromobenzaldehyde was replaced with acetaldehyde and that ethyl 2,4-dimethylpyrrole-3-carboxylate was replaced with 3-ethyl-2,4-dimethylpyrrole.

<Synthesis of Compound 11'>

The synthesis was performed in the same manner as in the above <Synthesis of Compound 2'> except that p-bromobenzaldehyde was replaced with benzaldehyde and that ethyl 2,4-dimethylpyrrole-3-carboxylate was replaced with n-butyl 2,4-dimethylpyrrole-3-carboxylate.

<Synthesis of Compound 12'>

[Synthesis of 3,3'-di-methyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with 5-formyl-4-methyl-1H-pyrrole.

[Synthesis of Compound 12']

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-methyl-4,4'-di-ethoxycarbonyl-2,2'-dipyrromethene hydrobromide.

[Preparation of Coating Liquid]

The resulting dipyrromethene cobalt complex was dissolved in a mixed solvent of MEK/methyl acetate = 50/50 (mass ratio). The resulting solution, UA-306H, DPHA and PETA (UA-306H/DPHA/PETA = 70/20/10 (mass ratio)) as the photopolymerizable compounds (B), Omnirad TPO as the photopolymerization initiator (C), and Tinuvin249 and D1781 (Tinuvin249/D1781 = 70/30 (mass ratio)) as the non-polymerizable additives (D) were mixed to prepare a coating liquid (composition for forming a colored layer) having the following composition.

Dipyrromethene cobalt complex: 0.4 mass% relative to the solid content of the coating liquid.
Photopolymerizable compound (B): 94 mass% relative to the solid content of the coating liquid.
Photopolymerization initiator (C): 3 mass% relative to the solid content of the coating liquid.
Non-polymerizable additive (D): 2.6 mass% relative to the solid content of the coating liquid.
Solvent (E): 70 mass% relative to the total mass of the coating liquid.

(Formation of Coating Film)

The coating liquid was spin coated on a glass substrate and dried in an oven at 80°C for 60 seconds. Then, the

coating film was cured by irradiating it with ultraviolet light at an irradiation dose of 150 mJ/cm$^2$ using an ultraviolet irradiation device (a light source, H-bulb, manufactured by Fusion UV Systems Japan) to form a coating film (cured film) having a cured thickness of 5.0 $\mu$m.

(Preparation of Evaluation Substrate)

An 80% polyvinyl alcohol aqueous solution (PVA117, manufactured by Kuraray Co., Ltd.) was applied to the cured film, and dried to form an oxygen barrier layer. Further, a triacetylcellulose film (TG60UL, manufactured by FUJIFILM Corporation, substrate thickness 60 $\mu$m) was adhered to the oxygen barrier layer to prepare an evaluation substrate.

(Evaluations)

<Free Energy Change ($\Delta$G) Between Before and After Reaction>

For boron dipyrromethene having the same substituents as the dipyrromethene cobalt complex of each example, $\Delta$G was calculated by the following procedure using the quantum chemical calculation program Gaussian 16 with the calculation method B3LYP and the basis function 6-31G (d,p) (however, the basis function LanL2DZ was assigned to elements having an atomic number greater than that of Kr in the periodic table). Table 2 shows the results.

(1) Structural optimization calculation and vibration calculation of boron dipyrromethene having the same substituents as the dipyrromethene cobalt complex of each example were performed, and a free energy value $G_{Co}$ of the boron dipyrromethene was obtained from the result of the vibration calculation.
(2) Structural optimization calculation and vibration calculation of singlet oxygen was performed, and a free energy value $G_{O2}$ of the singlet oxygen was obtained from the result of the vibration calculation.
(3) Structural optimization and vibration calculation of the structure in which oxygen was added to the meso position of the boron dipyrromethene structure (structure of the right side of reaction formula (II)) were performed, and a free energy value $G_{Co+O2}$ of the oxygen adduct of the boron dipyrromethene was obtained from the result of the vibration calculation.
(4) $\Delta$G was calculated by the following formula.

$$\Delta G = G_{Co+O2} - (G_{Co} + G_{O2})$$

<Molar Absorption Coefficient ($\varepsilon$) of Acetone Solution>

Three acetone solutions of the dipyrromethene cobalt complex having different concentrations were prepared, and the absorption spectra were measured using an ultraviolet-visible spectrophotometer (manufactured by Hitachi, Ltd., U-4100). The slope of the approximate line obtained by plotting the absorbance at the wavelength of maximum absorption in the wavelength range of 470 nm to 530 nm against each concentration was determined as $\varepsilon$. Table 2 shows the results.

<Wavelength of Maximum Absorption ($\lambda_{max}$) of Acetone Solution>

Acetone solutions of the dipyrromethene cobalt complex were prepared, and the absorption spectra were measured using an ultraviolet-visible spectrophotometer (manufactured by Hitachi, Ltd., U-4100). The wavelength at which the absorbance was maximum in the wavelength range of 470 nm to 530 nm was determined as $\lambda_{max}$. Table 2 shows the results.

<Wavelength of Maximum Absorption ($\lambda_{max}$) of Coating Film>

The absorption spectra of the coating films were measured using an ultraviolet-visible spectrophotometer (manufactured by Hitachi, Ltd., U-4100), and the wavelength at which the absorbance was maximum in the wavelength range of 470 nm to 530 nm was determined as $\lambda_{max}$. Table 2 shows the results.

<Full Width at Half Maximum of Coating Film>

The absorption spectra of the coating films were measured using an ultraviolet-visible spectrophotometer (manufactured by Hitachi, Ltd., U-4100), and the full width at half maximum of the peak at which the absorbance was maximum in the wavelength range of 470 nm to 530 nm was calculated. Table 2 shows the results.

<Light Fastness>

A test was performed in which a surface of the evaluation substrate on which the coating film was formed was irradiated with light for 120 hours using a xenon weather meter testing machine (manufactured by Suga Test Instruments Co., Ltd., X75) under conditions of a xenon lamp illuminance of 60 W/$cm^2$ (300 nm to 400 nm) at a temperature of 45°C and a humidity (RH) of 50% inside the testing machine. Before and after the test, the transmittance of the evaluation substrate was measured using an ultraviolet-visible spectrophotometer (manufactured by Hitachi, Ltd., U-4100) to calculate a difference in transmittance (ΔT) between before and after the test at the wavelength showing the minimum transmittance before the test in the wavelength range of 470 nm to 530 nm. The light fastness was evaluated according to the following evaluation criteria. Table 2 shows the results.

A: ΔT is less than 10%.
B: ΔT is 10% or greater and less than 15%.
C: ΔT is 15% or greater.

<Dye Concentration>

In Examples 1, 5, 10, 12 and Comparative Example 11, cured films having different concentrations (mass%) of dipyrromethene cobalt complex due to different contents of dipyrromethene cobalt complex relative to the solid content of the coating liquid were formed, and the transmittance was measured using an ultraviolet-visible spectrophotometer (manufactured by Hitachi, Ltd., U-4100). The concentration (mass%) of dipyrromethene metal complex in the cured film when the transmittance was 40% at the film thickness of 5.0 μm was determined, and evaluation was performed according to the following criteria. Table 3 shows the results.

A: Concentration less than 0.4%.
B: Concentration 0.4% or greater.

<Miscibility>

The coating films formed in Examples 1, 5, 10, 12 and Comparative Example 11 were observed in visual inspection to determine whether the dye (dipyrromethene metal complex) was miscible with other components, and evaluated by the following criteria. Table 3 shows the results.

A: Miscible.
B: Not miscible, and phase separation and dye precipitation occurred.

[Table 1-1]

| | | | | Dipyrromethene cobalt complex | | | | | | | |
|---|---|---|---|---|---|---|---|---|---|---|---|
| | | | | Compound name | $R^1$ | $R^2$ | $R^3$ | $R^4$ | $R^5$ | $R^6$ | $R^7$ |
| Example | 1A | 1B | | Compound 1 | Me | Me | Me | Me | H | COOEt | COOEt |
| | 2A | | | Compound 2 | Me | I | Me | I | H | COOEt | COOEt |
| | 3A | | | Compound 3 | Me | Br | Me | Br | H | COOEt | COOEt |
| | 4A | | | Compound 4 | Me | Cl | Me | Cl | H | COOEt | COOEt |
| | 5A | | | Compound 5 | H | Me | H | Me | H | COOEt | COOEt |
| | 6A | | | Compound 6 | Cl | Me | Cl | Me | H | COOEt | COOEt |
| | 7A | | | Compound 7 | I | Me | I | Me | H | COOEt | COOEt |
| | 8A | | | Compound 8 | Br | Me | Br | Me | H | COOEt | COOEt |
| | 9A | 3B | | Compound 9 | Me | Me | Me | Me | H | $COOCH_2{}^tBu$ | $COOCH_2{}^tBu$ |
| | 10A | 2B | | Compound 10 | Me | Me | Me | Me | H | COOMe | COOMe |
| | 11A | 4B | | Compound 11 | H | H | H | H | H | COOEt | COOEt |
| | 12A | | | Compound 12 | H | Me | H | Me | H | COOMe | COOMe |
| | 13A | 11B | 2C | Compound 13 | $^nBu$ | Et | $^nBu$ | Et | H | COOEt | COOEt |
| | 14A | 12B | 1C | Compound 14 | $^nBu$ | Et | $^nBu$ | Et | H | COOMe | COOMe |
| | 15A | 9B | 4C | Compound 15 | $^nBu$ | Me | $^nBu$ | Me | H | COOEt | COOEt |
| | 16A | | | Compound 16 | Pr | Me | Pr | Me | H | COOEt | COOEt |
| | 17A | 10B | 3C | Compound 17 | $^nBu$ | Me | $^nBu$ | Me | H | COOMe | COOMe |
| | 18A | 5B | 12C | Compound 18 | Et | Me | Et | Me | H | COOEt | COOEt |
| | | 6B | | Compound 19 | Me | Et | Me | Et | H | COOEt | COOEt |
| | | 7B | | Compound 20 | Me | Et | Me | Et | H | COOMe | COOMe |
| | | 8B | | Compound 21 | Me | $^nBu$ | Me | $^nBu$ | H | COOEt | COOEt |
| | | 13B | | Compound 22 | Pr | Pr | Pr | Pr | H | COOEt | COOEt |
| | | | 5C | Compound 23 | Et | $^nBu$ | Et | $^nBu$ | H | COOMe | COOMe |
| | | | 6C | Compound 24 | Et | $^nBu$ | Et | $^nBu$ | H | COOEt | COOEt |
| | | | 7C | Compound 25 | Me | $^nBu$ | Me | $^nBu$ | H | COOMe | COOMe |
| | | | 8C | Compound 26 | Me | $^nBu$ | Me | $^nBu$ | H | COOEt | COOEt |
| | | | 9C | Compound 27 | Me | Et | Me | Et | H | COOMe | COOMe |
| | | | 10C | Compound 28 | Et | Me | Et | Me | H | COOMe | COOMe |
| | | | 11C | Compound 29 | Me | Et | Me | Et | H | COOEt | COOEt |

[Table 1-2]

| | | | | Dipyrromethene cobalt complex | | | | | | | |
|---|---|---|---|---|---|---|---|---|---|---|---|
| | | | | Compound name | $R^1$ | $R^2$ | $R^3$ | $R^4$ | $R^5$ | $R^6$ | $R^7$ |
| Comparative example | 1A | 1B | 4C | Compound 1' | Me | Me | Me | Me | H | Et | Et |
| | 2A | 7B | 5C | Compound 2' | Me | Me | Me | Me | p-Br-Ph | COOEt | COOEt |
| | 3A | | 6C | Compound 3' | Me | Me | Me | Me | m-CN-Ph | COOEt | COOEt |
| | 4A | 8B | 7C | Compound 4' | Me | Me | Me | Me | p-$NO_2$-Ph | COOEt | COOEt |
| | 5A | 6B | 8C | Compound 5' | Me | Me | Me | Me | p-I-Ph | Et | Et |
| | 6A | 4B | 9C | Compound 6' | Me | Me | Me | Me | p-I-Ph | COOEt | COOEt |
| | 7A | 3B | 10C | Compound 7' | Me | Me | Me | Me | Ph | COOEt | COOEt |
| | 8A | 9B | | Compound 8' | Me | Me | Me | Me | p-CN-Ph | COOEt | COOEt |
| | 9A | 5B | | Compound 9' | Me | Me | Me | Me | m-I-Ph | COOEt | COOEt |
| | 10A | 2B | 11C | Compound 10' | Me | Me | Me | Me | Me | Et | Et |
| | 11A | | 12C | Compound 11' | Me | Me | Me | Me | Ph | $COO^nBu$ | $COO^nBu$ |
| | 12A | | | Compound 12' | Me | H | Me | H | H | COOEt | COOEt |
| | | | 1C | Compound 13' | Me | Me | Me | Me | H | COOMe | COOMe |
| | | | 2C | Compound 14' | Me | Me | Me | Me | H | COOEt | COOEt |
| | | | 3C | Compound 15' | Me | Me | Me | Me | H | $COOCH_2C(CH_3)_3$ | $COOCH_2C(CH_3)_3$ |

[Table 2]

| | | ΔG [kcal/mol] | ε (acetone solution) [L/(mol·cm)] | $\lambda_{max}$ [nm] | | Full width at half maximum [nm] | Light fastness |
|---|---|---|---|---|---|---|---|
| | | | | Acetone solution | Coating film | | |
| Example | 1A | 0.54 | 222,000 | 488 | 493 | 25 | B |
| | 2A | 2.25 | 195,000 | 492 | 499 | 24 | A |
| | 3A | 0.35 | 190,000 | 490 | 495 | 24 | A |
| | 4A | -0.02 | 191,000 | 488 | 494 | 24 | A |
| | 5A | 2.21 | 210,000 | 490 | 495 | 24 | A |
| | 6A | 2.08 | 210,000 | 498 | 502 | 24 | A |
| | 7A | 2.71 | 203,000 | 506 | 511 | 24 | A |
| | 8A | 1.56 | 199,000 | 500 | 504 | 25 | A |
| | 9A | 0.07 | 175,000 | 488 | 494 | 25 | B |
| | 10A | 0.47 | 199,000 | 488 | 493 | 25 | B |
| | 11A | -0.31 | 178,000 | 483 | 489 | 24 | B |
| | 12A | 2.32 | 192,000 | 490 | 495 | 24 | A |
| | 13A | 0.92 | 234,000 | 493 | 496 | 23 | A |
| | 14A | 1.28 | 238,000 | 493 | 496 | 23 | A |
| | 15A | 1.87 | 238,000 | 492 | 495 | 23 | A |
| | 16A | 2.11 | 213,000 | 491 | 494 | 23 | A |
| | 17A | 2.12 | 240,000 | 492 | 495 | 23 | A |
| | 18A | 1.40 | 228,000 | 491 | 494 | 23 | A |
| Comparative example | 1A | -1.39 | 130,000 | 506 | 510 | 37 | C |
| | 2A | -3.72 | 145,000 | 495 | 500 | 33 | C |
| | 3A | -3.69 | 168,000 | 497 | 503 | 32 | C |
| | 4A | -3.16 | 175,000 | 497 | 499 | 37 | C |
| | 5A | -1.12 | 69,000 | 508 | 512 | 43 | C |
| | 6A | -1.42 | 160,000 | 495 | 501 | 33 | C |
| | 7A | -3.35 | 158,000 | 494 | 496 | 31 | C |
| | 8A | -3.14 | 179,000 | 496 | 502 | 34 | C |
| | 9A | -1.21 | 166,000 | 496 | 502 | 31 | C |
| | 10A | -3.04 | 100,000 | 507 | 511 | 44 | C |
| | 11A | -3.30 | 158,000 | 494 | 496 | 31 | C |

[Table 3]

| | | Dipyrromethene cobalt complex | | | | | | | ε (acetone solution) [L/(mol·cm)] | Dye concentration | Miscibility | Light fastness |
|---|---|---|---|---|---|---|---|---|---|---|---|---|
| | | $R^1$ | $R^2$ | $R^3$ | $R^4$ | $R^5$ | $R^6$ | $R^7$ | | | | |
| Example | 1A | Me | Me | Me | Me | H | COOEt | COOEt | 222,000 | A | A | B |
| | 5A | H | Me | H | Me | H | COOEt | COOEt | 210,000 | A | A | A |
| | 10A | Me | Me | Me | Me | H | COOMe | COOMe | 199,000 | A | A | B |
| | 12A | H | Me | H | Me | H | COOMe | COOMe | 192,000 | A | A | A |
| Comparative example | 12A | Me | Me | Me | Me | Ph | $COO^nBu$ | $COO^nBu$ | 158,000 | B | A | C |

As shown in the above results, the coating films of Examples 1 to 18, which used dipyrromethene cobalt complexes having ΔG of -1.0 kcal/mol or greater, had excellent light fastness. Also, the dipyrromethene cobalt complex had good miscibility with other components. In particular, when an acetone solution of the dipyrromethene cobalt complex had a molar absorption coefficient of 190,000 L/(mol·cm) or greater, the absorption efficiency of light at the wavelength of around 500 nm was high. Reducing the concentration of the dipyrromethene metal complex in the coating film is also advantageous in terms of production costs.

[Examples 1B to 13B and Comparative Examples 1B to 9B]

In Examples 1B to 5B and 9B to 12B, the compounds 1, 10, 9, 11, 18, 15, 17, 13 and 14 were used, respectively, as shown in Table 1-1. In Examples 6B to 8B and 13B, the following compounds 19 to 22 were used, respectively. In Comparative Examples 1B to 9B, the compounds 1', 10', 7', 6', 9', 5', 2', 4' and 8' were used, respectively, as shown in Table 1-2.

<Synthesis of Compound 19>

[Synthesis of 3,3'-di-methyl-5,5'-di-ethyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 4-methyl-2-ethyl-5-formyl-1H-pyrrole-3-carboxylate.

[Synthesis of Compound 19]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-methyl-5,5'-di-ethyl-4,4'-di-ethoxycarbonyl-2,2'-dipyrromethene hydrobromide.

<Synthesis of Compound 20>

[Synthesis of 3,3'-di-methyl-5,5'-di-ethyl-4,4'-di-methoxy carbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with methyl 4-methyl-2-ethyl-5-formyl-1H-pyrrole-3-carboxylate.

[Synthesis of Compound 20]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-methyl-5,5'-di-ethyl-4,4'-di-methoxy carbonyl-2,2'-dipyrromethene hydrobromide.

<Synthesis of Compound 21>

[Synthesis of 3,3'-di-methyl-5,5'-di-butyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 4-methyl-2-butyl-5-formyl-1H-pyrrole-3-carboxylate.

[Synthesis of Compound 21]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-methyl-5,5'-di-butyl-4,4'-di-ethoxycarbonyl-2,2'-dipyrromethene hydrobromide.

<Synthesis of Compound 22>

[Synthesis of 3,3',5,5'-tetraisopropyl-4,4'-di-ethoxycarbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 5-formyl-2,4-diisopropyl-1H-pyrrole-3-carboxylate.

[Synthesis of Compound 22]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3',5,5'-tetraisopropyl-4,4'-di-ethoxycarbonyl-2,2'-dipyrromethene hydrobromide.

Preparation of the coating liquid, formation of the coating film, preparation of the evaluation substrate, evaluation of the wavelength of maximum absorption ($\lambda_{max}$) of the acetone solution, evaluation of the wavelength of maximum absorption ($\lambda_{max}$) of the coating film and evaluation of the weatherability were performed in the same manner as in Example 1A. Table 4 shows the results.

(Evaluations)

<Thermal Properties>

The dipyrromethene cobalt complex of each example was measured using a simultaneous differential thermal and thermogravimetric analyzer (STA7200RV, manufactured by Hitachi High-Tech Science Corporation) at a gas flow rate of 500 mL/min and a temperature increase rate of 10°C/min from 30°C to 530°C. Air or nitrogen was used as the gas. Based on the weight at the start of the temperature increase rate, the 5% weight loss temperature and the 50% weight loss temperature were determined. Further, a difference between the 50% weight loss temperature in air and the 50% weight loss temperature in nitrogen was calculated. Table 4 shows the results.

[Table 4]

| | | $\lambda_{max}$ [nm] | | 5% weight loss temperature (°C) | | 50% weight loss temperature (°C) | | Difference between 50% weight loss temperatures in air and nitrogen (°C) | Light fastness |
|---|---|---|---|---|---|---|---|---|---|
| | | Acetone solution | Coating film | Air | Nitrogen | Air | Nitrogen | | |
| Example | 1B | 488 | 493 | 337.0 | 349.5 | 452.2 | 397.6 | 54.6 | B |
| | 2B | 488 | 493 | 336.1 | 347.3 | 483.2 | 457.2 | 26.0 | B |
| | 3B | 488 | 494 | 346.2 | 374.5 | 441.6 | 410.0 | 31.6 | B |
| | 4B | 483 | 489 | 354.7 | 367.8 | 420.9 | 364.3 | 56.6 | B |
| | 5B | 493 | 496 | 335.4 | 347.8 | 402.6 | 395.5 | 7.1 | A |
| | 6B | 489 | 494 | 335.9 | 348.1 | 403.8 | 396.1 | 7.7 | A |
| | 7B | 489 | 494 | 330.6 | 344.8 | 417.4 | 408.2 | 9.2 | A |
| | 8B | 491 | 494 | 329.7 | 339.1 | 397.8 | 390.3 | 7.5 | A |
| | 9B | 492 | 495 | 330.2 | 340.4 | 392.3 | 390.9 | 1.4 | A |
| | 10B | 492 | 495 | 325.5 | 335.1 | 390.1 | 389.4 | 0.7 | A |
| | 11B | 493 | 496 | 328.5 | 337.8 | 390.3 | 389.2 | 1.1 | A |
| | 12B | 493 | 496 | 322.5 | 329.0 | 394.5 | 387.6 | 6.9 | A |
| | 13B | 494 | 497 | 327.6 | 337.0 | 391.1 | 387.9 | 3.2 | A |
| Comparative example | 1B | 506 | 510 | 281.7 | 280.4 | 447.8 | 335.9 | 111.9 | C |
| | 2B | 507 | 511 | 251.0 | 241.3 | 472.9 | 359.6 | 113.3 | C |
| | 3B | 494 | 496 | 325.9 | 346.5 | 455.8 | 490.6 | 34.8 | C |
| | 4B | 495 | 501 | 324.7 | 339.5 | 423.7 | >530 | >106.3 | C |
| | 5B | 496 | 502 | 314.6 | 323.7 | 447.6 | >530 | >82.4 | C |
| | 6B | 508 | 512 | 282.6 | 257.3 | 508.1 | >530 | >21.9 | C |
| | 7B | 495 | 500 | 291.0 | 302.3 | 499.4 | 492.9 | 6.5 | C |
| | 8B | 497 | 499 | 318.3 | 337.7 | 399.8 | >530 | >130.2 | C |
| | 9B | 496 | 502 | 318.0 | 327.2 | 464.9 | >530 | >65.1 | C |

As shown in the above results, the coating films of Examples 1 to 13, which used dipyrromethene cobalt complexes with the 5% weight loss temperature of 300°C or higher both in air and in nitrogen, and the 50% weight loss temperature of 360°C or higher and 470°C or lower in nitrogen, had excellent light fastness. In particular, when the difference between the 50% weight loss temperature in air and the 50% weight loss temperature in nitrogen was 10°C or less, the weatherability was particularly excellent.

[Examples 1C to 12C and Comparative Examples 1C to 12C]

In Examples 1C to 4C and 12C, the compounds 14, 13, 17, 15 and 18 were used, respectively, as shown in Table 1-1. In Examples 5C to 11C, the following compounds 23 to 29 were used, respectively. In Comparative Examples 4C to 12C, the compounds 1' to 7', 10' and 11' were used, respectively, as shown in Table 1-2. In Comparative Examples 1C to 3C, the following compounds 13' to 15' were used, respectively.

<Synthesis of Compound 23>

[Synthesis of 5,5'-di-butyl-3,3'-di-ethyl-4,4'-di-methoxy carbonyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with methyl 2-butyl-4-ethyl-5-formyl-1H-pyrrole-3-carboxylate.

[Synthesis of Compound 23]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 5,5'-di-butyl-3,3'-di-ethyl-4,4'-di-methoxy carbonyl-2,2'-dipyrromethene hydrobromide.

<Synthesis of Compound 24>

[Synthesis of 5,5'-di-butyl-4,4'-di-ethoxycarbonyl-3,3'-di-ethyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 2-butyl-4-ethyl-5-formyl-1H-pyrrole-3-carboxylate.

[Synthesis of Compound 24]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 5,5'-di-butyl-4,4'-di-ethoxycarbonyl-3,3'-di-ethyl-2,2'-dipyrromethene hydrobromide.

<Synthesis of Compound 25>

[Synthesis of 5,5'-di-butyl-4,4'-di-methoxy carbonyl-3,3'-di-methyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with methyl 2-butyl-5-formyl-4-methyl-1H-pyrrole-3-carboxylate.

[Synthesis of Compound 25]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 5,5'-di-butyl-4,4'-di-methoxy carbonyl-3,3'-di-methyl-2,2'-dipyrromethene hydrobromide.

<Synthesis of Compound 26>

[Synthesis of 5,5'-di-butyl-4,4'-di-ethoxycarbonyl-3,3'-di-methyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 2-butyl-5-formyl-4-methyl-1H-pyrrole-3-carboxylate.

[Synthesis of Compound 26]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 5,5'-di-butyl-4,4'-di-ethoxycarbonyl-3,3'-di-methyl-2,2'-dipyrromethene hydrobromide.

<Synthesis of Compound 27>

[Synthesis of 5,5'-di-ethyl-4,4'-di-methoxy carbonyl-3,3'-di-methyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with methyl 2-ethyl-5-formyl-4-methyl-1H-pyrrole-3-carboxylate.

[Synthesis of Compound 27]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 5,5'-di-ethyl-4,4'-di-methoxy carbonyl-3,3'-di-methyl-2,2'-dipyrromethene hydrobromide.

<Synthesis of Compound 28>

[Synthesis of 3,3'-di-ethyl-4,4'-di-methoxy carbonyl-5,5'-di-methyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with methyl 4-ethyl-5-formyl-2-methyl-1H-pyrrole-3-carboxylate.

[Synthesis of Compound 28]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 3,3'-di-ethyl-4,4'-di-methoxy carbonyl-5,5'-di-methyl-2,2'-dipyrromethene hydrobromide.

<Synthesis of Compound 29>

[Synthesis of 5,5'-di-ethyl-4,4'-di-ethoxycarbonyl-3,3'-di-methyl-2,2'-dipyrromethene hydrobromide]

The synthesis was performed in the same manner as in the above [Synthesis of 3,3',5,5'-tetramethyl-4,4'-di-ethoxycarbonyl-2,2'-dipyrromethene hydrobromide] except that ethyl 5-formyl-2,4-dimethyl-1H-pyrrole-3-carboxylate was replaced with ethyl 2-ethyl-5-formyl-4-methyl-1H-pyrrole-3-carboxylate.

[Synthesis of Compound 29]

The synthesis was performed in the same manner as in the above [Synthesis of Compound 1] except that 3,3',5,5'-tetramethyl-4,4'-di-ethoxycarbonyl-2,2'-dipyrromethene hydrobromide was replaced with 5,5'-di-ethyl-4,4'-di-ethoxycarbonyl-3,3'-di-methyl-2,2'-dipyrromethene hydrobromide.

<Synthesis of Compound 13'>

The compound 13' was obtained in the same manner as the compound 10 by synthesizing 3,3',5,5'-tetramethyl-4,4'-di-methoxy carbonyl-2,2'-dipyrromethene hydrobromide as with the compound 10.

<Synthesis of Compound 14'>

The compound 14' was obtained in the same manner as the compound 1 by synthesizing 3,3',5,5'-tetramethyl-4,4'-di-ethoxycarbonyl-2,2'-dipyrromethene hydrobromide as with the compound 1.

<Synthesis of Compound 15'>

The compound 15' was obtained in the same manner as the compound 9 by synthesizing 3,3',5,5'-tetramethyl-4,4'-bis(2,2-dimethylpropoxycarbonyl)-2,2'-dipyrromethene hydrobromide as with the compound 9.

Preparation of the coating liquid, formation of the coating film, preparation of the evaluation substrate, evaluation of the wavelength of maximum absorption ($\lambda_{max}$) of the coating film, evaluation of the full width at half maximum of the

coating film and evaluation of the light fastness were performed in the same manner as in Example 1A. Table 5 shows the results.

<Free Energy Change (ΔG) Between Before and After Reaction>

For boron dipyrromethene having the same substituents as the dipyrromethene cobalt complex of each example and represented by formula (III), ΔG (kcal/mol) was calculated by the following procedure using the quantum chemical calculation program Gaussian 16 with the calculation method B3LYP and the basis function 6-31G (d,p) (however, the basis function LanL2DZ was assigned to elements in which $R^5$ in formula (I) has an atomic number greater than that of Kr). Table 5 shows the results.

(1) Structural optimization calculation and vibration calculation of boron dipyrromethene having the same substituents as the dipyrromethene cobalt complex of each example and represented by formula (III) were performed, and a free energy value $G_{(III)}$ of the boron dipyrromethene was obtained from the result of the vibration calculation.
(2) Structural optimization calculation and vibration calculation of singlet oxygen was performed, and a free energy value $G_{O2}$ of the singlet oxygen was obtained from the result of the vibration calculation.
(3) Structural optimization and vibration calculation of the structure in which oxygen was added to the meso position of the boron dipyrromethene structure (structure of the right side of reaction formula (II)) were performed, and a free energy value $G_{(III)+O2}$ of the oxygen adduct of the boron dipyrromethene was obtained from the result of the vibration calculation.
(4) ΔG was calculated by the following formula.

$$\Delta G = G_{(III)+O2}-(G_{(III)}+G_{O2})$$

[Spectral Characteristics]

<Wavelength of Maximum Absorption ($\lambda_{max}$) of Acetone Solution>

Acetone solutions of the dipyrromethene cobalt complex with a concentration of $5.0\times10^{-6}$ M were prepared, and the absorption spectra were measured using an ultraviolet-visible spectrophotometer (manufactured by Hitachi, Ltd., U-4100). The wavelength at which the absorbance was maximum in the wavelength range of 470 nm to 530 nm was determined as $\lambda_{max}$. Table 5 shows the results.

<Full Width at Half Maximum of Absorption Peak in Acetone Solution>

In the above absorption spectra, a full width at half maximum of the peak at which the absorbance was maximum in the wavelength range of 470 nm to 530 nm was calculated. Table 5 shows the results.

<Molar Absorption Coefficient (ε) of Acetone Solution>

Three acetone solutions of the dipyrromethene cobalt complex having different concentrations (concentration of $5.0\times10^{-6}$M, concentration of $7.5\times10^{-6}$M, and concentration of $1.0\times10^{-5}$M) were prepared, and the absorption spectra were measured using an ultraviolet-visible spectrophotometer (manufactured by Hitachi, Ltd., U-4100). In the absorption spectra, the slope of the approximate line obtained by plotting the absorbance at the wavelength of maximum absorption ($\lambda_{max}$) in the wavelength range of 470 nm to 530 nm against each concentration was determined as ε. Table 5 shows the results.

<White Luminous Efficiency>

The transmittance of the evaluation substrate was measured using an ultraviolet-visible spectrophotometer (manufactured by Hitachi, Ltd., U-4100), and this transmittance of the evaluation substrate was multiplied by the individual spectrum in the white display of an organic EL display device (manufactured by ASUS) shown in Fig. 9 to calculate the spectrum after passing through the evaluation substrate. After multiplying each of the individual spectrum in the white display of the organic EL display device and the spectrum after passing through the evaluation substrate by the luminosity function to calculate their Y values, the ratio between the Y values was determined assuming that the Y value obtained from the individual spectrum in the white display of the organic EL display device is 100. The determined ratio was assumed as the white luminous efficiency and used as a metric of the reliability evaluation. The closer the white luminous efficiency was

to 100, the higher the luminous efficiency. Table 5 shows the results.

<Color Purity (DCI Coverage)>

The transmittance of the evaluation substrate was measured using an ultraviolet-visible spectrophotometer (manufactured by Hitachi, Ltd., U-4100), and this transmittance of the evaluation substrate was multiplied by each of the individual spectra in the red, green and blue displays of an organic EL display device (manufactured by ASUS) shown in Fig. 10 to calculate the chromaticity (x, y) for each of monochromatic red, green and blue in the Commission International de l'Eclairage (CIE) 1931 color space after passing through the optical film. Then, by comparison between the triangle obtained by connecting the obtained chromaticities for monochromatic red, green and blue and the triangle obtained by connecting the three primary colors of DCI-P3 proposed by the Digital Cinema Initiatives (DCI), i.e., red (x = 0.680, y = 0.320), green (x = 0.265, y = 0.690) and blue (x = 0.150, y = 0.060), the overlap area was determined to calculate the DCI coverage. The closer the DCI coverage was to 100, the higher the color purity. Table 5 shows the results.

[Overall Evaluation]

From the results of the above-mentioned [Reliability Evaluation], an overall evaluation was made according to the following evaluation criteria. Table 5 shows the results.

«Evaluation Criteria»

Good: The light fastness was rated "A", the white luminous efficiency was 88.0 or greater, and the DCI coverage was 96.0% or greater.
Fair: The light fastness was rated "B", the white luminous efficiency was 88.0 or greater, and the DCI coverage was 96.0% or greater.
Poor: The light fastness was rated "C", the white luminous efficiency was less than 88.0, or the DCI coverage was less than 96.0%.

[Table 5]

| | | ΔG [kcal/mol] | Spectral characteristics | | | | | Reliability evaluation | | | Overall evaluation |
|---|---|---|---|---|---|---|---|---|---|---|---|
| | | | Acetone solution | | | Coating film | | | | | |
| | | | $\lambda_{max}$ [nm] | Full width at half maximum [nm] | ε [L/(mol·cm)] | $\lambda_{max}$ [nm] | Full width at half maximum [nm] | Light fastness | White luminance efficiency | Color purity (DCI coverage) % | |
| Example | 1C | 1.28 | 493 | 19 | 238,000 | 496 | 23 | A | 88.6 | 96.5 | Good |
| | 2C | 0.92 | 493 | 19 | 234,000 | 496 | 23 | A | 88.7 | 96.5 | Good |
| | 3C | 2.12 | 492 | 19 | 240,000 | 495 | 23 | A | 88.6 | 96.3 | Good |
| | 4C | 1.87 | 492 | 19 | 238,000 | 495 | 23 | A | 88.7 | 96.3 | Good |
| | 5C | 0.64 | 493 | 19 | 227,000 | 496 | 23 | A | 88.3 | 96.3 | Good |
| | 6C | 0.58 | 493 | 19 | 225,000 | 496 | 23 | A | 88.3 | 96.3 | Good |
| | 7C | 0.23 | 491 | 19 | 225,000 | 496 | 23 | A | 88.5 | 96.4 | Good |
| | 8C | 0.14 | 491 | 19 | 220,000 | 496 | 23 | A | 88.5 | 96.4 | Good |
| | 9C | 0.15 | 489 | 19 | 214,000 | 494 | 23 | A | 88.6 | 96.5 | Good |
| | 10C | 1.16 | 491 | 19 | 230,000 | 494 | 23 | A | 88.7 | 96.5 | Good |
| | 11C | 0.04 | 489 | 19 | 210,000 | 494 | 23 | A | 88.7 | 96.6 | Good |
| | 12C | 1.40 | 491 | 19 | 228,000 | 494 | 23 | A | 88.8 | 96.6 | Good |
| Comparative example | 1C | 0.47 | 488 | 21 | 199,000 | 493 | 25 | B | 89.3 | 96.3 | Fair |
| | 2C | 0.54 | 488 | 21 | 222,000 | 493 | 25 | B | 89.4 | 96.4 | Fair |
| | 3C | 0.07 | 488 | 21 | 175,000 | 494 | 25 | B | 89.3 | 96.4 | Fair |
| | 4C | -1.39 | 506 | 24 | 130,000 | 510 | 37 | C | 82.4 | 96.1 | Poor |
| | 5C | -3.72 | 495 | 27 | 145,000 | 500 | 33 | C | 83.7 | 96.2 | Poor |
| | 6C | -3.69 | 497 | 27 | 168,000 | 503 | 32 | C | 83.4 | 96.3 | Poor |
| | 7C | -3.16 | 497 | 26 | 175,000 | 499 | 37 | C | 83.2 | 96.1 | Poor |
| | 8C | -1.12 | 508 | 32 | 69,000 | 512 | 43 | C | 83.2 | 95.4 | Poor |
| | 9C | -1.42 | 495 | 27 | 160,000 | 501 | 33 | C | 83.5 | 96.1 | Poor |
| | 10C | -3.35 | 494 | 29 | 158,000 | 496 | 31 | C | 83.8 | 96.4 | Poor |
| | 11C | -3.04 | 507 | 34 | 100,000 | 511 | 44 | C | 82.5 | 95.4 | Poor |
| | 12C | -3.30 | 494 | 29 | 158,000 | 496 | 31 | C | 83.3 | 96.1 | Poor |

As shown in Table 5, Examples 1C to 12C, in which the present invention was applied, had the overall evaluation of "good", with excellent luminous efficiency, color reproducibility and light fastness.

On the other hand, Comparative Examples 1C to 3C, in which the wavelength of maximum absorption in acetone solution was less than 489 nm, had the overall evaluation of "fair". Comparative Examples 4C to 12C, in which the full width at half maximum of the absorption peak in acetone solution was greater than 22 nm, had the overall evaluation of "poor".

The coating film using the composition for forming a colored layer of the present invention was found to be effective in achieving low reflectance, high luminance, reduced film thickness and improved color reproducibility of the display device, and have excellent light fastness. Reducing the concentration of the dipyrromethene metal complex in the coating film is also advantageous in terms of production costs.

[Industrial Applicability]

According to the present invention, it is possible to provide an optical film capable of selectively and efficiently absorbing light having a wavelength of around 500 nm and excellent in light fastness, a composition for forming a colored layer capable of selectively and efficiently absorbing light having a wavelength of around 500 nm and excellent in light fastness, a dipyrromethene cobalt complex capable of selectively and efficiently absorbing light having a wavelength of around 500 nm and excellent in light fastness, and a display device using the optical film.

[Reference Signs List]

1, 2, 3, 4, 5, 6, 7, 8 ... Optical film
10 ... Colored layer
20 ... Transparent substrate
30 ... Functional layer
31 ... Low refractive index layer
32 ... Hard coat layer
33 ... Oxygen barrier layer
34 ... Antiglare layer

## Claims

**1.** An optical film comprising:

a transparent substrate; and a colored layer laminated on at least one side of the transparent substrate, the colored layer containing a dye (A), the dye (A) containing a colorant having a wavelength of maximum absorption in the range of 470 nm to 530 nm, the colorant containing a dipyrromethene cobalt complex having a structure represented by the following formula (I), in which $R^1$ to $R^7$ in the following formulas (I) and (II) are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group, wherein
the colorant satisfies at least one of the following conditions (1) to (4):

(1) The colorant has a wavelength of maximum absorption in the range of 470 nm to 530 nm, and, when thermogravimetric measurement is performed for the dipyrromethene cobalt complex under conditions of a gas flow rate of 500 mL/min and a temperature increase rate of 10°C/min, a 5% weight loss temperature when the gas is air and a 5% weight loss temperature when the gas is nitrogen are both 300°C or higher, and when thermogravimetric measurement is performed under conditions of a nitrogen flow rate of 500 mL/min and a temperature increase rate of 10°C/min, a 50% weight loss temperature is 360°C or higher and 470°C or lower;
(2) The colorant has a wavelength of maximum absorption of 489 nm to 500 nm and a full width at half maximum of an absorption peak of 22 nm or less in acetone solution with a concentration of $5.0\times10^{-6}$ M, and has a full width at half maximum of an absorption peak of 30 nm or less;
(3) The colorant has a wavelength of maximum absorption in the range of 470 nm to 530 nm, and contains a dipyrromethene cobalt complex in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is 0.92 kcal/mol or greater; and
(4) The colorant has a wavelength of maximum absorption in the range of 470 nm to 530 nm, and contains a dipyrromethene cobalt complex in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is -1.0 kcal/mol or greater, and at least one of $R^1$ to $R^4$ is a

hydrogen atom or a halogen atom.

[Chem. 1]

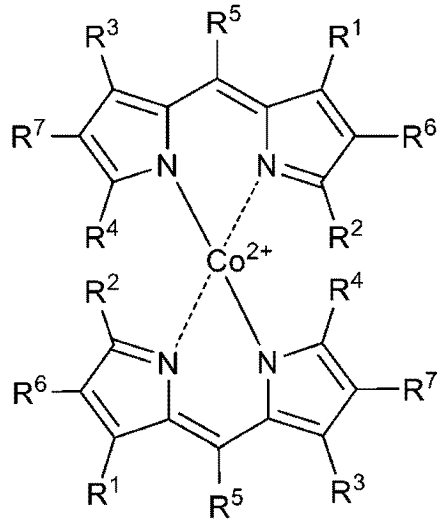

(I)

[Chem. 2]

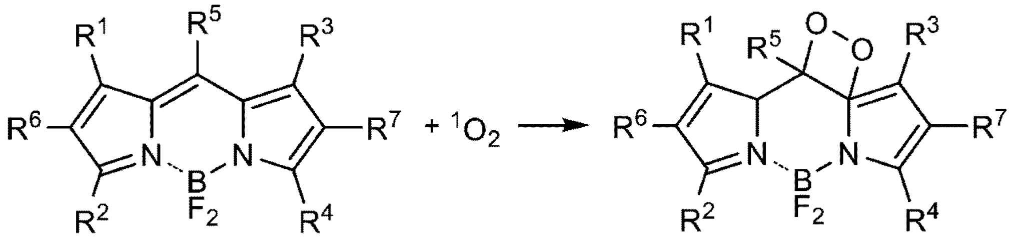

(II)

2. The optical film according to claim 1, wherein the colorant satisfies the condition (2).

3. The optical film according to claim 1, wherein, when thermogravimetric measurement is performed for the dipyrromethene cobalt complex of the condition (1) under conditions of a gas flow rate of 500 mL/min and a temperature increase rate of 10°C/min, a difference between a 50% weight loss temperature when the gas is air and a 50% weight loss temperature when the gas is nitrogen is 10°C or less.

4. The optical film according to claim 1, wherein,

in the reaction formula (II) in which boron dipyrromethene having a structure represented by the following formula (III) reacts with singlet oxygen, the dipyrromethene cobalt complex of the condition (2) has a free energy change $\Delta G$ between before and after reaction, calculated using a quantum chemical calculation program Gaussian 16 with a calculation method B3LYP and a basis function 6-31G (d,p) (however, a basis function LanL2DZ is assigned to elements in which $R^5$ in the formula (I) has an atomic number greater than that of Kr), of -1.0 kcal/mol or greater:

[Chem. 3]

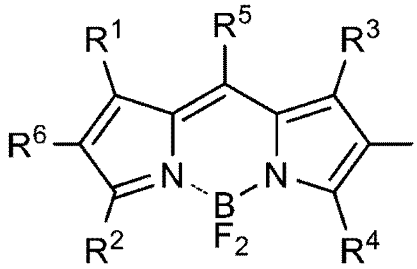

(III)

where $R^1$ to $R^7$ in formula (III) each represent the same monovalent groups as $R^1$ to $R^7$ in the formula (I).

5. The optical film according to claim 1, wherein, in the dipyrromethene cobalt complex of the condition (3), at least one of $R^1$ to $R^4$ is a hydrogen atom or a halogen atom.

6. The optical film according to claim 1, wherein, in the dipyrromethene cobalt complex of the condition (3) or (4), $R^1$ and $R^3$ are each independently a hydrogen atom or a halogen atom and $R^2$ and $R^4$ are each independently an alkyl group having 1 to 4 carbon atoms, or $R^1$ and $R^3$ are each independently an alkyl group having 1 to 4 carbon atoms and $R^2$ and $R^4$ are each independently a halogen atom.

7. The optical film according to claim 1, wherein, in the dipyrromethene cobalt complex, $R^5$ is a hydrogen atom.

8. The optical film according to claim 1, wherein, in the dipyrromethene cobalt complex of the conditions (1) to (3), $R^1$ to $R^4$ are alkyl groups, and a sum of carbon numbers of $R^1$ and $R^2$ is 3 or greater and a sum of carbon numbers of $R^3$ and $R^4$ is 3 or greater.

9. The optical film according to claim 1, wherein

the dipyrromethene cobalt complex has a structure represented by the following formula (I-1):

[Chem. 4]

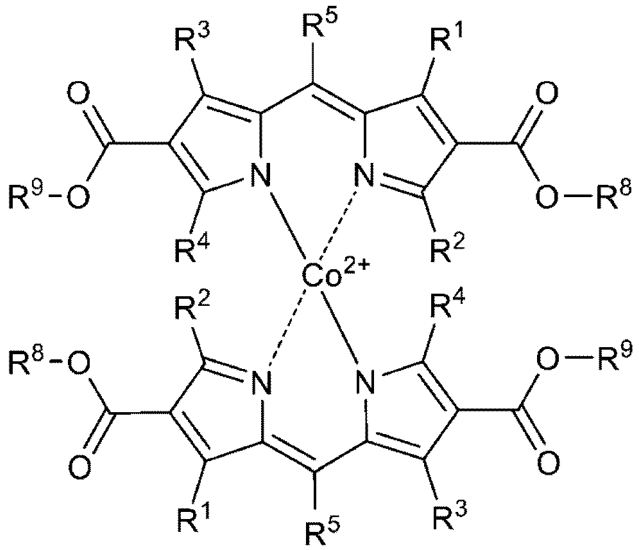

(I-1)

where $R^1$ to $R^5$ in formula (I-1) each represent the same monovalent groups as $R^1$ to $R^5$ in the formula (I), and $R^8$ and $R^9$ each independently represent an alkyl group having 1 to 6 carbon atoms.

10. The optical film according to claim 9, wherein

an acetone solution of the dipyrromethene cobalt complex has a molar absorption coefficient of 190,000 L/(mol cm) or greater.

**11.** The optical film according to claim 10, wherein,
in the dipyrromethene cobalt complex, $R^8$ and $R^9$ are each independently a methyl group or an ethyl group.

**12.** A composition for forming a colored layer, the composition comprising:

a dye (A); a photopolymerizable compound (B); and a photopolymerization initiator (C), the dye (A) containing a colorant, the colorant containing a dipyrromethene cobalt complex having a structure represented by the following formula (I), in which $R^1$ to $R^7$ in the following formulas (I) and (II) are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group, wherein
the colorant satisfies at least one of the following conditions (1) to (4):

(1) The colorant has a wavelength of maximum absorption in the range of 470 nm to 530 nm, and, when thermogravimetric measurement is performed for the dipyrromethene cobalt complex under conditions of a gas flow rate of 500 mL/min and a temperature increase rate of 10°C/min, a 5% weight loss temperature when the gas is air and a 5% weight loss temperature when the gas is nitrogen are both 300°C or higher, and when thermogravimetric measurement is performed under conditions of a nitrogen flow rate of 500 mL/min and a temperature increase rate of 10°C/min, a 50% weight loss temperature is 360°C or higher and 470°C or lower;
(2) The colorant has a wavelength of maximum absorption of 489 nm to 500 nm and a full width at half maximum of an absorption peak of 22 nm or less in acetone solution with a concentration of $5.0\times10^{-6}$ M, and has a full width at half maximum of an absorption peak of 30 nm or less;
(3) The colorant has a wavelength of maximum absorption in the range of 470 nm to 530 nm, and contains a dipyrromethene cobalt complex in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is 0.92 kcal/mol or greater; and
(4) The colorant has a wavelength of maximum absorption in the range of 470 nm to 530 nm, and contains a dipyrromethene cobalt complex in which $R^1$ to $R^7$ are combined such that a free energy change between before and after the reaction, calculated by applying $R^1$ to $R^7$ in the formula (I) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is -1.0 kcal/mol or greater, and at least one of $R^1$ to $R^4$ is a hydrogen atom or a halogen atom.

[Chem. 5]

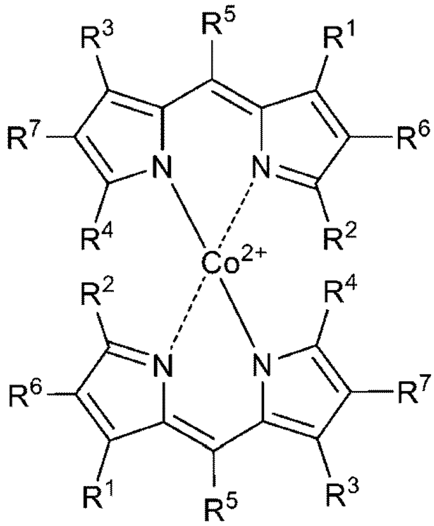

(I)

[Chem. 6]

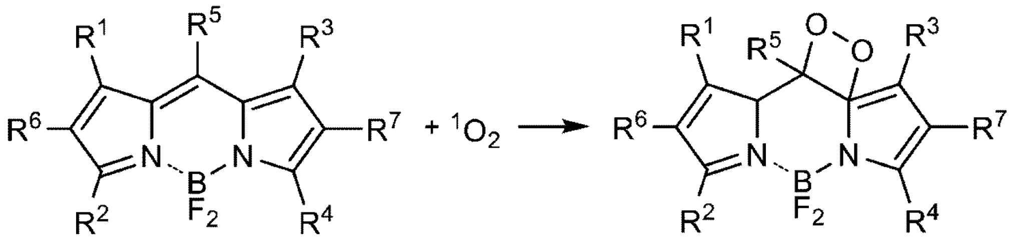

(II)

**13.** The composition for forming a colored layer according to claim 12, wherein the colorant satisfies the condition (2).

**14.** The composition for forming a colored layer according to claim 12, wherein, when thermogravimetric measurement is performed for the dipyrromethene cobalt complex of the condition (1) under conditions of a gas flow rate of 500 mL/min and a temperature increase rate of 10°C/min, a difference between a 50% weight loss temperature when the gas is air and a 50% weight loss temperature when the gas is nitrogen is 10°C or less.

**15.** The composition for forming a colored layer according to claim 12, wherein,

in the reaction formula (II) in which boron dipyrromethene having a structure represented by the following formula (III) reacts with singlet oxygen, the dipyrromethene cobalt complex of the condition (2) has a free energy change $\Delta G$ between before and after reaction, calculated using a quantum chemical calculation program Gaussian 16 with a calculation method B3LYP and a basis function 6-31G (d,p) (however, a basis function LanL2DZ is assigned to elements in which $R^5$ in the formula (I) has an atomic number greater than that of Kr), of -1.0 kcal/mol or greater:

[Chem. 7]

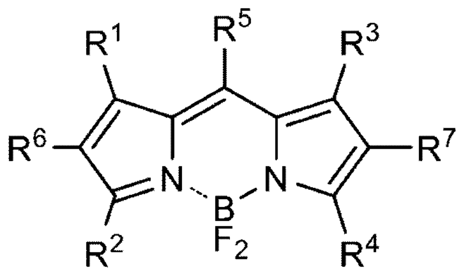

(III)

where $R^1$ to $R^7$ in formula (III) each represent the same monovalent groups as $R^1$ to $R^7$ in the formula (I).

**16.** The composition for forming a colored layer according to claim 12, wherein, in the dipyrromethene cobalt complex of the condition (3), at least one of $R^1$ to $R^4$ is a hydrogen atom or a halogen atom.

**17.** The composition for forming a colored layer according to claim 12, wherein, in the dipyrromethene cobalt complex of the condition (3) or (4), $R^1$ and $R^3$ are each independently a hydrogen atom or a halogen atom and $R^2$ and $R^4$ are each independently an alkyl group having 1 to 4 carbon atoms, or $R^1$ and $R^3$ are each independently an alkyl group having 1 to 4 carbon atoms and $R^2$ and $R^4$ are each independently a halogen atom.

**18.** The composition for forming a colored layer according to claim 12, wherein, in the dipyrromethene cobalt complex, $R^5$ is a hydrogen atom.

**19.** The composition for forming a colored layer according to claim 12, wherein, in the dipyrromethene cobalt complex of the conditions (1) to (3), $R^1$ to $R^4$ are alkyl groups, and a sum of carbon numbers of $R^1$ and $R^2$ is 3 or greater and a sum of carbon numbers of $R^3$ and $R^4$ is 3 or greater.

**20.** The composition for forming a colored layer according to claim 12, wherein

the dipyrromethene cobalt complex has a structure represented by the following formula (I-1):

[Chem. 8]

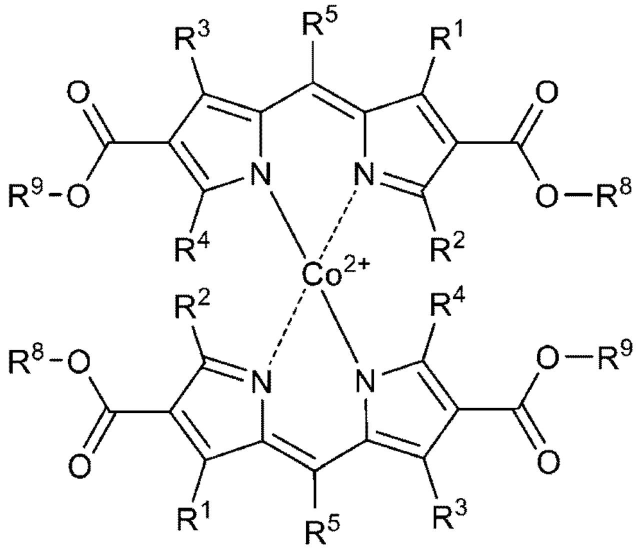

(I-1)

where $R^1$ to $R^5$ in formula (I-1) each represent the same monovalent groups as $R^1$ to $R^5$ in the formula (I), and $R^8$ and $R^9$ are each independently represent an alkyl group having 1 to 6 carbon atoms.

**21.** The composition for forming a colored layer according to claim 20, wherein an acetone solution of the dipyrromethene cobalt complex has a molar absorption coefficient of 190,000 L/(mol cm) or greater.

**22.** The composition for forming a colored layer according to claim 20 or 21, wherein, in the dipyrromethene cobalt complex, $R^8$ and $R^9$ are each independently a methyl group or an ethyl group.

**23.** The composition for forming a colored layer according to claim 12, further containing a non-polymerizable additive (D).

**24.** An optical film comprising: a transparent substrate; and a colored layer laminated on at least one side of the transparent substrate, the colored layer being a cured product of the composition for forming a colored layer according to claim 12.

**25.** A dipyrromethene cobalt complex having a structure represented by the following formula (I-1), in which $R^1$ to $R^5$ in the following formula (I-1) are each independently a monovalent group selected from the group consisting of a hydrogen atom, a halogen atom, an aliphatic hydrocarbon group, an alkoxy group, an alkylthio group, an aromatic hydrocarbon group, a heterocyclic group, a hydroxyl group, a mercapto group, a nitro group, a substituted amino group, an unsubstituted amino group, a cyano group, a sulfo group, an ester group and an acyl group, wherein
the dipyrromethene cobalt complex satisfies at least one of the following conditions (1) to (3):

(1) When thermogravimetric measurement is performed for the dipyrromethene cobalt complex under conditions of a gas flow rate of 500 mL/min and a temperature increase rate of 10°C/min, a 5% weight loss temperature when the gas is air and a 5% weight loss temperature when the gas is nitrogen are both 300°C or higher, and when thermogravimetric measurement is performed under conditions of a nitrogen flow rate of 500 mL/min and a temperature increase rate of 10°C/min, a 50% weight loss temperature is 360°C or higher and 470°C or lower, and $R^8$ and $R^9$ are each independently an alkyl group having 1 to 6 carbon atoms;
(2) An acetone solution of the dipyrromethene cobalt complex has a molar absorption coefficient of 190,000 L/(mol·cm) or greater, $R^1$ to $R^5$, $R^8$ and $R^9$ are combined such that a free energy change between before and after the reaction, calculated by applying $R^1$ to $R^5$, $R^8$ and $R^9$ in the formula (I-1) to the following reaction formula (II) using a quantum chemical calculation program Gaussian 16 with a calculation method B3LYP and a basis function 6-31G (d,p) (however, a basis function LanL2DZ is assigned to elements having an atomic number greater than that of Kr in the periodic table), is 0.92 kcal/mol or greater, $R^8$ and $R^9$ are each independently an alkyl group having 1 to 6 carbon atoms, $R^6$ is -C(=O)-O-$R^8$, and $R^7$ is -C(=O)-O-$R^9$; and
(3) An acetone solution of the dipyrromethene cobalt complex has a molar absorption coefficient of 190,000 L/(mol·cm) or greater, $R^8$ and $R^9$ are each independently an alkyl group having 1 to 6 carbon atoms, and at least one of $R^1$ to $R^4$ is a hydrogen atom or a halogen atom.

[Chem. 9]

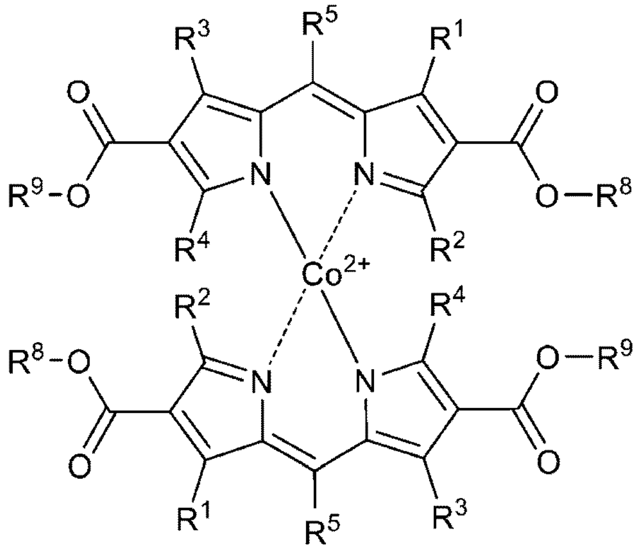

(I-1)

[Chem. 10]

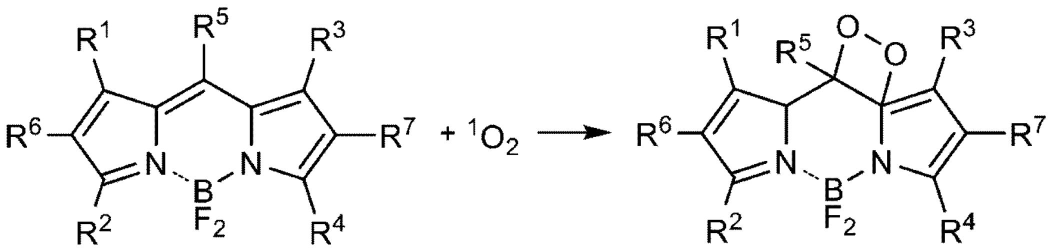

(II)

**26.** The dipyrromethene cobalt complex according to claim 25, wherein,
when thermogravimetric measurement is performed for the dipyrromethene cobalt complex of the condition (1) under

conditions of a gas flow rate of 500 mL/min and a temperature increase rate of 10°C/min, a difference between a 50% weight loss temperature when the gas is air and a 50% weight loss temperature when the gas is nitrogen is 10°C or less.

**27.** The dipyrromethene cobalt complex according to claim 25, wherein $R^5$ is a hydrogen atom.

**28.** The dipyrromethene cobalt complex according to claim 25, wherein $R^8$ and $R^9$ are each independently a methyl group or an ethyl group.

**29.** The dipyrromethene cobalt complex according to claim 25, wherein $R^1$ to $R^4$ are alkyl groups, and a sum of carbon numbers of $R^1$ and $R^2$ is 3 or greater and a sum of carbon numbers of $R^3$ and $R^4$ is 3 or greater.

**30.** The dipyrromethene cobalt complex according to claim 25, wherein, in the dipyrromethene cobalt complex of the condition (2), $R^1$ and $R^3$ are each independently a hydrogen atom or a halogen atom and $R^2$ and $R^4$ are each independently an alkyl group having 1 to 4 carbon atoms, or $R^1$ and $R^3$ are each independently an alkyl group having 1 to 4 carbon atoms and $R^2$ and $R^4$ are each independently a halogen atom.

**31.** The dipyrromethene cobalt complex according to claim 25, wherein a wavelength of maximum absorption of an acetone solution thereof is 470 nm to 530 nm.

**32.** A display device comprising the optical film according to any one of claims 1 to 11 and 24.

FIG.1

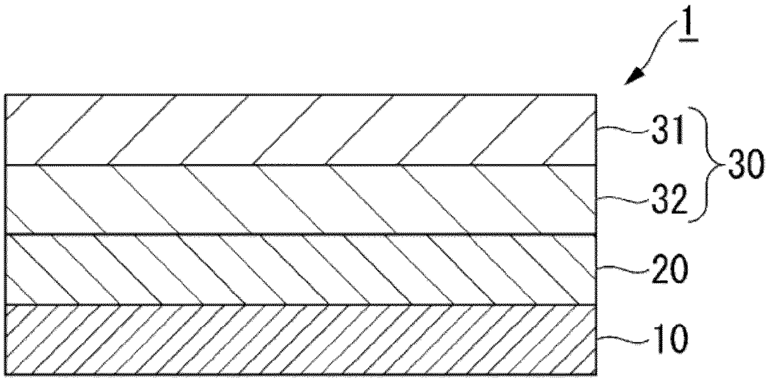


FIG.2

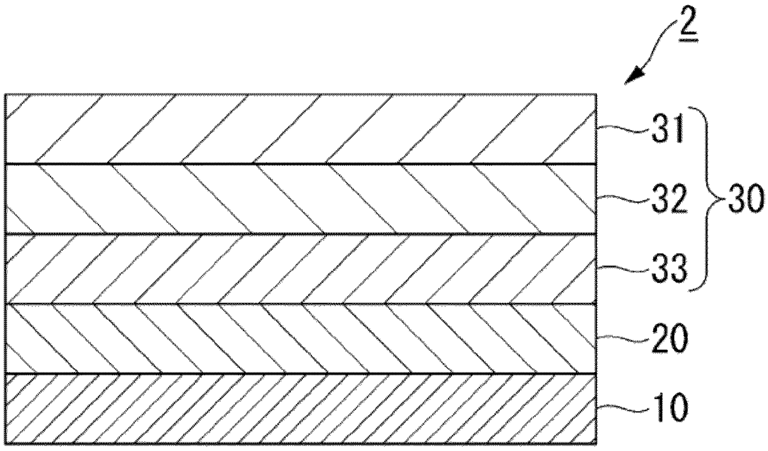


FIG.3

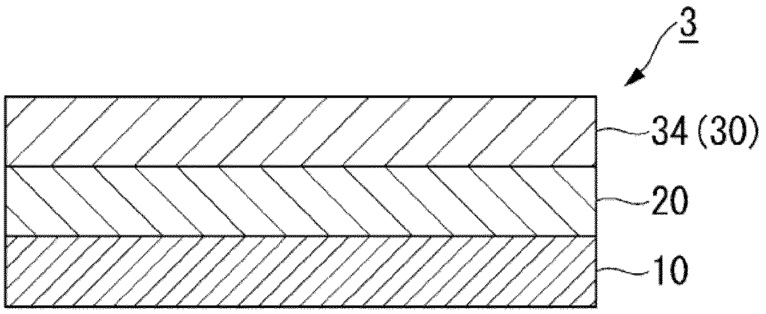


FIG.4

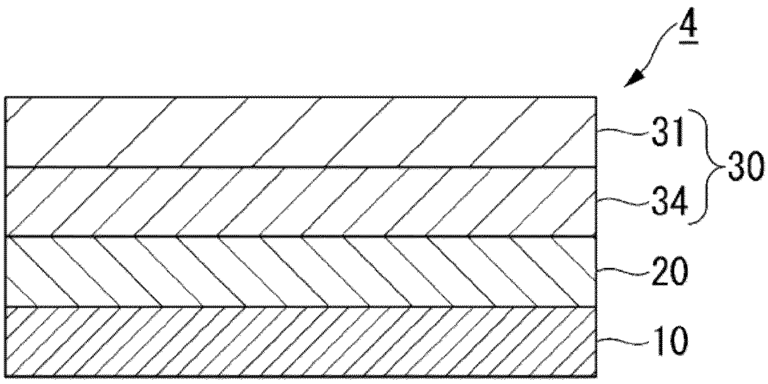

FIG.5

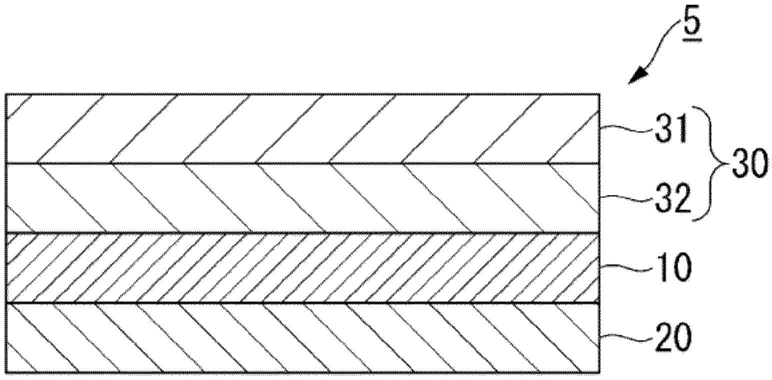


FIG.6

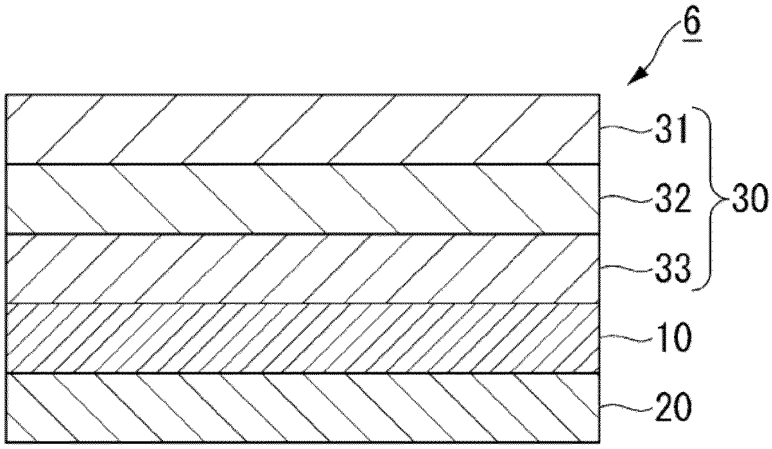


FIG.7

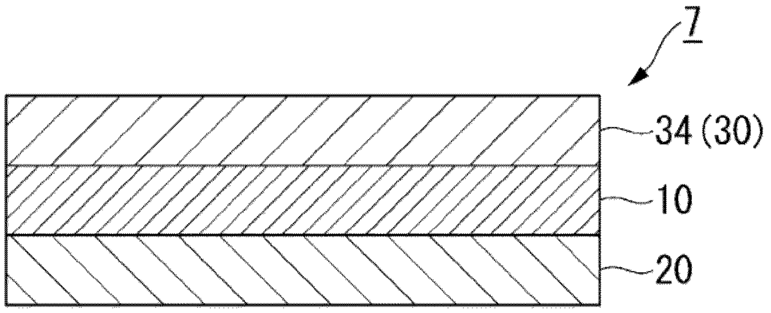


FIG.8

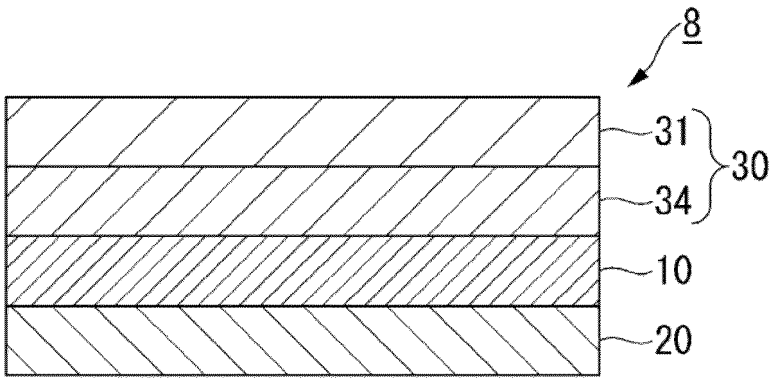

FIG.9

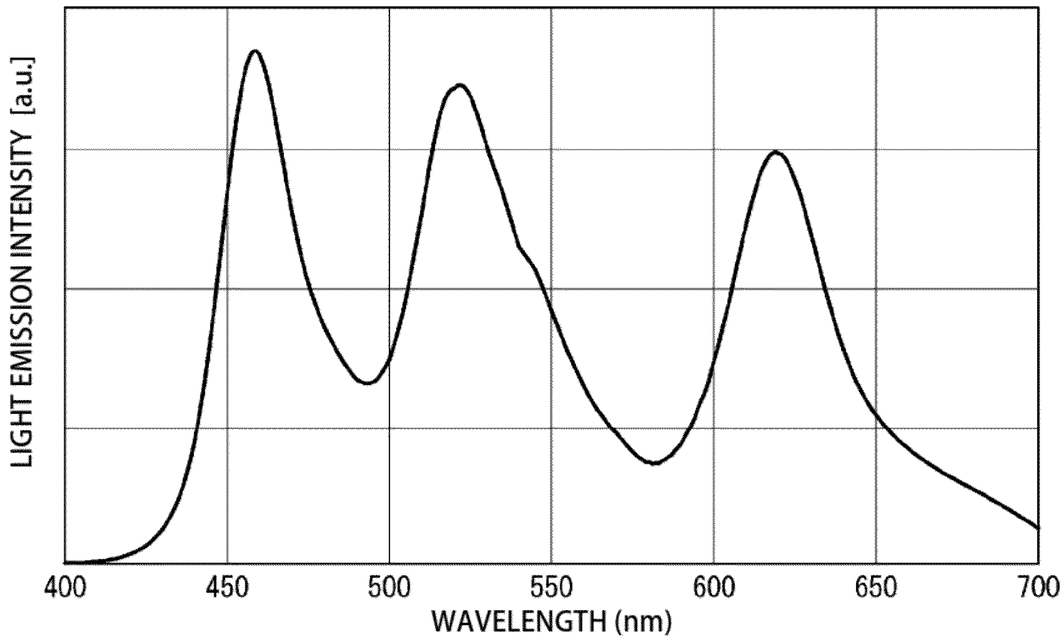
LIGHT EMISSION INTENSITY [a.u.]
400
450
500
550
600
650
700
WAVELENGTH (nm)

FIG.10

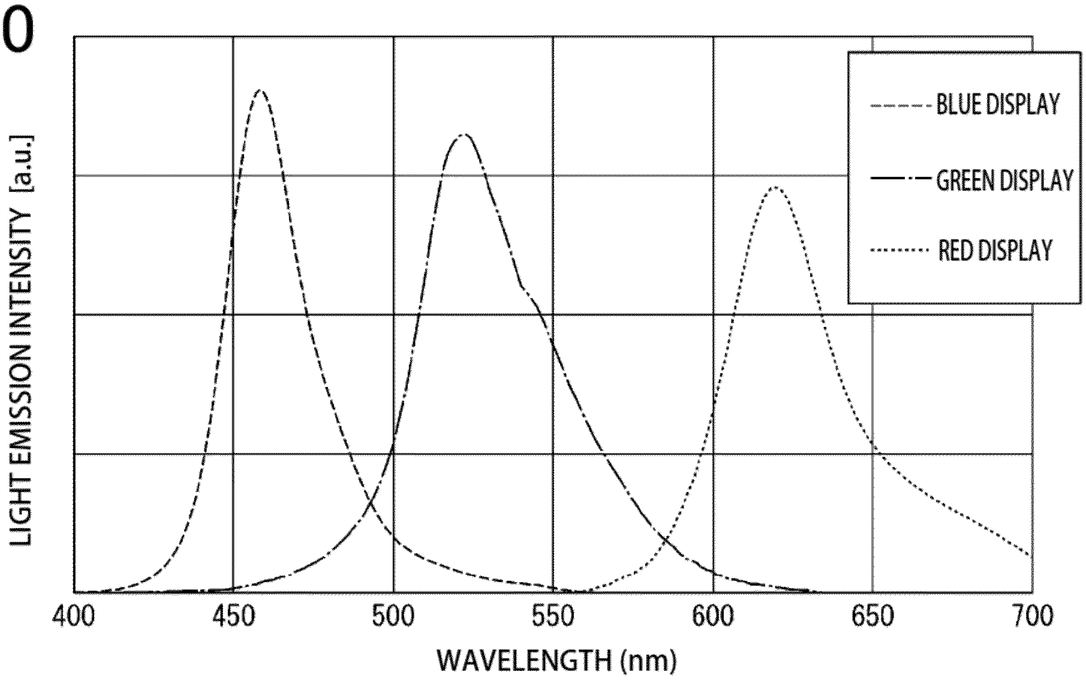
LIGHT EMISSION INTENSITY [a.u.]
BLUE DISPLAY
GREEN DISPLAY
RED DISPLAY
400
450
500
550
600
650
700
WAVELENGTH (nm)

**INTERNATIONAL SEARCH REPORT**

International application No.
**PCT/JP2022/048523**

**A. CLASSIFICATION OF SUBJECT MATTER**

***G02B 5/22***(2006.01)i; ***B32B 7/023***(2019.01)i; ***B32B 27/18***(2006.01)i; ***B32B 27/20***(2006.01)i; ***C07F 15/06***(2006.01)i; ***C08F 290/00***(2006.01)i; ***C08L 33/04***(2006.01)i; ***C08L 101/00***(2006.01)i; ***C09B 23/04***(2006.01)i; ***C09B 23/16***(2006.01)i; ***C09B 26/02***(2006.01)i; ***C09B 67/20***(2006.01)i; ***G02B 5/20***(2006.01)i

According to International Patent Classification (IPC) or to both national classification and IPC

**B. FIELDS SEARCHED**

Minimum documentation searched (classification system followed by classification symbols)

G02B5/22; B32B7/023; B32B27/18; B32B27/20; C07F15/06; C08F290/00; C08L33/04; C08L101/00; C09B23/04; C09B23/16; C09B26/02; C09B67/20; G02B5/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| A | JP 2021-38177 A (YAMADA CHEMICAL CO., LTD.) 11 March 2021 (2021-03-11) paragraphs [0002], [0049], [0076] | 1-32 |
| A | FERGUSSON, J. E. et al. Dipyrromethene Complexes of Transition Metals. Part I. Tetrahedral Complexes of Cobalt(II), Nickel(II), Copper(II), and Zinc(II). Journal of the Chemical Society, 1965 table 1 | 1-32 |
| P, A | JP 7173394 B1 (TOPPAN PRINTING CO., LTD.) 16 November 2022 (2022-11-16) paragraph [0009] | 1-32 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **24 February 2023** | **14 March 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/048523**

| Patent document cited in search report | Publication date (day/month/year) | Patent family member(s) | Publication date (day/month/year) |
|---|---|---|---|
| JP 2021-38177 A | 11 March 2021 | (Family: none) | |
| JP 7173394 B1 | 16 November 2022 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2022001431 A
- JP 2022087750 A
- JP 2022087756 A
- JP 2022087760 A
- JP 6142398 B
- JP 2006251076 A
- JP 2002212456 A